(19) Europäisches Patentamt
European Patent Office
Office européen des brevets

(11) EP 4 397 502 A1

(12) EUROPEAN PATENT APPLICATION
published in accordance with Art. 153(4) EPC

(43) Date of publication:
10.07.2024 Bulletin 2024/28

(21) Application number: 22864452.2

(22) Date of filing: 26.08.2022

(51) International Patent Classification (IPC):
*B41N 1/14* (2006.01) *B41C 1/10* (2006.01)
*G03F 7/00* (2006.01) *G03F 7/004* (2006.01)
*G03F 7/027* (2006.01) *G03F 7/09* (2006.01)
*G03F 7/11* (2006.01)

(52) Cooperative Patent Classification (CPC):
**B41C 1/10; B41N 1/14; G03F 7/00; G03F 7/004; G03F 7/027; G03F 7/09; G03F 7/11**

(86) International application number:
**PCT/JP2022/032297**

(87) International publication number:
**WO 2023/032868 (09.03.2023 Gazette 2023/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.08.2021 JP 2021142007**

(71) Applicant: **FUJIFILM Corporation**
**Tokyo 106-8620 (JP)**

(72) Inventors:
- **WATANABE Shumpei**
  **Haibara-gun, Shizuoka 421-0396 (JP)**
- **SAKAGUCHI Akira**
  **Haibara-gun, Shizuoka 421-0396 (JP)**

(74) Representative: **HGF**
**HGF Limited**
**1 City Walk**
**Leeds LS11 9DX (GB)**

# (54) ON-MACHINE DEVELOPMENT-TYPE LITHOGRAPHIC PRINTING PLATE PRECURSOR AND METHOD FOR MANUFACTURING PRINTING PLATE

(57) The present invention provides an on-press development type lithographic printing plate precursor including, in the following order, a support, an image-recording layer, and a protective layer, in which the image-recording layer contains a) a polymerizable compound, b) an infrared absorber, c) a polymerization initiator, and d) a color forming substance precursor, and the protective layer contains an ultraviolet absorber, and a method of preparing a printing plate.

EP 4 397 502 A1

## Description

### BACKGROUND OF THE INVENTION

1. Field of the Invention

The present invention relates to an on-press development type lithographic printing plate precursor and a method of preparing a printing plate.

2. Description of the Related Art

Generally, a lithographic printing plate consists of a lipophilic image area that receives ink in a printing process and a hydrophilic non-image area that receives dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

Currently, in a plate making step of preparing a lithographic printing plate from a lithographic printing plate precursor, image exposure is performed by a computer-to-plate (CTP) technique. That is, the image exposure is performed by performing scanning exposure or the like directly on a lithographic printing plate precursor by using a laser or a laser diode without the intervention of a lith film.

Incidentally, due to the increasing concern for the global environment, in regard to making a lithographic printing plate precursor, attention is paid to the environmental issues relating to the waste liquid involved in a wet treatment such as a development treatment. As a result, there is a trend towards simplification or elimination of the development treatment. As one of the simple development treatments, a method called "on-press development" has been proposed. The on-press development is a method of performing image exposure on a lithographic printing plate precursor, then directly mounting the lithographic printing plate precursor on a printer without performing the wet development treatment of the related art, and removing a non-image area of an image-recording layer at the initial stage of the general printing step.

WO2020/262691A describes an on-press development type lithographic printing plate precursor having a support and an image-recording layer on the support, in which the image-recording layer contains an infrared absorber, a polymerization initiator, a polymerizable compound, and a color forming substance precursor, and in a case where the image-recording layer is exposed to an infrared laser having a wavelength of 830 nm at an energy density of 110 mJ/cm$^2$, a loss of ethylenically unsaturated bonds in an exposed region in the image-recording layer is 10% to 40% with respect to a loss of ethylenically unsaturated bonds in a non-exposed region in the image-recording layer.

### SUMMARY OF THE INVENTION

Incidentally, in a case where a lithographic printing plate precursor is mounted to a printer, an image of an exposed portion is usually visually recognized. In a case where the wet development treatment in the related art is performed, since the lithographic printing plate from which the non-image area has been removed is mounted on a printer, it is easy to visually recognize the image of the exposed portion of the lithographic printing plate. On the other hand, in a case where on-press development is performed, since the lithographic printing plate precursor from which the non-image area has not yet been removed is mounted on the printer, it tends to be difficult to visually recognize the image of the lithographic printing plate.

Based on the above description, a lithographic printing plate precursor in which a color forming substance precursor is contained in an image-recording layer has been developed in consideration of improvement of color formability in an exposed portion.

However, it has been found that in the lithographic printing plate precursor in which a color forming substance precursor is contained in an image-recording layer, the need for time for on-press development, so-called "development delay", is likely to be caused.

The present invention is made in consideration of the above-described circumstances, and an object thereof is to provide an on-press development type lithographic printing plate precursor having excellent color formability and suppressed development delay, and a method of preparing a printing plate using the on-press development type lithographic printing plate precursor.

In addition, the present invention is to provide an on-press development type lithographic printing plate precursor having excellent color formability, suppressed development delay, and further excellent printing durability, and a method of preparing a printing plate using the on-press development type lithographic printing plate precursor.

The means for achieving the above objects will be described below.

[1] An on-press development type lithographic printing plate precursor comprising, in the following order:

a support;
an image-recording layer; and
a protective layer,
in which the image-recording layer contains a) a polymerizable compound, b) an infrared absorber, c) a polymerization initiator, and d) a color forming substance precursor, and
the protective layer contains an ultraviolet absorber.

[2] An on-press development type lithographic printing plate precursor comprising, in the following order:

a support; and
an image-recording layer,
in which the image-recording layer contains a) a polymerizable compound, b) an infrared absorber, c) a polymerization initiator, d) a color forming substance precursor, and e) an ultraviolet absorber, and
the polymerizable compound has 4 or more functionalities and has a molecular weight of less than 15,000.

[3] An on-press development type lithographic printing plate precursor comprising, in the following order:

a support;
an image-recording layer; and
a protective layer,
in which the image-recording layer contains a) a polymerizable compound, b) an infrared absorber, c) a polymerization initiator, and d) a color forming substance precursor,
the protective layer contains an ultraviolet absorber,
in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer, and
in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

[4] An on-press development type lithographic printing plate precursor comprising, in the following order:

a support; and
an image-recording layer,
in which the image-recording layer contains a) a polymerizable compound, b) an infrared absorber, c) a polymerization initiator, d) a color forming substance precursor, and e) an ultraviolet absorber,
in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer, and
in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

[5] The on-press development type lithographic printing plate precursor according to any one of [1] to [4], in which the ultraviolet absorber has $\lambda$max at a wavelength of 280 to 400 nm.
[6] The on-press development type lithographic printing plate precursor according to any one of [1] to [5], in which the image-recording layer contains, as the polymerizable compound, a polymerizable compound having 7 or more functionalities and having a molecular weight of less than 15,000.
[7] The on-press development type lithographic printing plate precursor according to any one of [1] to [6], in which the image-recording layer contains, as the polymerizable compound, a polymerizable compound having 10 or more

functionalities and having a molecular weight of less than 15,000.

[8] The on-press development type lithographic printing plate precursor according to any one of [1] to [7], in which the image-recording layer contains polymer particles.

[9] The on-press development type lithographic printing plate precursor according to [8], in which the polymer particles have a hydrophobic main chain, and includes both

i) a constituent unit having a pendant cyano group directly bonded to the hydrophobic main chain, and
ii) a constituent unit having a pendant group that contains a hydrophilic poly(alkylene oxide) segment.

[10] The on-press development type lithographic printing plate precursor according to [8], in which the polymer particles are obtained by a reaction of a polyvalent isocyanate compound that is an adduct of a polyhydric phenol compound having two or more hydroxy groups in a molecule and isophorone diisocyanate, with a compound having active hydrogen.

[11] The on-press development type lithographic printing plate precursor according to any one of [1] to [10], in which a hydrogen abstraction enthalpy of all hydrogens present in a molecule of the color forming substance precursor is -6.5 kcal/mol or more.

[12] The on-press development type lithographic printing plate precursor described in any one of [1] to [11], in which the color forming substance precursor has a tertiary amine structure.

[13] The on-press development type lithographic printing plate precursor according to any one of [1] to [12], in which the color forming substance precursor includes an acid color forming agent.

[14] The on-press development type lithographic printing plate precursor according to any one of [1] to [13], in which the support has an anodic oxide film,

micropores in the anodic oxide film of the support are each composed of a large diameter portion that extends to a position at a depth of 10 nm to 1,000 nm from a surface of the anodic oxide film and a small diameter portion that is in communication with a bottom portion of the large diameter portion and that extends to a position at a depth of 20 nm to 2,000 nm from a communicate position,

an average diameter of the large diameter portion in the surface of the anodic oxide film is 15 nm to 100 nm, and
an average diameter of the small diameter portion at the communicate position is 15 nm or less.

[15] The on-press development type lithographic printing plate precursor according to any one of [1] to [13], in which the support has an anodic oxide film,

micropores in the anodic oxide film of the support each composed of a small diameter portion that extends to a position at a depth of 10 nm to 1,000 nm from a surface of the anodic oxide film and a large diameter portion that is in communication with a bottom portion of the small diameter portion and that extends to a position at a depth of 20 nm to 2,000 nm from a communicate position,

an average diameter of the small diameter portion in the surface of the anodic oxide film is 35 nm or less, and
an average diameter of the large diameter portion is 40 to 300 nm.

[16] The on-press development type lithographic printing plate precursor according to any one of [1] to [13], in which the support has an anodic oxide film, and

the anodic oxide film has, in order from a surface of the anodic oxide film along a depth direction,

an upper layer that has a thickness of 30 to 500 nm and that has micropores having an average diameter of 20 to 100 nm,
an interlayer that has a thickness of 100 to 300 nm and that has micropores having an average diameter which is 1/2 to 5 times the average diameter of the micropores in the upper layer, and
an under layer that has a thickness of 300 to 2,000 nm and that has micropores having an average diameter of 15 nm or less.

[17] The on-press development type lithographic printing plate precursor according to any one of [1] to [16], in which an end part of the lithographic printing plate precursor has a shear droop shape having a shear droop amount X of 25 to 150 $\mu$m and a shear droop width Y of 70 to 300 $\mu$m.

[18] The on-press development type lithographic printing plate precursor according to [17], in which an ink repellent is provided on a part or all of two opposing lateral surfaces of the lithographic printing plate precursor.

[19] A method of preparing a printing plate, comprising:

a step of image-exposing the on-press development type lithographic printing plate precursor according to any one of [1] to [18]; and

a step of supplying at least any one of printing ink or dampening water on a printer to remove a non-exposed portion of the image-recording layer in the on-press development type lithographic printing plate precursor.

According to the present invention, an on-press development type lithographic printing plate precursor having excellent color formability, and suppressed development delay, and a method of preparing a printing plate using the on-press development type lithographic printing plate precursor can be provided.

In addition, according to the present invention, an on-press development type lithographic printing plate precursor having excellent color formability, suppressed development delay, and further excellent printing durability, and a method of preparing a printing plate using the on-press development type lithographic printing plate precursor can be provided.

## BRIEF DESCRIPTION OF THE DRAWINGS

Fig. 1 is a graph of an example of a waveform diagram of alternating waveform current used for an electrochemical roughening treatment.

Fig. 2 is a lateral view showing an example of a radial cell in an electrochemical roughening treatment using alternating current.

Fig. 3 is a schematic view showing a cross-sectional shape of an end part of a lithographic printing plate precursor.

Fig. 4 is a conceptual view showing an example of a cutting portion of a slitter device.

Fig. 5 is a lateral view conceptually showing a brush graining step used in a mechanical roughening treatment in preparing an aluminum support.

Fig. 6 is a schematic view of an anodization treatment device used for an anodization treatment.

Fig. 7 is a view illustrating a method of performing coating with an ink repellent.

## DESCRIPTION OF THE PREFERRED EMBODIMENTS

Although the configuration requirements to be described below may be described based on representative embodiments of the present invention, the present invention is not limited to such embodiments.

In the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

The term "step" in the present specification means not only an independent step but also a step that cannot be clearly differentiated from other steps as long as the intended goal of the step is achieved.

In the present invention, a combination of two or more preferred aspects is a more preferred aspect.

In addition, in the present specification, unless otherwise specified, each of the mass-average molecular weight (Mw) and number average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

Hereinafter, the present invention will be described in detail.

[On-press development type lithographic printing plate precursor]

The first on-press development type lithographic printing plate precursor according to an embodiment of the present invention (hereinafter, also simply called first lithographic printing plate precursor) is an on-press development type lithographic printing plate precursor comprising, in the following order:

a support;

an image-recording layer; and

a protective layer,

in which the image-recording layer contains a) a polymerizable compound, b) an infrared absorber, c) a polymerization

initiator, and d) a color forming substance precursor, and
the protective layer contains an ultraviolet absorber.

The second on-press development type lithographic printing plate precursor according to an embodiment of the present invention (hereinafter, also simply called second lithographic printing plate precursor) is an on-press development type lithographic printing plate precursor comprising, in the following order:

a support; and
an image-recording layer,
in which the image-recording layer contains a) a polymerizable compound, b) an infrared absorber, c) a polymerization initiator, d) a color forming substance precursor, and e) an ultraviolet absorber, and
the polymerizable compound has 4 or more functionalities and has a molecular weight of less than 15,000.

The third on-press development type lithographic printing plate precursor according to an embodiment of the present invention (hereinafter, also simply called third lithographic printing plate precursor) is an on-press development type lithographic printing plate precursor comprising, in the following order:

a support;
an image-recording layer; and
a protective layer,
in which the image-recording layer contains a) a polymerizable compound, b) an infrared absorber, c) a polymerization initiator, and d) a color forming substance precursor,
the protective layer contains an ultraviolet absorber,
in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer, and
in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

The fourth on-press development type lithographic printing plate precursor according to an embodiment of the present invention (hereinafter, also simply called fourth lithographic printing plate precursor) is an on-press development type lithographic printing plate precursor comprising, in the following order:

a support; and
an image-recording layer,
in which the image-recording layer contains a) a polymerizable compound, b) an infrared absorber, c) a polymerization initiator, d) a color forming substance precursor, and e) an ultraviolet absorber,
in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer, and
in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

According to the first on-press development type lithographic printing plate precursor according to the embodiment of the present invention, by adopting the above-described configuration, an on-press development type lithographic printing plate precursor having excellent color formability and suppressed development delay can be obtained.
In addition, according to the second to fourth on-press development type lithographic printing plate precursors according to the embodiments of present invention, by adopting the above-described configurations, an on-press development type lithographic printing plate precursor having excellent color formability, suppressed development delay, and excellent printing durability can be obtained.
A reason therefor is not clear, but is presumed as follows.
As described above, in the lithographic printing plate precursor in which a color forming substance precursor is contained in an image-recording layer, "development delay" which is the need for time for on-press development, is likely to be caused. The present inventors have focused that the lithographic printing plates are usually stored under a

white fluorescent lamp.

The present inventors have found that the color forming substance precursor contained in the image-recording layer is excited under a white fluorescent lamp and the excited color forming substance precursor initiates unintended polymerization in the image-recording layer. By such polymerization, an unintended polymer may be present in the lithographic printing plate precursor before being exposed. In a case where the lithographic printing plate exposed under a white fluorescent lamp is subjected to on-press development, a non-exposed portion is removed with an ink or dampening water, but the polymer that may be present in the non-exposed portion is difficult to be removed with ink or dampening water and it may take time for the removal thereof, which is conceived to lead to the above-described development delay.

The first on-press development type lithographic printing plate precursor of the embodiment of the present invention contains a protective layer containing an ultraviolet absorber. Even in a case where the lithographic printing plate precursor is stored under a white fluorescent lamp, the ultraviolet absorber absorbs white light from the white fluorescent lamp, and thus the unintended polymerization reaction can be suppressed.

Therefore, it is considered that an on-press development type lithographic printing plate precursor having excellent color formability and suppressed development delay can be obtained.

The second on-press development type lithographic printing plate precursor of the embodiment of the present invention contains an image-recording layer containing an ultraviolet absorber. Similarly to the first on-press development type lithographic printing plate precursor, the unintended polymerization reaction can be suppressed. In addition, the image-recording layer contains a polymerizable compound and the polymerizable compound has 4 or more functionalities and has a molecular weight of less than 15,000.

In a case where the polymerizable compound has 4 or more functionalities, the strength of the exposed portion of the lithographic printing plate can be obtained, and thus the lithographic printing plate has excellent printing durability.

In addition, in a case where the molecular weight of the polymerizable compound is less than 15,000, in on-press development, removal of a non-exposed portion with an ink or dampening water can be easier, and thus a development delay in the on-press development can be further improved.

Therefore, it is considered that an on-press development type lithographic printing plate precursor having excellent color formability, suppressed development delay, and excellent printing durability can be obtained.

In the third and fourth on-press development type lithographic printing plate precursors of the embodiments of the present invention, an image-recording layer or a protective layer contains an ultraviolet absorber. Similarly to the first on-press development type lithographic printing plate precursor, the unintended polymerization reaction can be suppressed.

In the third and fourth on-press development type lithographic printing plate precursors, in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer. In a case where the loss of the ethylenically unsaturated bonds is in the above range, the polymerization reaction in the exposed portion of the lithographic printing plate precursor can be appropriately promoted, and the strength in the exposed portion can be ensured. Therefore, it is conceived that the lithographic printing plate has excellent printing durability.

In the third and fourth on-press development type lithographic printing plate precursors, in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer. It is considered that in a case where the loss of the ethylenically unsaturated bonds is in the above range, an unintended polymerization reaction under white lamp fluorescence can be suppressed, and thus a development delay in on-press development can be suppressed.

Therefore, it is considered that an on-press development type lithographic printing plate precursor having excellent color formability, suppressed development delay, and excellent printing durability can be obtained.

Hereinafter, the first to fourth on-press development type lithographic printing plate precursors according to the embodiments of the present invention (hereinafter, collectively referred to as an on-press development type lithographic printing plate precursor or simply referred to as a lithographic printing plate precursor) will be described in detail.

The on-press development is a method of performing image exposure on a lithographic printing plate precursor, then directly mounting the lithographic printing plate precursor on a printer without performing the wet development treatment of the related art, and removing a non-image area of an image-recording layer at the initial state of the general printing step. The lithographic printing plate precursor that can be subjected to on-press development is an on-press development type lithographic printing plate precursor.

(First on-press development type lithographic printing plate precursor)

First, a first lithographic printing plate precursor according to the embodiment of the present invention will be described.

(Support)

As the support, an aluminum support is preferable. The aluminum plate used in the aluminum support consists of a dimensionally stable metal containing aluminum as a main component, that is, aluminum or an aluminum alloy. It is preferable that the aluminum plate be selected from a pure aluminum plate and an alloy that contains aluminum as a main component and traces of foreign elements.

The foreign elements contained in the aluminum alloy include silicon, iron, manganese, copper, magnesium, chromium, zinc, bismuth, nickel, titanium, and the like. The content of the foreign elements in the alloy is 10% by mass or less. As the aluminum plate, a pure aluminum plate is suitable. However, the aluminum plate may be an alloy that contains traces of foreign elements, because it is difficult to manufacture perfectly pure aluminum by smelting technologies. The composition of the aluminum plate used for the aluminum support is not specified, and it is possible to appropriately use aluminum plates known in the related art, for example, JIS A 1050, JIS A 1100, JIS A 3103, and JIS A 3005, and the like.

The thickness of the support (preferably, the aluminum plate) is preferably about 0.1 to 0.6 mm.

(Anodic oxide film)

The support preferably has an anodic oxide film.

The anodic oxide film means an anodic oxide film (preferably an anodic aluminum oxide film) which is formed on the surface of a support (preferably an aluminum plate) by an anodization treatment and has supermicropores (also called micropores). The micropores extend from the surface of the anodic oxide film on the side opposite to the support along the thickness direction (support side, depth direction).

From the viewpoints of tone reproducibility, printing durability, and blanket stain property, the average diameter (average opening diameter) of the micropores within the surface of the anodic oxide film is preferably 7 nm to 150 nm, more preferably 10 nm to 100 nm, even more preferably 10 nm to 60 nm, particularly preferably 15 nm to 60 nm, and most preferably 18 nm to 40 nm.

The depth of the micropores is preferably 10 nm to 3,000 nm, more preferably 10 nm to 2,000 nm, and even more preferably 10 nm to 1,000 nm.

Usually, the micropores have a substantially straight tubular shape (substantially cylindrical shape) in which the diameter of the micropores substantially does not change in the depth direction (thickness direction). The micropores may also have a conical shape that continues to taper in the depth direction (thickness direction). In addition, the diameter of the micropores may have a shape that discontinuously tapers along the depth direction (thickness direction).

Examples of the micropores having a shape that discontinuously tapers in the depth direction (thickness direction) include micropores each configured with a large diameter portion that extends along the depth direction from the surface of the anodic oxide film and a small diameter portion that is in communication with the bottom portion of the large diameter portion and extends along the depth direction from the communicate position.

Specifically, the micropores are preferable which are each configured with a large diameter portion that extends 10 nm to 1,000 nm in the depth direction from the surface of the anodic oxide film and a small diameter portion that is in communication with the bottom portion of the large diameter portion and extends 20 nm to 2,000 nm in the depth direction from the communicate position.

Hereinafter, the large diameter portion and the small diameter portion will be specifically described.

-Large diameter portion-

From the viewpoints of tone reproducibility, printing durability, and blanket stain property, the average diameter (average opening diameter) of the large diameter portion within the surface of the anodic oxide film is preferably 7 nm to 150 nm, more preferably 10 nm to 100 nm, even more preferably 15 nm to 100 nm, particularly preferably 15 nm to 60 nm, and most preferably 18 nm to 40 nm.

The average diameter of the large diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm $\times$ 600 nm in the obtained 4 images, and calculating the arithmetic mean of the diameters.

In a case where the shape of the large diameter portion is not circular, the equivalent circle diameter is used.

"Equivalent circular diameter" is a diameter determined on an assumption that the opening portion is in the form of a circle having the same projected area as the projected area of the opening portion.

The bottom portion of the large diameter portion is preferably in a position at a depth of 70 nm to 1,000 nm (hereinafter, also called depth A) from the surface of the anodic oxide film. That is, the large diameter portion is preferably a pore portion extending to a position at a depth of 70 nm to 1,000 nm from the surface of the anodic oxide film in the depth direction (thickness direction). Particularly, from the viewpoint of further improving the effect of the manufacturing method of a lithographic printing plate precursor, the depth A is more preferably 90 nm to 850 nm, even more preferably 90 nm to 800 nm, and particularly preferably 90 nm to 600 nm.

The depth is a value obtained by taking an image (150,000X magnification) of a cross section of the anodic oxide film, measuring the depths of 25 or more large diameter portions, and calculating the arithmetic mean thereof.

The shape of the large diameter portion is not particularly limited. Examples of the shape of the large diameter portion include a substantially straight tubular shape (substantially cylindrical shape) and a conical shape that tapers along the depth direction (thickness direction). Among these, a substantially straight tubular shape is preferable. The shape of the bottom portion of the large diameter portion is not particularly limited, and may be a curved (convex) or planar shape.

The inner diameter of the large diameter portion is not particularly limited, but is preferably as large as the diameter of the opening portion or smaller than the diameter of the opening portion. There may be a difference of about 1 nm to 10 nm between the inner diameter of the large diameter portion and the diameter of the opening portion.

-Small diameter portion-

The small diameter portion is a pore portion that is in communication with the bottom portion of the large diameter portion and further extends from the communicate position in the depth direction (thickness direction). Generally, one small diameter portion is in communication with one large diameter portion. However, two or more small diameter portions may be in communication with the bottom portion of one large diameter portion.

The average diameter of the small diameter portion at the communicate position is preferably 15 nm or less, more preferably 13 nm or less, even more preferably 11 nm or less, and particularly preferably 10 nm or less. The lower limit thereof is not particularly limited, but is preferably 5 nm.

The average diameter of the small diameter portion is obtained by observing the surface of the anodic oxide film with FE-SEM at 150,000X magnification (N = 4), measuring the sizes (diameters) of the micropores (small diameter portion) existing in a range of 400 nm $\times$ 600 nm in the obtained 4 images, and calculating the arithmetic mean of the diameters. In a case where the large diameter portion is deep, as necessary, the upper portion of the anodic oxide film (region where the large diameter portion is located) may be cut (for example, cut by using argon gas), then the surface of the anodic oxide film may be observed with FE-SEM described above, and the average diameter of the small diameter portion may be determined.

In a case where the shape of the small diameter portion is not circular, the equivalent circle diameter is used. "Equivalent circular diameter" is a diameter determined on an assumption that the opening portion is in the form of a circle having the same projected area as the projected area of the opening portion.

The bottom portion of the small diameter portion is preferably in a position 20 nm to 2,000 nm distant from the communicate position (corresponding to the depth A described above) with the large diameter portion in the depth direction. In other words, the small diameter portion is a pore portion that extends further from the communicate position with the large diameter portion in the depth direction (thickness direction), and the depth of the small diameter portion is preferably 20 nm to 2,000 nm, more preferably 100 nm to 1,500 nm, and particularly preferably 200 nm to 1,000 nm.

The depth is a value obtained by taking an image (150,000X magnification) of a cross section of the anodic oxide film, measuring the depths of 25 or more small diameter portions, and calculating the arithmetic mean thereof.

The shape of the small diameter portion is not particularly limited. Examples of the shape of the small diameter portion include a substantially straight tubular shape (substantially cylindrical shape) and a conical shape that tapers along the depth direction. Among these, a substantially straight tubular shape is preferable. In addition, the shape of the bottom portion of the small diameter portion is not particularly limited, and may be a curved (convex) or planar shape.

The inner diameter of the small diameter portion is not particularly limited, and may be the same as the diameter at the communicate position, or may be smaller or larger than the diameter at the communicate position. Generally, there may be a difference of about 1 nm to 10 nm between the inner diameter of the small diameter portion and the diameter of the opening portion.

The ratio of the average diameter of the large diameter portion within the surface of the anodic oxide film to the average diameter of the small diameter portion at the communicate position, (average diameter of large diameter portion within surface of anodic oxide film)/(average diameter of small diameter portion at communicate position) is preferably 1.1 to 13, and more preferably 2.5 to 6.5.

The ratio of the depth of the large diameter portion to the depth of the small diameter portion, (depth of large

diameter portion)/(depth of small diameter portion) is preferably 0.005 to 50, and more preferably 0.025 to 40.

The micropores have a substantially straight tubular shape (substantially cylindrical shape) in which the diameter of the micropores substantially does not change in the depth direction (thickness direction). The micropores may also have a conical shape that continues to widen in the depth direction (thickness direction). The micropores may have a shape that discontinuously widens along the depth direction (thickness direction).

Examples of the micropores having a shape that discontinuously widens in the depth direction (thickness direction) include micropores each configured with a small diameter portion that extends along the depth direction from the surface of the anodic oxide film and a large diameter portion that is in communication with the bottom portion of the small diameter portion and extends along the depth direction from the communicate position.

Specifically, the micropores are preferable which are each configured with a small diameter portion that extends 10 nm to 1,000 nm in the depth direction from the surface of the anodic oxide film and a large diameter portion that is in communication with the bottom portion of the small diameter portion and further extends 20 nm to 2,000 nm in the depth direction from the communicate position.

-Small diameter portion-

The average diameter (average opening diameter) of the small diameter portion within the surface of the anodic oxide film is not particularly limited, but is preferably 35 nm or less, more preferably 25 nm or less, and particularly preferably 20 nm or less. The lower limit thereof is not particularly limited, but is preferably 15 nm.

The average diameter of the small diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm × 600 nm in the obtained 4 images, and calculating the arithmetic mean of the diameters.

In a case where the shape of the small diameter portion is not circular, the equivalent circle diameter is used. "Equivalent circular diameter" is a diameter determined on an assumption that the opening portion is in the form of a circle having the same projected area as the projected area of the opening portion.

The bottom portion of the small diameter portion is preferably in a position at a depth of 70 nm to 1,000 nm (hereinafter, also called depth A') from the surface of the anodic oxide film. That is, the small diameter portion is preferably a pore portion extending 70 nm to 1,000 nm in the depth direction (thickness direction) from the surface of the anodic oxide film.

The depth is a value obtained by taking an image (150,000X magnification) of a cross section of the anodic oxide film, measuring the depths of 25 or more large diameter portions, and calculating the arithmetic mean thereof.

The shape of the small diameter portion is not particularly limited. Examples of the shape of the large diameter portion include a substantially straight tubular shape (substantially cylindrical shape) and a conical shape that widens along the depth direction (thickness direction). Among these, a substantially straight tubular shape is preferable. In addition, the shape of the bottom portion of the small diameter portion is not particularly limited, and may be a curved (convex) or planar shape.

The inner diameter of the small diameter portion is not particularly limited, but is preferably as large as the diameter of the opening portion or smaller than the diameter of the opening portion. There may be a difference of about 1 nm to 10 nm between the inner diameter of the small diameter portion and the diameter of the opening portion.

-Large diameter portion-

The large diameter portion is a pore portion that is in communication with the bottom portion of the small diameter portion and further extends from the communicate position in the depth direction (thickness direction). Generally, as for one large diameter portion, the bottom portion of one large diameter portion may be in communication with two or more small diameter portions.

The average diameter of the large diameter portion at the communicate position is preferably 20 nm to 400 nm, more preferably 40 nm to 300 nm, even more preferably 50 nm to 200 nm, and particularly preferably 50 nm to 100 nm.

The average diameter of the large diameter portion is obtained by observing the surface of the anodic oxide film with FE-SEM at 150,000X magnification (N = 4), measuring the sizes (diameters) of the micropores (large diameter portion) existing in a range of 400 nm × 600 nm in the obtained 4 images, and calculating the arithmetic mean of the diameters. In a case where the small diameter portion is deep, as necessary, the upper portion of the anodic oxide film (region where the small diameter portion is located) may be cut (for example, cut by using argon gas), then the surface of the anodic oxide film may be observed with FE-SEM described above, and the average diameter of the large diameter portion may be determined.

In a case where the shape of the large diameter portion is not circular, the equivalent circle diameter is used. "Equivalent circular diameter" is a diameter determined on an assumption that the opening portion is in the form of a

circle having the same projected area as the projected area of the opening portion.

The bottom portion of the large diameter portion is preferably in a position 20 nm to 2,000 nm distant from the communicate position (corresponding to the depth A' described above) with the small diameter portion in the depth direction. In other words, the large diameter portion is a pore portion that extends further from the communicate position with the small diameter portion in the depth direction (thickness direction), and the depth of the large diameter portion is preferably 20 nm to 2,000 nm, more preferably 100 nm to 1,500 nm, and particularly preferably 200 nm to 1,000 nm.

The depth is a value obtained by taking an image (150,000X magnification) of a cross section of the anodic oxide film, measuring the depths of 25 or more large diameter portions, and calculating the arithmetic mean thereof.

The shape of the large diameter portion is not particularly limited. Examples of the shape of the large diameter portion include a substantially straight tubular shape (substantially cylindrical shape) and a conical shape that tapers along the depth direction. Among these, a substantially straight tubular shape is preferable. The shape of the bottom portion of the large diameter portion is not particularly limited, and may be a curved (convex) or planar shape.

The inner diameter of the large diameter portion is not particularly limited, and may be the same as the diameter at the communicate position, or may be smaller or larger than the diameter at the communicate position. Generally, there may be a difference of about 1 nm to 10 nm between the inner diameter of the large diameter portion and the diameter of the opening portion.

It is preferable that the support has an anodic oxide film, and
that the anodic oxide film has, in order from the surface of the anodic oxide film along the depth direction,

an upper layer that has a thickness of 30 to 500 nm and that has micropores having an average diameter of 20 to 100 nm,
an interlayer that has a thickness of 100 to 300 nm and that has micropores having an average diameter which is 1/2 to 5 times the average diameter of the micropores in the upper layer, and
an upper layer that has a thickness of 300 to 2,000 nm and that has micropores having an average diameter of 15 nm or less.

In an on-press development type lithographic printing plate precursor, from the viewpoint of improving image visibility, a support is useful in which the surface of an anodic oxide film (surface on which an image-recording layer is to be formed) has high brightness.

Usually, in a printing step using a lithographic printing plate, before the printing plate is mounted on a printer, the plate is inspected to check whether an image is printed as intended. For the on-press development type lithographic printing plate precursor, it is required to check the image at the stage where the image is exposed. Therefore, a unit generating a so-called printed image in an image exposed portion is used.

Examples of a method of quantitatively evaluating the visibility of an image area (image visibility) of the on-press development type lithographic printing plate precursor having undergone exposure of an image include a method of measuring the brightness of an image exposed portion and the brightness of a non-exposed portion and calculating the difference therebetween. As the brightness, a value of brightness L* in the CIEL*a*b* color system can be used. The brightness can be measured using a color difference meter (Spectro Eye, manufactured by X-Rite, Incorporated.). The larger the difference between the measured brightness of the image exposed portion and the measured brightness of the non-exposed portion is, the higher the visibility of the image area is.

It has been revealed that the larger the value of brightness L* of the surface of the anodic oxide film in the CIEL*a*b* color system is, the more effective it is to increase the difference between the brightness of the image exposed portion and the brightness of the non-exposed portion. That is, the value of the brightness L* is preferably 60 to 100.

As necessary, the support having an anodic oxide film may have a backcoat layer containing the organic high-molecular-weight compound described in JP1993-45885A (JP-H5-45885A), the alkoxy compound of silicon described in JP1994-35174A (JP-H6-35174A), or the like, on a surface opposite to the side where a constitutional layer containing a hydroxy acid compound having two or more hydroxyl groups is formed.

(Manufacturing of aluminum support having anodic oxide film)

The manufacturing method of an aluminum support having an anodic oxide film, which is an example of support, will be described.

The aluminum support having an anodic oxide film can be manufactured using known methods. The manufacturing method of the aluminum support having an anodic oxide film is not particularly limited. Examples of preferred aspects of the manufacturing method of the aluminum support having an anodic oxide film include a method including a step of performing a roughening treatment on an aluminum plate (roughening treatment step), a step of anodizing the aluminum plate having undergone the roughening treatment (anodization treatment step), and a step of bringing the aluminum plate having an anodic oxide film obtained by the anodization treatment step into contact with an aqueous

acid solution or an alkaline aqueous solution to increase the diameter of micropores in the anodic oxide film (pore widening treatment step).

Hereinafter, each step will be described in detail.

<Roughening treatment step>

The roughening treatment step is a step of performing a roughening treatment including an electrochemical roughening treatment on the surface of the aluminum plate. The roughening treatment step is preferably performed before the anodization treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment may be performed in combination with at least either a mechanical roughening treatment or a chemical roughening treatment.

In a case where the mechanical roughening treatment and the electrochemical roughening treatment are combined, it is preferable to perform the electrochemical roughening treatment after the mechanical roughening treatment.

The electrochemical roughening treatment is preferably performed in an aqueous solution of nitric acid or hydrochloric acid.

Generally, the mechanical roughening treatment is performed such that the aluminum plate has a surface roughness Ra: 0.35 to 1.0 μm.

The conditions of the mechanical roughening treatment are not particularly limited. For example, the mechanical roughening treatment can be performed according to the method described in JP1975-40047B (JP-S50-40047B). The mechanical roughening treatment can be performed by a brush graining treatment using a pumice stone suspension or by a transfer method.

The chemical roughening treatment is also not particularly limited, and can be performed according to known methods.

After the mechanical roughening treatment, it is preferable to perform the following chemical etching treatment.

By the chemical etching treatment performed after the mechanical roughening treatment, the edge portion of surface irregularities of the aluminum plate smoothed, such that ink clotting that may occur during printing is prevented, the antifouling property of the lithographic printing plate is improved, and unnecessary substances such as abrasive particles remaining on the surface are removed.

As the chemical etching treatment, etching with an acid and etching with an alkali are known. One of the examples of particularly efficient etching methods is a chemical etching treatment using an alkaline solution (hereinafter, also called "alkaline etching treatment").

The alkaline agent used in the alkaline solution is not particularly limited. Suitable examples thereof include caustic soda, caustic potash, sodium metasilicate, sodium carbonate, sodium aluminate, sodium gluconate, and the like.

The alkaline solution may contain aluminum ions. The concentration of the alkaline agent in the alkaline solution is preferably 0.01% by mass or more and more preferably 3% by mass or more. In addition, the concentration is preferably 30% by mass or less and more preferably 25% by mass or less.

The temperature of the alkaline solution is preferably equal to or more than room temperature and more preferably 30°C or more. In addition, the temperature is preferably 80°C or less and more preferably 75°C or less.

The etching amount is preferably 0.01 $g/m^2$ or more, and more preferably 0.05 $g/m^2$ or more. In addition, the etching amount is preferably 30 $g/m^2$ or less, and more preferably 20 $g/m^2$ or less.

The treatment time preferably is in a range of 2 seconds to 5 minutes depending on the etching amount. In view of improving productivity, the treatment time is more preferably 2 to 10 seconds.

In a case where the alkaline etching treatment is performed after the mechanical roughening treatment, in order to remove products generated by the alkaline etching treatment, the chemical etching treatment by using a low-temperature acidic solution (hereinafter, also called "desmutting treatment") is preferably performed.

The acid used in the acidic solution is not particularly limited, and examples thereof include sulfuric acid, nitric acid, and hydrochloric acid. The concentration of the acidic solution is preferably 1% to 50% by mass. The temperature of the acidic solution is preferably 20°C to 80°C. In a case where the concentration and temperature of the acidic solution are in this range, the lithographic printing plate using an aluminum support becomes more resistant to dot-like stain.

Examples of preferred aspects of the roughening treatment step are as below.

-Aspect SA-

An aspect in which the following treatments (1) to (8) are performed in this order.

(1) Chemical etching treatment using alkaline aqueous solution (first alkaline etching treatment)
(2) Chemical etching treatment using acidic aqueous solution (first desmutting treatment)
(3) Electrochemical roughening treatment using aqueous solution containing nitric acid as main component (first electrochemical roughening treatment)
(4) Chemical etching treatment using alkaline aqueous solution (second alkaline etching treatment)
(5) Chemical etching treatment using acidic aqueous solution (second desmutting treatment)
(6) Electrochemical roughening treatment using aqueous solution containing hydrochloric acid as main component (second electrochemical roughening treatment)
(7) Chemical etching treatment using alkaline aqueous solution (third alkaline etching treatment)
(8) Chemical etching treatment using acidic aqueous solution (third desmutting treatment)

-Aspect SB-

An aspect in which the following treatments (11) to (15) are performed in this order.

(11) Chemical etching treatment using alkaline aqueous solution (fourth alkaline etching treatment)
(12) Chemical etching treatment using acidic aqueous solution (fourth desmutting treatment)
(13) Electrochemical roughening treatment using aqueous solution containing hydrochloric acid as main component (third electrochemical roughening treatment)
(14) Chemical etching treatment using alkaline aqueous solution (fifth alkaline etching treatment)
(15) Chemical etching treatment using acidic aqueous solution (fifth desmutting treatment)

As necessary, a mechanical roughening treatment may be performed before the treatment (1) of the aspect SA or before the treatment (11) of the aspect SB.

The amount of the aluminum plate dissolved by the first alkaline etching treatment and the fourth alkaline etching treatment is preferably 0.5 $g/m^2$ to 30 $g/m^2$ and more preferably 1.0 $g/m^2$ to 20 $g/m^2$.

Examples of the aqueous solution containing nitric acid as a main component used in the first electrochemical roughening treatment of the aspect SA include aqueous solutions used in the electrochemical roughening treatment using direct current or alternating current. Examples thereof include an aqueous solution obtained by adding aluminum nitrate, sodium nitrate, ammonium nitrate, or the like to a 1 g/L to 100 g/L aqueous nitric acid solution.

Examples of the aqueous solution containing hydrochloric acid as a main component used in the second electrochemical roughening treatment of the aspect SA and in the third electrochemical roughening treatment of the aspect SB include aqueous solutions used in the electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, or ammonium nitrate; or hydrochloric acid ions such as aluminum chloride, sodium chloride, or ammonium chloride may be further added to the aqueous solution.

As the waveform of an alternating current power source for the electrochemical roughening treatment, a sine wave, a square wave, a trapezoidal wave, a triangular wave, or the like can be used. The frequency is preferably 0.1 Hz to 250 Hz.

Fig. 1 is a graph showing an example of waveform diagram of alternating waveform current used for an electrochemical roughening treatment.

In Fig. 1, ta represents an anodic reaction time, tc represents a cathodic reaction time, tp represents the time taken for current to reach a peak from 0, Ia represents the peak current on the anodic cycle side, and Ic represents the peak current on the cathodic cycle side. For a trapezoidal wave, the time tp taken for current to reach a peak from 0 is preferably 1 msec to 10 msec. Regarding the conditions of one cycle of alternating current used for the electrochemical roughening treatment, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 msec to 1,000 msec. The peak current density of the trapezoidal wave is preferably 10 to 200 $A/dm^2$ at both the anodic cycle side Ia and the cathodic cycle side Ic of the current. Ic/Ia is preferably 0.3 to 20. At a point in time when the electrochemical roughening treatment has ended, the total quantity of electricity that participates in the anodic reaction of the aluminum plate is preferably 25 $C/dm^2$ to 1,000 $C/dm^2$.

The electrochemical roughening treatment using alternating current can be performed using the device shown in Fig. 2.

Fig. 2 is a lateral view showing an example of a radial cell in an electrochemical roughening treatment using alternating current.

In Fig. 2, 50 represents a main electrolytic cell, 51 represents an alternating current power source, 52 represents

a radial drum roller, 53a and 53b represent main poles, 54 represents an electrolytic solution supply port, 55 represents an electrolytic solution, 56 represents a slit, 57 represents an electrolytic solution channel, 58 represents an auxiliary anode, 60 represents an auxiliary anode cell, and W represents an aluminum plate. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution channel 57 between the radial drum roller 52 and the main poles 53a and 53b through the slit 56. The aluminum plate W treated in the main electrolytic cell 50 is then electrolyzed in the auxiliary anode cell 60. In the auxiliary anode cell 60, the auxiliary anode 58 is disposed to face the aluminum plate W. The electrolytic solution 55 is supplied to flow in the space between the auxiliary anode 58 and the aluminum plate W.

In view of easily manufacturing a predetermined lithographic printing plate precursor, the amount of the aluminum plate dissolved by the second alkaline etching treatment is preferably 1.0 g/m$^2$ to 20 g/m$^2$ and more preferably 2.0 g/m$^2$ to 10 g/m$^2$.

In view of easily manufacturing a predetermined lithographic printing plate precursor, the amount of the aluminum plate dissolved by the third alkaline etching treatment and the fifth alkaline etching treatment is preferably 0.01 g/m$^2$ to 0.8 g/m$^2$ and more preferably 0.05 g/m$^2$ to 0.3 g/m$^2$.

In the chemical etching treatment (first to fifth desmutting treatments) using an acidic aqueous solution, an acidic aqueous solution containing phosphoric acid, nitric acid, sulfuric acid, chromic acid, hydrochloric acid, or a mixed acid consisting of two or more of these acids is suitably used.

The concentration of the acid in the acidic aqueous solution is preferably 0.5% by mass to 60% by mass.

<Anodization treatment step>

The anodization treatment step is a step of performing an anodization treatment on the aluminum plate having undergone the roughening treatment such that an aluminum oxide film is formed on the surface of the aluminum plate. By the anodization treatment, an anodic oxide film of aluminum having micropores is formed on the surface of the aluminum plate.

The anodization treatment can be performed according to the method known in the field of the related art, by appropriately setting manufacturing conditions in consideration of the desired micropore shape.

In the anodization treatment step, an aqueous solution of sulfuric acid, phosphoric acid, oxalic acid, or the like can be mainly used as an electrolytic solution. In some cases, an aqueous solution or a non-aqueous solution of chromic acid, sulfamic acid, benzenesulfonic acid, or the like or an aqueous solution or a non-aqueous solution containing two or more acids among the above acids can also be used. In a case where direct current or alternating current is applied to the aluminum plate in the electrolytic solution, an anodic oxide film can be formed on the surface of the aluminum plate. The electrolytic solution may contain aluminum ions. The content of the aluminum ions is not particularly limited, and is preferably 1 to 10 g/L.

The conditions of the anodization treatment are appropriately set depending on the electrolytic solution used. Generally, the concentration of the electrolytic solution of 1% to 80% by mass (preferably 5% to 20% by mass), the liquid temperature of 5°C to 70°C (preferably 10°C to 60°C), the current density of 0.5 to 60 A/dm$^2$ (preferably 5 to 50 A/dm$^2$), the voltage of 1 to 100 V (preferably 5 to 50 V), and the electrolysis time of 1 to 100 seconds (preferably 5 to 60 seconds) are appropriate.

One of the preferred examples of the anodization treatment is the anodization method described in British Patent 1,412,768, which is performed in a sulfuric acid at a high current density.

The anodization treatment can also be performed multiple times. It is possible to change one or more of conditions, such as the type, concentration, and liquid temperature of the electrolytic solution used in each anodization treatment, the current density, the voltage, and the electrolysis time. In a case where the anodization treatment is performed twice, sometime the firstly performed anodization treatment is called first anodization treatment, and the secondly performed anodization treatment is called second anodization treatment. Performing the first anodization treatment and the second anodization treatment makes it possible to form anodic oxide films having different shapes and to provide a lithographic printing plate precursor having excellent printing performance.

Furthermore, it is also possible to perform the following pore widening treatment after the anodization treatment and then perform the anodization treatment again. In this case, the first anodization treatment, the pore widening treatment, and the second anodization treatment are performed.

Using the method of performing the first anodization treatment, the pore widening treatment, and the second anodization treatment makes it possible to form micropores each configured with a large diameter portion that extends from the surface of the anodic oxide film along the depth direction and a small diameter portion that is in communication with the bottom portion of the large diameter portion and extends from the communicate position along the depth direction.

<Pore widening treatment step>

The pore widening treatment step is a treatment of enlarging the diameter of micropores (pore diameter) present in the anodic oxide film formed by the aforementioned anodization treatment step (pore diameter enlarging treatment). By the pore widening treatment, the diameter of the micropores is enlarged, and an anodic oxide film having micropores having a larger average diameter is formed.

The pore widening treatment can be carried out by bringing the aluminum plate obtained by the anodization treatment step into contact with an aqueous acid solution or an alkaline aqueous solution. The contact method is not particularly limited, and examples thereof include a dipping method and a spraying method. Among these, a dipping method is preferable.

In a case where an alkaline aqueous solution is used in the pore widening treatment step, it is preferable to use at least one alkaline aqueous solution selected from the group consisting of sodium hydroxide, potassium hydroxide, and lithium hydroxide. The concentration of the alkaline aqueous solution is preferably 0.1% to 5% by mass. As a proper treatment method, the pH of the alkaline aqueous solution is adjusted to 11 to 13, and the aluminum plate is brought into contact with the alkaline aqueous solution for 1 to 300 seconds (preferably 1 to 50 seconds) under the condition of 10°C to 70°C (preferably 20°C to 50°C). At this time, the alkaline treatment liquid may contain a metal salt of a polyvalent weak acid such as carbonate, borate, or phosphate.

In a case where an aqueous acid solution is used in the pore widening treatment step, it is preferable to use an aqueous solution of an inorganic acid such as sulfuric acid, phosphoric acid, nitric acid, or hydrochloric acid, or a mixture of these. The concentration of the aqueous acid solution is preferably 1% to 80% by mass, and more preferably 5% to 50% by mass. As a proper treatment method, the aluminum plate is brought into contact with the aqueous acid solution for 1 to 300 seconds (preferably 1 to 150 seconds) under the condition of a liquid temperature of the aqueous acid solution of 5°C to 70°C (preferably 10°C to 60°C).

The alkaline aqueous solution or the aqueous acid solution may contain aluminum ions. The content of the aluminum ions is not particularly limited, and is preferably 1 to 10 g/L.

The manufacturing method of the aluminum support having an anodic oxide film may include a hydrophilic treatment step of performing a hydrophilic treatment after the pore widening treatment step described above. As the hydrophilic treatment, it is possible to use the known method described in paragraphs "0109" to "0114" of JP2005-254638A.

The hydrophilic treatment is preferably performed by a method of immersing the aluminum plate in an aqueous solution of an alkali metal silicate such as sodium silicate or potassium silicate, a method of coating the aluminum plate with a hydrophilic vinyl polymer or a hydrophilic compound to form a hydrophilic undercoat layer, or the like.

The hydrophilic treatment using an aqueous solution of an alkali metal silicate such as sodium silicate or potassium silicate can be performed according to the method and procedure described in US2714066A and US3181461A.

[Image-recording layer]

The image-recording layer contains a) a polymerizable compound, b) an infrared absorber, c) a polymerization initiator, and d) a color forming substance precursor.

a) Polymerizable compound

The polymerizable compound may be, for example, a radically polymerizable compound or a cationically polymerizable compound. As the polymerizable compound, an addition polymerizable compound having at least one ethylenically unsaturated bond (ethylenically unsaturated compound) is preferable. The ethylenically unsaturated compound is preferably a compound having at least one ethylenically unsaturated bond on a terminal, and more preferably a compound having two or more ethylenically unsaturated bonds on a terminal. The polymerizable compound can have a chemical form such as a monomer or a prepolymer, that is, a dimer, a trimer, an oligomer, a mixture of these, or the like.

From the viewpoint of printing durability, the polymerizable compound preferably has 4 or more functionalities, more preferably has 7 or more functionalities, and even more preferably has 10 or more functionalities. The "functionality" indicates a group (functional group) that contributes to polymerization, and an ethylenically unsaturated bond is preferable. For example, the term "4 or more functionalities" indicates that the number of groups contributing to polymerization is 4 or more.

The polymerizable compound is not particularly limited, but usually has 20 or less functionalities.

From the viewpoint of printing durability, the polymerizable compound is preferably an ethylenically unsaturated compound having 4 or more functionalities, more preferably an ethylenically unsaturated compound having 7 or more functionalities, and even more preferably an ethylenically unsaturated compound having 10 or more functionalities.

The molecular weight of the polymerizable compound (the weight-average molecular weight in a case where

the compound has molecular weight distribution) is not particularly limited, but the molecular weight thereof is preferably smaller from the viewpoint of on-press developability and the molecular weight thereof is preferably larger from the viewpoint of printing durability.

The molecular weight of the polymerizable compound is preferably less than 15,000. In addition, the molecular weight thereof is preferably 100 or greater.

From the viewpoints of achieving both on-press developability and printing durability, the molecular weight of the polymerizable compound is preferably 100 or more and less than 15,000, more preferably 500 or more and less than 13,000, and even more preferably 1,000 or more and less than 10,000.

As a preferred aspect, the image-recording layer preferably contains a polymerizable compound having 7 or more functionalities and having a molecular weight of less than 15,000, as the polymerizable compound.

As a preferred aspect, the image-recording layer preferably contains a polymerizable compound having 10 or more functionalities and having a molecular weight of less than 15,000, as the polymerizable compound.

Examples of the monomer include unsaturated carboxylic acids (for example, acrylic acid, methacrylic acid, itaconic acid, crotonic acid, isocrotonic acid, and maleic acid), and esters and amides thereof. It is preferable to use esters of an unsaturated carboxylic acid and a polyhydric alcohol compound, or amides of an unsaturated carboxylic acid and a polyvalent amine compound. In addition, products of an addition reactant of unsaturated carboxylic acid esters or amides having a nucleophilic substituent such as a hydroxy group, an amino group, or a mercapto group and monofunctional or polyfunctional isocyanates or epoxies, a dehydrocondensation reactant of the aforementioned unsaturated carboxylic acid esters or amides and a monofunctional or polyfunctional carboxylic acid, and the like are also suitably used. Furthermore, an addition reactant of unsaturated carboxylic acid esters or amides having an electrophilic substituent such as an isocyanate group or an epoxy group and monofunctional or polyfunctional alcohols, amines, or thiols, and a substitution reactant of unsaturated carboxylic acid esters or amides having a leaving substituent such as a halogen atom or a tosyloxy group and monofunctional or polyfunctional alcohols, amines, or thiols are also suitable. In addition, as another example, it is also possible to use a group of compounds obtained by substituting the unsaturated carboxylic acid with an unsaturated phosphonic acid, styrene, vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers. Examples of the methacrylic acid ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis[p-(methacryloxyethoxy)phenyl]dimethylmethane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds manufactured using an addition reaction between an isocyanate and a hydroxy group are also suitable, and specific examples thereof include vinyl urethane compounds having two or more polymerizable vinyl groups in one molecule obtained by adding vinyl monomers containing a hydroxy group represented by the following Formula (M) to a polyisocyanate compound having two or more isocyanate groups in one molecule which is described in, for example, JP1973-41708B (JP-S48-41708B).

$$CH_2=C(R^{M4})COOCH_2CH(R^{M5})OH \qquad (M)$$

In Formula (M), $R^{M4}$ and $R^{M5}$ each independently represent a hydrogen atom or a methyl group.

Furthermore, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

Details of how to use the polymerizable compound, such as the structure of the compound, whether the compound is used alone or used in combination with other compounds, and the amount of the compound to be added, can be randomly set in consideration of the final use of the lithographic printing plate precursor or the like.

The content of the polymerizable compound with respect to the total solid content of the image-recording layer

is preferably 1% to 50% by mass, more preferably 3% to 30% by mass, and even more preferably 5% to 20% by mass.

b) Infrared absorber

The infrared absorber has a function of inducing electron migration and/or energy transfer to a polymerization initiator or the like by being excited by infrared rays. The infrared absorber also has a function of converting absorbed infrared rays into heat. It is preferable that the infrared absorber have maximal absorption in a wavelength range of 750 to 1,400 nm. Examples of the infrared absorber include a dye or pigment. A dye is preferably used.

As the dye, it is possible to use commercially available dyes and known dyes described in publications such as "Dye Handbooks" (edited by the Society of Synthetic Organic Chemistry, Japan, 1970). Specific examples thereof include dyes such as an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among dyes, a cyanine colorant, a squarylium colorant, or a pyrylium salt is preferable, a cyanine colorant is more preferable, and an indolenine cyanine colorant is particularly preferable.

Examples of the cyanine colorant include a cyanine colorant represented by Formula (a).

Formula (a)

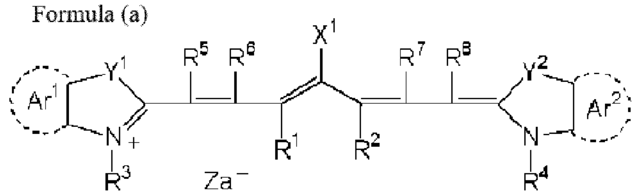

In Formula (a), $X^1$ represents a hydrogen atom, a halogen atom, $-N(R^9)(R^{10})$, $-X^2-L^1$, or a group shown below. Here, $R^9$ and $R^{10}$ may be the same as or different from each other and each independently represent an aromatic hydrocarbon group having 6 to 10 carbon atoms, an alkyl group having 1 to 8 carbon atoms, or a hydrogen atom, or $R^9$ and $R^{10}$ may be bonded to each other to form a ring. The aromatic hydrocarbon group having 6 to 10 carbon atoms or the alkyl group having 1 to 8 carbon atoms may have a substituent. Both $R^9$ and $R^{10}$ are preferably a phenyl group. $X^2$ represents an oxygen atom or a sulfur atom, and $L^1$ represents a hydrocarbon group having 1 to 12 carbon atoms or a heteroatom-containing hydrocarbon group having 1 to 12 carbon atoms. Here, the heteroatom represents N, S, O, a halogen atom, or Se. In the group shown below, $Xa^-$ has the same definition as that for $Za^-$ described later, and Ra represents a hydrogen atom or a substituent selected from an alkyl group, an aryl group, a substituted or unsubstituted amino group, and a halogen atom.

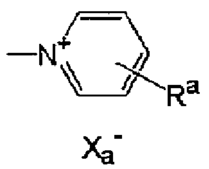

In Formula (a), $R^1$ and $R^2$ each independently represent a hydrocarbon group having 1 to 12 carbon atoms. From the viewpoint of the storage stability of the image-recording layer coating liquid, $R^1$ and $R^2$ each preferably represent a hydrocarbon group having 2 or more carbon atoms, and $R^1$ and $R^2$ particularly preferably bond to each other to form a 5-membered ring or a 6-membered ring.

In Formula (a), $Ar^1$ and $Ar^2$ may be the same as or different from each other, and $Ar^1$ and $Ar^2$ each represent an aromatic hydrocarbon group. The aromatic hydrocarbon group may have a substituent. Preferred examples of the aromatic hydrocarbon groups include a benzene ring group and a naphthalene ring group. In addition, preferred examples of the substituent include a hydrocarbon group having 12 or less carbon atoms, a halogen atom, and an alkoxy group having 12 or less carbon atoms. $Y^1$ and $Y^2$ may be the same as or different from each other, and $Y^1$ and $Y^2$ each represent a sulfur atom or a dialkylmethylene group having 12 or less carbon atoms. $R^3$ and $R^4$ may be the same as or different from each other, and $R^3$ and $R^4$ each represent a hydrocarbon group having 20 or less carbon atoms. The hydrocarbon group having 20 or less carbon atoms may have a substituent. Preferred examples of the substituent include an alkoxy group having 12 or less carbon atoms, a carboxy group, and a sulfo group. $R^5$, $R^6$, $R^7$, and $R^8$ may be the same as or different from each other, and $R^5$, $R^6$, $R^7$, and $R^8$ each represent a hydrogen atom or a hydrocarbon group having 12 or less carbon atoms. From the viewpoint of availability of a raw material, a hydrogen atom is preferable. In

addition, Za⁻ represents a counter anion. Provided that Za⁻ is not necessary in a case where the cyanine colorant represented by Formula (a) has an anionic substituent in the structure thereof and neutralization of the charge is not required. From the viewpoint of the storage stability of the image-recording layer coating liquid, Za⁻ is preferably a halide ion, a perchlorate ion, a tetrafluoroborate ion, a hexafluorophosphate ion, or a sulfonate ion and more preferably a perchlorate ion, a hexafluorophosphate ion, or an aryl sulfonate ion.

In the cyanine colorant represented by Formula (a), $X^1$ is more preferably a diphenylamino group. In addition, it is even more preferable that $X^1$ is a diphenylamino group and both $Y^1$ and $Y^2$ are a dimethylmethylene group.

Specific examples of the cyanine colorant include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to " 0076" of JP2008-195018A are preferable.

One infrared absorber may be used alone, or two or more infrared absorbers may be used in combination.

The content of the infrared absorber in the total solid content of the image-recording layer is preferably 0.05% to 30% by mass, more preferably 0.1% to 20% by mass, and even more preferably 0.2% to 10% by mass.

c) Polymerization initiator

The polymerization initiator is a compound that generates a polymerization initiation species such as a radical or a cation by either or both of light energy and heat energy. The polymerization initiator to be used can be appropriately selected from known thermal polymerization initiators, compounds having a bond that requires low bond dissociation energy, photopolymerization initiators, and the like.

As the polymerization initiator, an infrared-sensitive photopolymerization initiator is preferable. In addition, as the polymerization initiator, a radical polymerization initiator is preferable. Two or more radical polymerization initiators may be used in combination.

The radical polymerization initiator may be either an electron-accepting polymerization initiator or an electron-donating polymerization initiator.

<Electron-accepting polymerization initiator>

Examples of the electron-accepting polymerization initiator include an organic halide, a carbonyl compound, an azo compound, an organic peroxide, a metallocene compound, an azide compound, a hexaarylbiimidazole compound, a disulfone compound, an oxime ester compound, and an onium salt compound.

As the organic halide, for example, the compounds described in paragraphs "0022" and" 0023" of JP2008-195018A are preferable.

As the carbonyl compound, for example, the compounds described in paragraph "0024" of JP2008-195018A are preferable.

Examples of the azo compound include the azo compounds described in JP1996-108621A (JP-H08-108621A), and the like.

As the organic peroxide, for example, the compounds described in paragraph "0025" of JP2008-195018A are preferable.

As the metallocene compound, for example, the compounds described in paragraph "0026" of JP2008-195018A are preferable.

Examples of the azide compound include compounds such as 2,6-bis(4-azidobenzylidene)-4-methylcyclohexanone.

As the hexaarylbiimidazole compound, for example, the compounds described in paragraph "0027" of JP2008-195018A are preferable.

Examples of the disulfone compound include the compounds described in JP1986-166544A (JP-S61-166544A) and JP2002-328465A.

As the oxime ester compound, for example, the compounds described in paragraphs "0028" to "0030" of JP2008-195018A are preferable.

Among the electron-accepting polymerization initiators, for example, an include onium salt such as an iodonium salt, a sulfonium salt, or an azinium salt is more preferable. Among these, an iodonium salt and a sulfonium salt are particularly preferable. Specific examples of the iodonium salt and the sulfonium salt will be shown below, but the present invention is not limited thereto.

As the iodonium salt, for example, a diphenyliodonium salt is preferable. Particularly, a diphenyl iodonium salt having an electron-donating group, for example, a diphenyl iodonium salt substituted with an alkyl group or an alkoxyl group is preferable, and an asymmetric diphenyl iodonium salt is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1 -perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt, for example, a triarylsulfonium salt is preferable. Particularly, a triarylsulfonium salt having an electron withdrawing group as a substituent, for example, a triarylsulfonium salt is preferable in which at least some of the groups on an aromatic ring are substituted with halogen atoms, and a triarylsulfonium salt is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

One electron-accepting polymerization initiator may be used alone, or two or more electron-accepting polymerization initiators may be used in combination.

The content of the electron-accepting polymerization initiator with respect to the total solid content of the image-recording layer is preferably 0.1% to 50% by mass, more preferably 0.5% to 30% by mass, and even more preferably 0.8% to 20% by mass.

<Electron-donating polymerization initiator>

The electron-donating polymerization initiator contributes to the improvement of printing durability of a lithographic printing plate prepared from the lithographic printing plate precursor. Examples of the electron-donating polymerization initiator include the following five initiators.

(i) Alkyl- or aryl-ate complex: considered to generate active radicals by oxidative cleavage of carbon-hetero bond. Specific examples thereof include a borate compound and the like.

(ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group), N-phenyl iminodiacetic acid (which may have a substituent in a phenyl group), and the like.

(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acid (which may have a substituent on a phenyl group) and the like.

(iv) Sulfur-containing compound: compound obtained by substituting nitrogen atoms of the aforementioned amino acetate compound with tin atoms and capable of generating active radicals by the same action as that of the amino acetate compound.

(v) Sulfinates: capable of generating active radicals by oxidation. Specific examples thereof include sodium aryl sulfinate and the like.

Among the electron-donating polymerization initiators, a borate compound is preferable. As the borate compound, a tetraaryl borate compound or a monoalkyltriaryl borate compound is preferable. From the viewpoint of compound stability, a tetraaryl borate compound is more preferable.

A countercation that the borate compound has is preferably an alkali metal ion or a tetraalkyl ammonium ion, and more preferably a sodium ion, a potassium ion, or a tetrabutylammonium ion.

Specific examples of the borate compound include the following compounds. In the following compounds, $X_c^+$ represents a monovalent cation, which is preferably an alkali metal ion or a tetraalkylammonium ion, and more preferably an alkali metal ion or a tetrabutylammonium ion. Bu represents an n-butyl group.

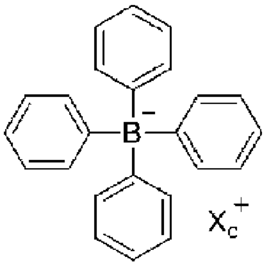
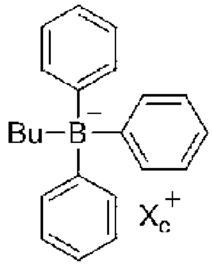
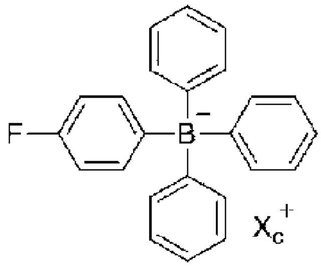
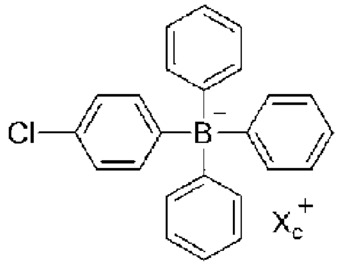

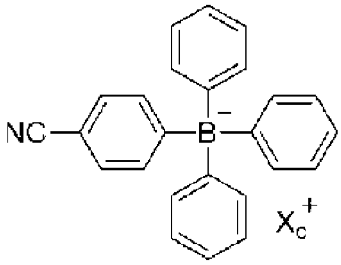
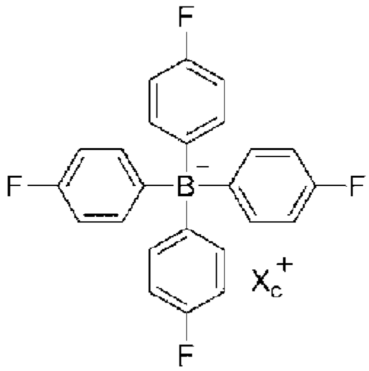
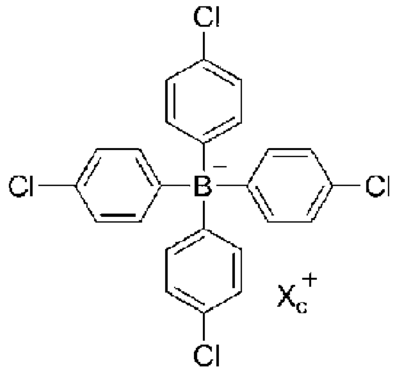

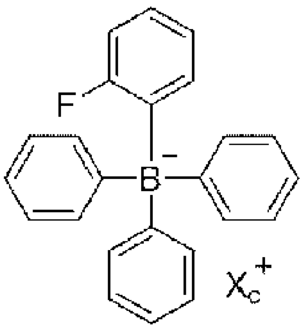
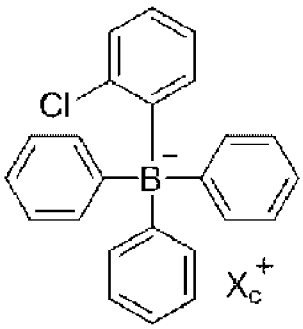
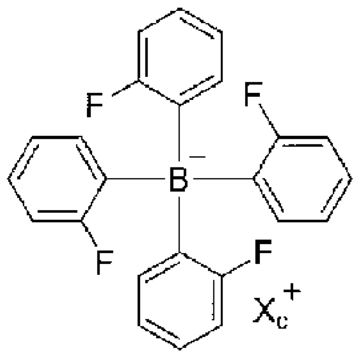

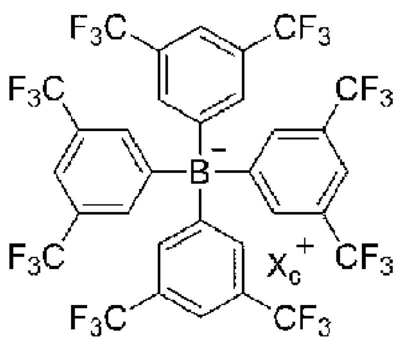

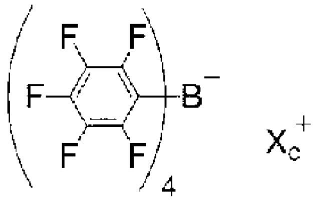
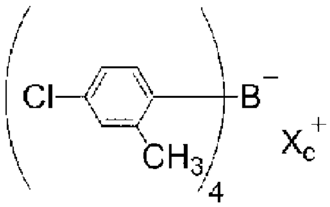
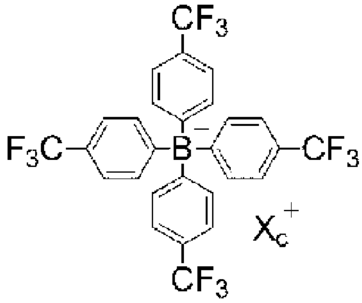
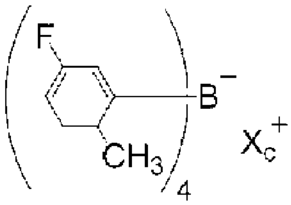
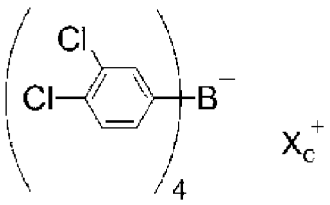
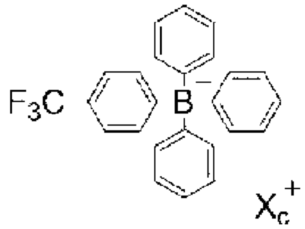
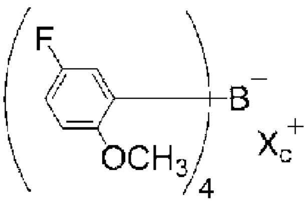
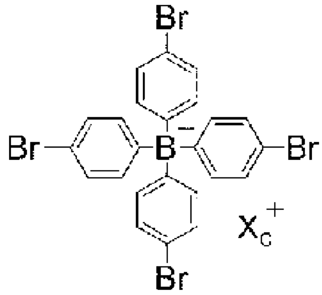
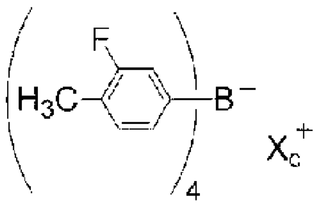
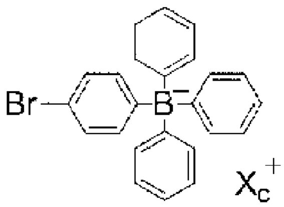
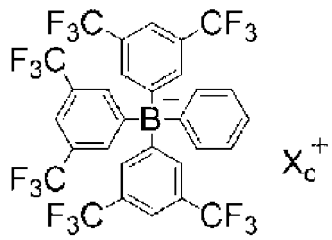
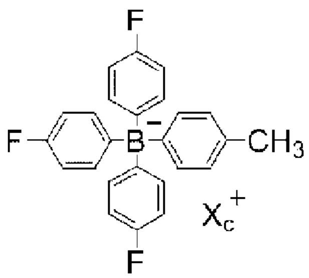
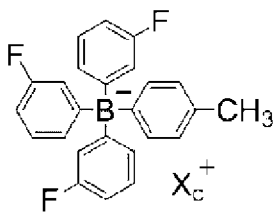
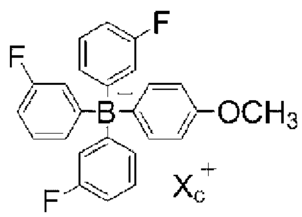
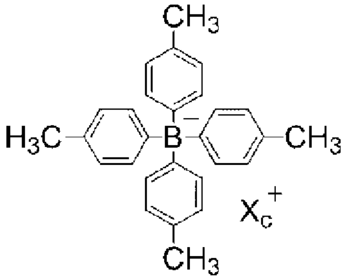
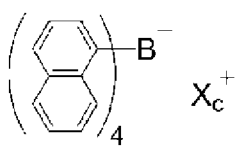
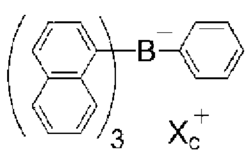

One electron-donating polymerization initiator may be used alone, or two or more electron-donating polymerization initiators may be used in combination.

The content of the electron-donating polymerization initiator with respect to the total solid content of the image-recording layer is preferably 0.01% to 30% by mass, more preferably 0.05% to 25% by mass, and even more preferably 0.1% to 20% by mass.

d) Color forming substance precursor

The image-recording layer contains a color forming substance precursor.

From the viewpoint of color formability, the color forming substance precursor preferably includes an acid color forming agent. In addition, from the viewpoint of color formability, the color forming substance precursor preferably includes a leuco compound.

As a preferred aspect, the color forming substance precursor is preferably an acid generator.

"Color forming substance precursor" used in the present disclosure means a compound that forms or removes color by a stimulus such as light or acid and thus changes the color of the image-recording layer. Furthermore, "acid color forming agent" means a compound that forms or removes color by being heated in a state of accepting an electron accepting compound (for example, a proton of an acid or the like) and thus changes the color of the image-recording layer. The acid color forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron-accepting compound.

From the viewpoint of printing durability, the hydrogen abstraction enthalpy of all hydrogen atoms present in a molecule of the color forming substance precursor is preferably -12.0 kcal/mol or more, more preferably -8.0 kcal/mol or more, even more preferably -6.5 kcal/mol or more, even still more preferably -4.0 kcal/mol or more, and particularly preferably 0.0 kcal/mol or more.

The higher the hydrogen abstraction enthalpy, the further the hydrogen atoms are inhibited from being abstracted from the color forming substance precursor by a polymerization initiating species such as radicals, and the further the polymerization reaction is prolonged. Therefore, curing property is excellent, and printing durability is further improved.

In addition, as a preferred aspect, a hydrogen abstraction enthalpy of all hydrogen atoms present in a molecule of the color forming substance precursor is preferably -2.0 kcal/mol or less.

In the present invention, the hydrogen abstraction enthalpy of all hydrogen atoms present in a molecule of the color forming substance precursor is calculated by the following method.

Regarding a reaction with propagating radicals caused by hydrogen abstraction, the enthalpy of each of the reactant and product is calculated using Gaussian 16 as a calculation program at a calculation level of density functional theory (B3LYP/6-31+G**). The solvent effect (solvent: methanol) is examined by the SCRF method. By finding the difference in the enthalpy between the reactant and the product, a reaction enthalpy is calculated.

More specifically, the hydrogen abstraction enthalpy is calculated as follows. In the following chemical reaction formula, for each of the propagating radical, LeucoDye-H, the hydrogenated propagating radical, and LeucoDye-radical, modeling is carried out using Gaussian pre/post software GaussView6. #p opt b3lyp/6-31+g (d, p) scrf = (solvent = methanol) is specified as a calculation condition, charge 0 multiplicity 2 is set for the radical, and charge 0 multiplicity 1 is set for substances other than the radical. #p is specified for detailed logging output, and may not be specified.

From the energy (unit: hartree) of the structure optimized by performing calculation, the enthalpy of formation of the reactant (sum of the energy of the propagating radical and LeucoDye-H) and the enthalpy of formation of the product (sum of the energy of the hydrogenated propagating radical and LeucoDye-radical) are calculated. The enthalpy of formation of the reactant is subtracted from the enthalpy of formation of the product, and the result is adopted as the hydrogen abstraction enthalpy. The unit is converted as 1 hartree = 627.51 kcal/mol.

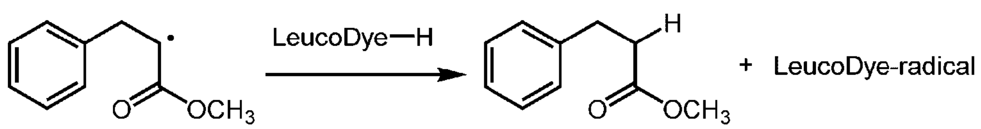


For example, the hydrogen abstraction enthalpy for each hydrogen atom of the following compound is as follows.

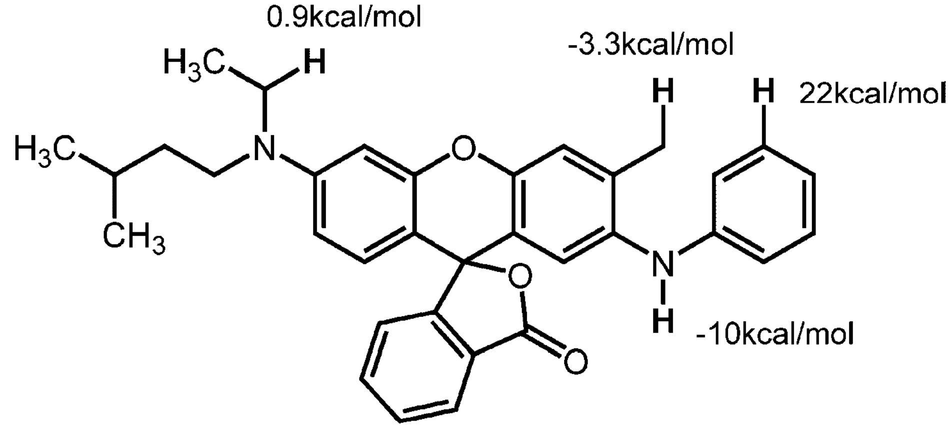


From the viewpoint of printing durability, it is preferable that the color forming substance precursor does not have a structure in which a hydrogen atom is directly bonded to a nitrogen atom.

The structure in which a hydrogen atom is directly bonded to a nitrogen atom (N-H structure) is a structure in which a hydrogen abstraction reaction readily occurs by a radical or the like. In a case where the color forming substance precursor is a compound that does not have such a structure, the hydrogen atom abstraction from the color forming substance precursor is inhibited, and the polymerization reaction is prolonged. Therefore, excellent curing property is obtained, and printing durability is further improved.

The color forming substance precursor preferably has a tertiary amine structure. The tertiary amine structure is an amine structure containing a nitrogen atom in which all atoms directly bonded to the nitrogen atom are not hydrogen atoms. In the tertiary amine structure, an N-H structure is not present.

Particularly, from the viewpoint of color formability, the color forming agent used in the present invention is preferably at least one kind of compound selected from the group consisting of a spiropyran compound, a spirooxazine compound, a spirolactone compound, and a spirolactam compound.

From the viewpoint of visibility, the hue of the colorant after color formment is preferably green, blue, or black.

From the viewpoints of color formability, visibility of exposed portions, and printing durability, the acid color forming agent is preferably a leuco colorant.

The aforementioned leuco colorant is not particularly limited as long as it has a leuco structure. The leuco colorant preferably has a spiro structure, and more preferably has a spirolactone ring structure.

From the viewpoints of color formability, visibility of exposed portions, and printing durability, the leuco colorant is preferably a leuco colorant having a phthalide structure or a fluoran structure.

Furthermore, from the viewpoints of color formability, visibility of exposed portions, and printing durability, the leuco colorant having a phthalide structure or a fluoran structure is preferably a compound represented by any of Formula (Le-1) to Formula (Le-3), and more preferably a compound represented by Formula (Le-2).

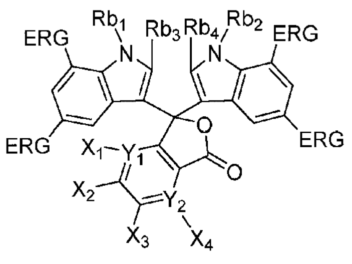
(Le - 1)

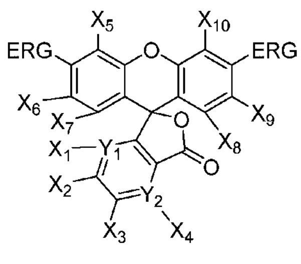
(Le - 2)

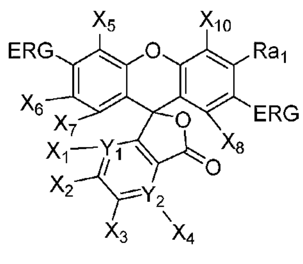
(Le - 3)

In Formula (Le-1) to Formula (Le-3), ERG each independently represent an electron-donating group, to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, Rai represents a hydrogen atom, an alkyl group, or an alkoxy group, and Rbi to $Rb_4$ each independently represent an alkyl group, or an aryl group.

As the electron-donating groups represented by ERG in Formula (Le-1) to Formula (Le-3), from the viewpoints of color formability, visibility of the exposed portion, and printing durability, an amino group, an alkylamino group, an arylamino group, a dialkylamino group, a monoalkyl monoarylamino group, a diarylamino group, an alkoxy group, an

aryloxy group or an alkyl group is preferable, an amino group, alkylamino group, arylamino group, dialkylamino group, monoalkyl monoarylamino group, diarylamino group, alkoxy group, or an aryloxy group is more preferable, an arylamino group or a diarylamino group is even more preferable, and an arylamino group is particularly preferable.

From the viewpoints of color formability, visibility of exposed portions, and UV printing durability, to $X_4$ in Formula (Le-1) to Formula (Le-3) preferably each independently represent a hydrogen atom or a chlorine atom, and more preferably each independently represent a hydrogen atom.

From the viewpoints of color formability, visibility of exposed portions, and UV printing durability, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoints of color formability, visibility of exposed portions, and UV printing durability, it is preferable that at least one of $Y_1$ or $Y_2$ in Formula (Le-1) to Formula (Le-3) be C, and it is more preferable that both of $Y_1$ and $Y_2$ be C.

From the viewpoints of color formability, visibility of exposed portions, and UV printing durability, Rai in Formula (Le-1) to Formula (Le-3) is preferably an alkyl group or an alkoxy group, more preferably an alkoxy group, and particularly preferably a methoxy group.

From the viewpoints of color formability and visibility of exposed portions, Rbi to $Rb_4$ in Formula (Le-1) to Formula (Le-3) preferably each independently represent a hydrogen atom or an alkyl group, more preferably each independently represent an alkyl group, and particularly preferably each independently represent a methyl group.

One of these color forming substance precursors may be used alone, or two or more of these components can be used in combination.

The content of the color forming substance precursor with respect to the total mass of the image-recording layer is preferably 0.5% by mass to 10% by mass, and more preferably 1% by mass to 5% by mass.

The image-recording layer can contain a polymer compound, a chain transfer agent, a low-molecular-weight hydrophilic compound, an oil sensitizing agent, and other components. Details will be described later.

The first lithographic printing plate precursor according to the embodiment of the present invention includes a protective layer.

[Protective layer]

The protective layer has a function of suppressing the reaction inhibiting image formation by blocking oxygen, a function of preventing the damage of the image-recording layer, and a function of preventing ablation during exposure to high-illuminance lasers.

The protective layer having such characteristics is described, for example, in US3458311A and JP1980-49729B (JP-S55-49729B). As polymers with low oxygen permeability that are used in the protective layer, any of water-soluble polymers and water-insoluble polymers can be appropriately selected and used. If necessary, two or more such polymers can be used by being mixed together. Specific examples thereof include a polyvinyl alcohol resin (including polyvinyl alcohol and modified polyvinyl alcohol), polyvinylpyrrolidone, a water-soluble cellulose derivative, poly (meth)acrylonitrile, and the like.

As the polyvinyl alcohol, a polyvinyl alcohol having a saponification degree of 50% or more is suitable. The saponification degree of the polyvinyl alcohol is preferably 60% or more, more preferably 70% or more, and even more preferably 85% or more. The upper limit of the saponification degree is not particularly limited. The saponification degree may be 100% or less.

The saponification degree can be measured according to the method described in JIS K 6726:1994.

As the modified polyvinyl alcohol, acid-modified polyvinyl alcohol having a carboxy group or a sulfo group is preferably used. Specific examples thereof include the modified polyvinyl alcohols described in JP2005-250216A and JP2006-259137A.

Among water-soluble polymers, a polyvinyl alcohol resin is preferable.

(Ultraviolet absorber)

The protective layer includes an ultraviolet absorber.

The ultraviolet absorber has a maximal absorption wavelength ($\lambda$max) in a wavelength range of 280 to 400 nm, and any one of an organic compound, an inorganic compound, or an organic-inorganic hybrid compound, which has a maximal absorption wavelength ($\lambda$max) in a wavelength range of 280 to 400 nm, is preferable.

The maximal absorption wavelength is measured by the following method.

The ultraviolet absorber is dissolved in a good solvent to prepare a 0.1% by mass solution. Using the prepared solution, an ultraviolet-visible absorption spectrum is measured with a spectrophotometer U-3010 (manufactured by Hitachi High-Tech Science Corporation), and a wavelength at which the maximal value of the absorbance is exhibited is defined as the maximal absorption wavelength.

From the viewpoint of ease of adaptability to a layer to be added to the printing plate, the ultraviolet absorber is preferably an organic compound.

One ultraviolet absorber may be used alone, or two or more ultraviolet absorbers may be used in combination.

Examples of a compound suitably used as the ultraviolet absorber include a benzophenone compound, a benzotriazole compound, a triazine compound, and a cyanoacrylate compound. From the viewpoints of ultraviolet absorbability, ease of adaptability to the additive layer, and solubility in the solvent of a coating liquid, a benzophenone compound, a benzotriazole compound, or a triazine compound is more preferable, and a benzotriazole compound is even more preferable.

In the total solid content of the protective layer, the amount of the ultraviolet absorber added is preferably 0.1% to 5% by mass, more preferably 0.5% to 4% by mass, and even more preferably 1% to 3% by mass.

In order to improve oxygen barrier properties, it is preferable that the protective layer contain an inorganic lamellar compound. The inorganic lamellar compound refers to particles in the form of a thin flat plate, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica group, examples of the natural mica include muscovite, soda mica, phlogopite, biotite, and lepidolite. Examples of synthetic mica include non-swelling mica such as fluorophlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite $(Na, Li)Mg_2Li(Si_4O_{10})F_2$, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the mica compounds, fluorine-based swelling mica is particularly useful. That is, swelling synthetic mica has a laminated structure consisting of unit crystal lattice layers having a thickness in a range of approximately 10 to 15Å, and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is the ratio of the major diameter to the thickness of a particle, and it can be measured, for example, from a projection view obtained from the microphotograph of the particle. As the aspect ratio increases, the obtained effect is stronger.

Regarding the particle diameter of the mica compound, the average major diameter thereof is preferably 0.3 to 20 $\mu$m, more preferably 0.5 to 10 $\mu$m, and particularly preferably 1 to 5 $\mu$m. The average thickness of the particles is preferably 0.1 $\mu$m or less, more preferably 0.05 $\mu$m or less, and particularly preferably 0.01 $\mu$m or less. Specifically, for example, in the case of swelling synthetic mica which is a typical compound, an aspect is preferable in which the compound has a thickness of about 1 to 50 nm and a surface size (major diameter) of about 1 to 20 $\mu$m.

The content of the inorganic lamellar compound in the total solid content of the protective layer is preferably 0% to 60% by mass, and more preferably 3% to 50% by mass. Even in a case where two or more inorganic lamellar compounds are used in combination, the total amount of the inorganic lamellar compounds preferable equals the content described above. In a case where the content is within the above range, the oxygen barrier property is improved, and excellent sensitivity is obtained. In addition, the deterioration of receptivity can be prevented.

The protective layer may contain known additives such as a plasticizer for imparting flexibility, a surfactant for improving coating properties, and inorganic fine particles for controlling surface sliding properties. In addition, the oil sensitizing agent described above regarding the image-recording layer may be contained in the protective layer.

The protective layer can be formed by performing coating by a known method, followed by drying. The coating

amount (solid content) of the protective layer after drying is preferably 0.01 to 10 g/$m^2$, more preferably 0.02 to 3 g/$m^2$, and particularly preferably 0.02 to 1 g/$m^2$.

(Second on-press development type lithographic printing plate precursor)

A second lithographic printing plate precursor according to the embodiment of the present invention will be described.

A support is the same as the support in the first on-press development type lithographic printing plate precursor described above.

An image-recording layer in the second lithographic printing plate precursor contains a) a polymerizable compound, b) an infrared absorber, c) a polymerization initiator, and d) a color forming substance precursor.

The a) polymerizable compound, b) infrared absorber, c) polymerization initiator, and d) color forming substance precursor are respectively the a) polymerizable compound and b) infrared absorber, c) polymerization initiator, and d) color forming substance precursor in the image-recording layer of the first lithographic printing plate precursor.

In the second lithographic printing plate precursor, the polymerizable compound has 4 or more functionalities and has a molecular weight of less than 15,000.

In addition, in the second lithographic printing plate precursor, the image-recording layer contains e) an ultraviolet absorber. The ultraviolet absorber is the same as the ultraviolet absorber contained in the protective layer of the first lithographic printing plate precursor.

In the total solid content of the image-recording layer, the amount of the ultraviolet absorber added is preferably 0.1% to 5% by mass, more preferably 0.5% to 4% by mass, and even more preferably 1% to 3% by mass.

The second lithographic printing plate precursor may include a protective layer on the image-recording layer.

Examples of the protective layer include the same protective layer as the protective layer in the first lithographic printing plate precursor. Regarding the second lithographic printing plate precursor, the protective layer may or may not contain an ultraviolet absorber.

(Third on-press development type lithographic printing plate precursor)

A third lithographic printing plate precursor according to the embodiment of the present invention will be described.

A support is the same as the support in the first on-press development type lithographic printing plate precursor described above.

An image-recording layer in the third lithographic printing plate precursor contains a) a polymerizable compound, b) an infrared absorber, c) a polymerization initiator, and d) a color forming substance precursor.

The a) polymerizable compound, b) infrared absorber, c) polymerization initiator, and d) color forming substance precursor are respectively the a) polymerizable compound and b) infrared absorber, c) polymerization initiator, and d) color forming substance precursor in the image-recording layer of the first lithographic printing plate precursor.

A protective layer is the same as the protective layer of the first lithographic printing plate precursor. In the third lithographic printing plate precursor, the protective layer contains an ultraviolet absorber.

In a case where the image-recording layer is exposed to an infrared laser having a wavelength of 830 nm at an energy density of 120 mJ/$cm^2$, a loss of ethylenically unsaturated bonds in an exposed region in the image-recording layer is 10% or more with respect to a loss of ethylenically unsaturated bonds in a non-exposed region in the image-recording layer.

In a case where the image-recording layer is exposed to an infrared laser having a wavelength of 830 nm at an energy density of 120 mJ/$cm^2$, a loss of ethylenically unsaturated bonds in an exposed region in the image-recording layer with respect to a loss of ethylenically unsaturated bonds in a non-exposed region in the image-recording layer (hereinafter, also referred to as "loss of ethylenically unsaturated bonds during exposure to an infrared laser") is measured as follows.

(Loss of ethylenically unsaturated bonds during exposure to infrared laser)

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 120 mJ/$cm^2$. The exposed image includes a solid image and a non-image area.

Next, using a Fourier transform infrared spectrophotometer (FT-IR) "FT-720" manufactured by HORIBA, Ltd., the peak surface area in the vicinity of 1,410 $cm^{-1}$ derived from the ethylenically unsaturated group were determined for the solid image area and the non-image area. Here, the support of each lithographic printing plate is used as a background. In a case where the peak surface area of the solid image area is defined as S1 and the peak surface area of the non-image area is defined as S2, a loss of ethylenically unsaturated bonds R1 [%] is determined by Expression 1.

$$R1 = [1 - (S1/S2)] \times 100 \cdots (1)$$

In a case where the image-recording layer is exposed to an infrared laser having a wavelength of 830 nm at an energy density of 120 mJ/cm$^2$, the upper limit of the loss of ethylenically unsaturated bonds in an exposed region in the image-recording layer with respect to a loss of ethylenically unsaturated bonds in a non-exposed region in the image-recording layer is not particularly limited, but generally 60%, preferably 50%, and more preferably 40%.

The loss of ethylenically unsaturated bonds during exposure to infrared laser is preferably 10% to 40%, more preferably 15% to 35%, and even more preferably 20% to 30%.

In a case where the loss of ethylenically unsaturated bonds is 10% or more, excellent printing durability can be obtained. In addition, in a case where the loss of ethylenically unsaturated bonds is 40% or less, the reproducibility of the image in various images such as halftone dots is improved, which is more preferable.

In a case where the image-recording layer is exposed to an infrared laser having a wavelength of 830 nm at an energy density of 120 mJ/cm$^2$, the loss of ethylenically unsaturated bonds in an exposed region in the image-recording layer with respect to a loss of ethylenically unsaturated bonds in a non-exposed region in the image-recording layer is not particularly limited. However, for example, in a case where the polymerizable compound contained in the image-recording layer is a polymerizable compound having a predetermined number or more functionality, the loss of ethylenically unsaturated bonds can be appropriately adjusted. In addition, the loss of ethylenically unsaturated bonds can be appropriately adjusted by appropriately adjusting the hydrogen abstraction enthalpy of all hydrogens present in the molecule of the color forming substance precursor in the image-recording layer.

The hydrogen abstraction enthalpy of all hydrogens present in the molecule of the color forming substance precursor are as described above.

In a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

In a case where the image-recording layer is exposed to a white fluorescent lamp having an illuminance of 600 Lux for 1 hour, the loss of ethylenically unsaturated bonds in the exposed region with respect to a loss of ethylenically unsaturated bonds in the non-exposed region (hereinafter, also referred to as "loss of ethylenically unsaturated bonds during exposure to a white lamp") is measured as follows.

(Loss of ethylenically unsaturated bonds during exposure to white lamp)

The obtained lithographic printing plate precursor is exposed to a white fluorescent lamp such that the illuminance on the plate surface is 600 Lux. After the exposure for 1 hour, using a Fourier transform infrared spectrophotometer (FT-IR) "FT-720" manufactured by HORIBA, Ltd., the peak surface area in the vicinity of 1,410 cm$^{-1}$ derived from the ethylenically unsaturated group were determined for the exposed portion and the non-exposed portion. Here, the support of each lithographic printing plate is used as a background. In a case where the peak surface area of the exposed portion is defined as S3 and the peak surface area of the non-exposed portion is defined as S4, a loss of ethylenically unsaturated bonds R2 [%] is determined by Expression (2).

$$R2 = [1 - (S3/S4)] \times 100 \cdots (2)$$

In a case where the image-recording layer is exposed to a white fluorescent lamp having an illuminance of 600 Lux for 1 hour, a loss of ethylenically unsaturated bonds in an exposed region in the image-recording layer with respect to a loss of ethylenically unsaturated bonds in a non-exposed region in the image-recording layer is less than 10%, less than 5%, and more preferably less than 3%.

In a case where the image-recording layer is exposed to a white fluorescent lamp having an illuminance of 600 Lux for 1 hour, the lower limit value of the loss of ethylenically unsaturated bonds in an exposed region in the image-recording layer is preferably 0 with respect to a loss of ethylenically unsaturated bonds in a non-exposed region in the image-recording layer. In addition, as a preferred aspect, the lower limit value is generally more than 0.

In a case where the image-recording layer is exposed to a white fluorescent lamp having an illuminance of 600 Lux for 1 hour, the loss of ethylenically unsaturated bonds in the exposed region in the image-recording layer with respect to a loss of ethylenically unsaturated bonds in the non-exposed region in the image-recording layer is not particularly limited. However, for example, in a case where the protective layer contains the ultraviolet absorber in the lithographic printing plate precursor, the loss of ethylenically unsaturated bonds can be appropriately adjusted.

(Fourth on-press development type lithographic printing plate precursor)

A fourth lithographic printing plate precursor according to the embodiment of the present invention will be described.

A support is the same as the support in the first on-press development type lithographic printing plate precursor described above.

An image-recording layer in the fourth lithographic printing plate precursor contains a) a polymerizable compound, b) an infrared absorber, c) a polymerization initiator, and d) a color forming substance precursor.

The a) polymerizable compound, b) infrared absorber, c) polymerization initiator, and d) color forming substance precursor are respectively the a) polymerizable compound and b) infrared absorber, c) polymerization initiator, and d) color forming substance precursor in the image-recording layer of the first lithographic printing plate precursor.

In addition, in the fourth lithographic printing plate precursor, the image-recording layer contains e) an ultraviolet absorber. The ultraviolet absorber is the same as the ultraviolet absorber contained in the protective layer of the first lithographic printing plate precursor.

In the total solid content of the image-recording layer, the amount of the ultraviolet absorber added is preferably 0.1% to 5% by mass, more preferably 0.5% to 4% by mass, and even more preferably 1% to 3% by mass.

The fourth lithographic printing plate precursor may include a protective layer on the image-recording layer.

Examples of the protective layer include the same protective layer as the protective layer in the first lithographic printing plate precursor. Regarding the fourth lithographic printing plate precursor, the protective layer may or may not contain an ultraviolet absorber.

In a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer.

In a case where the image-recording layer is exposed to an infrared laser having a wavelength of 830 nm at an energy density of 120 $mJ/cm^2$, a loss of ethylenically unsaturated bonds in an exposed region in the image-recording layer with respect to a loss of ethylenically unsaturated bonds in a non-exposed region in the image-recording layer is as described in the third on-press development type lithographic printing plate precursor, and the same applies to the preferred range.

In a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

In a case where the image-recording layer is exposed to a white fluorescent lamp having an illuminance of 600 Lux for 1 hour, a loss of ethylenically unsaturated bonds in an exposed region in the image-recording layer with respect to a loss of ethylenically unsaturated bonds in a non-exposed region in the image-recording layer is as described in the third on-press development type lithographic printing plate precursor, and the same applies to the preferred range.

In a case where the image-recording layer is exposed to a white fluorescent lamp having an illuminance of 600 Lux for 1 hour, the loss of ethylenically unsaturated bonds in the exposed region in the image-recording layer with respect to a loss of ethylenically unsaturated bonds in the non-exposed region in the image-recording layer is not particularly limited. However, for example, in a case where the image-recording layer contains the ultraviolet absorber in the lithographic printing plate precursor, the loss of ethylenically unsaturated bonds can be appropriately adjusted.

In the on-press development type lithographic printing plate, the image-recording layer can contain a polymer compound, a chain transfer agent, a low-molecular-weight hydrophilic compound, an oil sensitizing agent, and other components.

(Polymer compound)

The polymer compound may function as a binder polymer of the image-recording layer, or may be present in the image-recording layer as a particle-formed polymer compound (polymer particles).

<Binder polymer>

As the binder polymer, a polymer having film forming properties is preferable, and preferred examples thereof include a (meth)acrylic resin, a polyvinyl acetal resin, a polyurethane resin, and the like.

As the binder polymer used in the image-recording layer, a binder polymer having an alkylene oxide chain is preferable. The binder polymer having an alkylene oxide chain may have a poly(alkylene oxide) moiety on a main chain or side chain. In addition, the binder polymer may be a graft polymer having poly(alkylene oxide) moiety on a side chain or a block copolymer of a block configured with a poly(alkylene oxide) moiety-containing repeating unit and a block

configured with an (alkylene oxide) moiety-free repeating unit.

As a binder polymer having a poly(alkylene oxide) moiety on a main chain, a polyurethane resin is preferable. In a case where the binder polymer has a poly(alkylene oxide) moiety on a side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

As the alkylene oxide, an alkylene oxide having 2 to 6 carbon atoms is preferable, and ethylene oxide or propylene oxide is particularly preferable.

The number of repetitions of alkylene oxide in the poly(alkylene oxide) moiety is preferably 2 to 120, more preferably 2 to 70, and even more preferably 2 to 50.

It is preferable that the number of repetitions of alkylene oxide be 120 or less, because then printing durability deterioration resulting from abrasion and printing durability deterioration resulting from deterioration of ink receiving properties are suppressed.

The poly(alkylene oxide) moiety is preferably contained in the binder polymer as a side chain of the binder polymer in the form of a structure represented by Formula (AO), and more preferably contained in the binder polymer as a side chain of a (meth)acrylic resin in the form of a structure represented by Formula (AO).

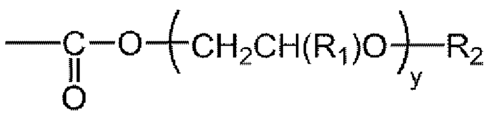

( AO )

In Formula (AO), y represents 2 to 120, $R_1$ represents a hydrogen atom or an alkyl group, and $R_2$ represents a hydrogen atom or a monovalent organic group.

As the monovalent organic group, an alkyl group having 1 to 6 carbon atoms is preferable. Specifically, examples thereof include a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group, and a cyclohexyl group.

In Formula (AO), y is preferably 2 to 70, and more preferably 2 to 50. $R_1$ is preferably a hydrogen atom or a methyl group, and particularly preferably a hydrogen atom. $R_2$ is particularly preferably a hydrogen atom or a methyl group.

In order to enhance the film hardness of an image area, the binder polymer may have crosslinking properties. In order to impart crosslinking properties to the polymer, a crosslinking functional group such as an ethylenically unsaturated bond may be introduced into a main chain or a side chain of the polymer. The crosslinking functional group may be introduced by either copolymerization or a polymer reaction.

Examples of the polymer having an ethylenically unsaturated bond on a main chain of the molecule include poly-1,4-butadiene, poly-1,4-isoprene, and the like.

Examples of the polymer having an ethylenically unsaturated bond on a side chain of the molecule include a polymer of an ester or amide of an acrylic or methacrylic acid in which a residue of the ester or amide (R of -COOR or -CONHR) has an ethylenically unsaturated bond.

Examples of the residue (R described above) having an ethylenically unsaturated bond include $-(CH_2)_nCR^{1A}=CR^{2A}R^{3A}$, $-(CH_2O)_nCH_2CR^{1A}=CR^{2A}R^{3A}$, $-(CH_2CH_2O)_nCH_2CR^{1A}=CR^{2A}R^{3A}$, $-(CH_2)_nNH-CO-O-CH_2CR^{1A}=CR^{2A}R^{3A}$, $-(CH_2)_n-O-CO-CR^{1A}= CR^{2A}R^{3A}$, and $-(CH_2CH_2O)_2-X^A$ (in the formulas, $R^{A1}$ to $R^{A3}$ each independently represent a hydrogen atom, a halogen atom, an alkyl group having 1 to 20 carbon atoms, an aryl group, an alkoxy group, or an aryloxy group, $R^{A1}$ and $R^{A2}$ or $R^{A3}$ may be bonded to each other to form a ring, n represents an integer of 1 to 10, and $X^A$ represents a dicyclopentadienyl residue).

Specific examples of the ester residue include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$, and $-CH_2CH_2O-X$ (in the formula, X represents a dicyclopentadienyl residue).

Specific examples of the amide residue include $-CH_2CH=CH_2$, $-CH_2CH_2-Y$ (in the formula, Y represents a cyclohexene residue), and $-CH_2CH_2-OCO-CH=CH_2$.

For example, free radicals (polymerization initiating radicals or growing radicals in a polymerization process of a polymerizable compound) are added to crosslinking functional groups of the binder polymer having crosslinking properties, the polymers are addition-polymerized directly or via polymerization chains of polymerizable compounds, and crosslinks are formed between the polymer molecules, which cures the binder polymer. Alternatively, atoms in the polymer (for example, hydrogen atoms on carbon atoms adjacent to a functional crosslinking group) are abstracted by free radicals to generate polymer radicals, and the polymer radicals are bonded to each other, which forms crosslinks between the polymer molecules and cure the binder polymer.

From the viewpoint of excellent sensitivity and excellent storage stability, the content of the crosslinkable group

(content of the unsaturated double bond capable of being radically polymerized by iodine titration) in the binder polymer per 1 g of the binder polymer is preferably 0.1 to 10.0 mmol, more preferably 1.0 to 7.0 mmol, and even more preferably 2.0 to 5.5 mmol.

Specific examples 1 to 11 of the binder polymer will be shown below, but the present invention is not limited thereto. In the following exemplary compounds, the numerical value written together with each repeating unit (the numerical value written together with the main chain repeating unit) represents the molar percentage of the repeating unit. The numerical value written together with the repeating unit of the side chain means the number of repetitions of the repeating moiety. In addition, Me represents a methyl group, Et represents an ethyl group, and Ph represents a phenyl group.

(1)

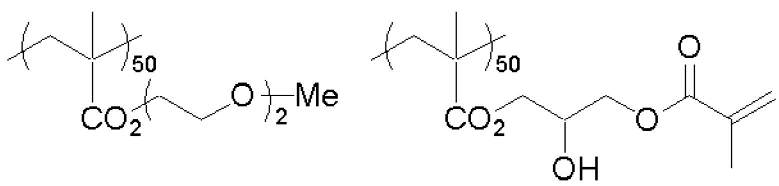

(2)

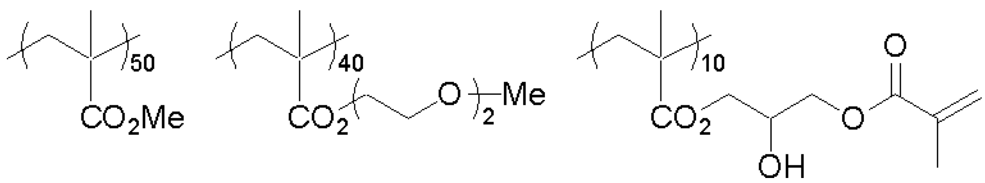

(3)

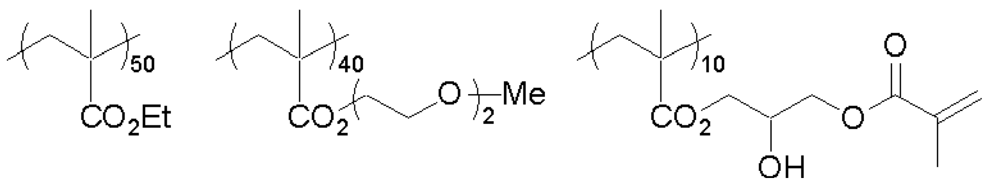

(4)

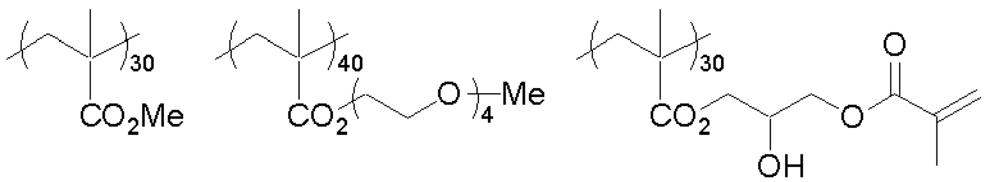

(5)

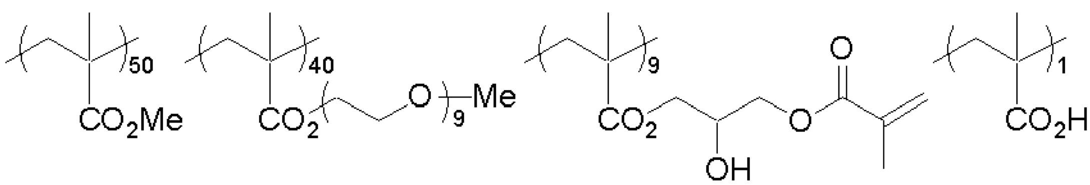

(6)

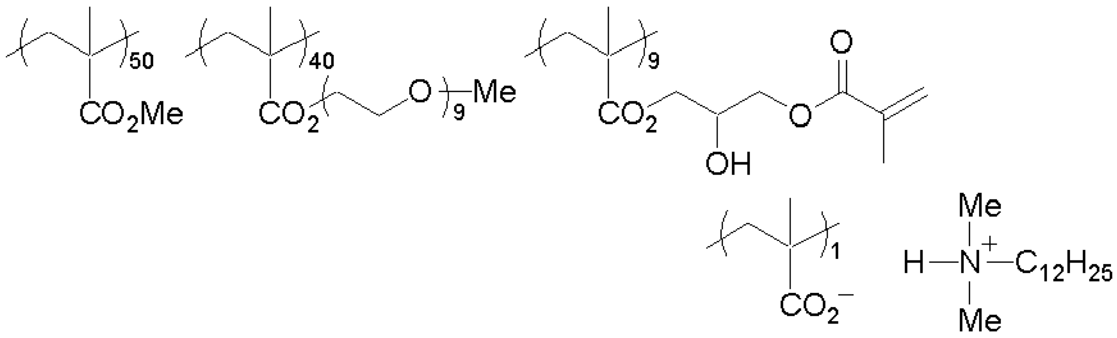

(7)

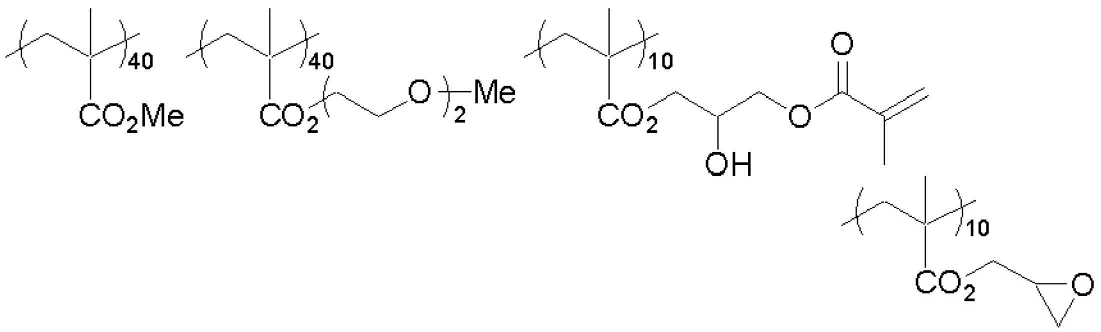

(8)

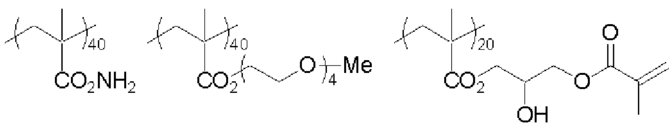

(9)

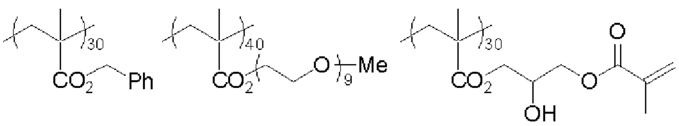

(10)

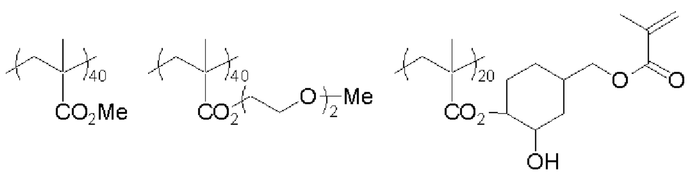

(11)

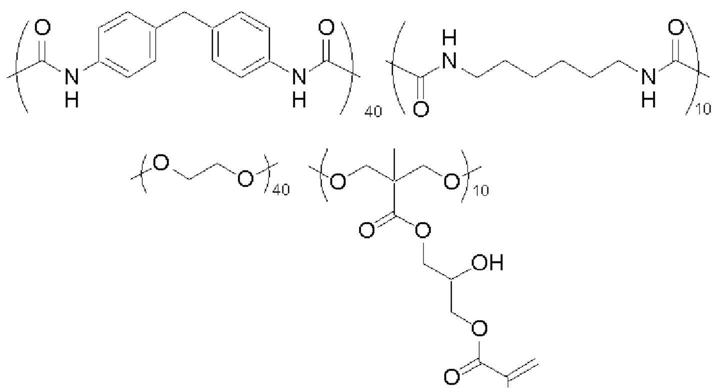

The molecular weight of the binder polymer that is a polystyrene-equivalent mass-average molecular weight (Mw) determined by GPC is preferably 2,000 or more, more preferably 5,000 or more, and even more preferably 10,000 to 300,000.

As necessary, a hydrophilic polymer such as polyacrylic acid or polyvinyl alcohol described in JP2008-195018A can be used in combination. In addition, a lipophilic polymer and a hydrophilic polymer can be used in combination.

One binder polymer may be used alone, or two or more binder polymers may be used in combination.

The content of the binder polymer in the total solid content of the image-recording layer is preferably 1% to 90% by mass, and more preferably 5% to 80% by mass.

<Polymer compound in form of particles (polymer particles)>

It is preferable that the image-recording layer contain polymer particles. The polymer particles contribute to the improvement of on-press developability. The polymer particles are preferably polymer particles that can convert the image-recording layer into hydrophobic when heat is applied thereto. The polymer particles are preferably at least one kind of particles selected from hydrophobic thermoplastic polymer particles, thermal reactive polymer particles, polymer particles having a polymerizable group, microcapsules encapsulating a hydrophobic compound, and a microgel (crosslinked polymer particles).

Suitable examples of the hydrophobic thermoplastic polymer particles include the hydrophobic thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the hydrophobic thermoplastic polymer particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and mixtures of these. For example, copolymers having polystyrene, styrene, and acrylonitrile or polymethyl methacrylate are preferable. The average particle diameter of the hydrophobic thermoplastic polymer particles is preferably 0.01 to 2.0 μm.

Examples of the thermal reactive polymer particles include polymer particles having a thermal reactive group. The polymer particles having a thermal reactive group form a hydrophobic region through crosslinking by a thermal reaction and the accompanying change in functional groups.

As the thermal reactive group in the polymer particles having a thermal reactive group, any functional group performing any reaction may be used as long as a chemical bond is formed. As the thermal reactive group, a polymerizable group is preferable. Suitable examples of the thermal reactive group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanate group or a blocked isocyanate group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating all or some of the constituent components of the image-recording layer as described in JP2001-277740A and JP2001-277742A. The constituent components of the image-recording layer can also be incorporated into the exterior of the microcapsules. In a preferred aspect of the

image-recording layer containing microcapsules, hydrophobic constituent components are encapsulated in the microcapsules and hydrophilic constituent components are incorporated into the exterior of the microcapsules.

The microgel (crosslinked polymer particles) can contain some of the constituent components of the image-recording layer, in at least one of the interior or the surface of the microgel. Particularly, from the viewpoint of sensitivity in image formation and printing durability, an aspect is preferable in which a radically polymerizable group is incorporated into the surface thereof to form a reactive microgel.

In order to encapsulate the constituent components of the image-recording layer in microcapsules or microgel, known methods can be used.

An average particle diameter of the microcapsules or microgels is preferably 0.01 to 3.0 μm, more preferably 0.05 to 2.0 μm, and particularly preferably 0.10 to 1.0 μm. In a case where the average particle diameter is in this range, excellent resolution and temporal stability are obtained.

One kind of polymer particles may be used alone, or two or more kinds of polymer particles may be used in combination.

The content of the polymer particles in the total solid content of the image-recording layer is preferably 5% to 90% by mass, more preferably 5% to 80% by mass, and even more preferably 10% to 75% by mass.

As a preferred aspect, the polymer particles have a hydrophobic main chain, and includes both

i) a constituent unit having a pendant cyano group directly bonded to the hydrophobic main chain, and
ii) a constituent unit having a pendant group that contains a hydrophilic poly(alkylene oxide) segment.

Preferred examples of the hydrophobic main chain include an acrylic resin chain.

Preferred examples of the pendant cyano group include $-[CH_2CH(C{\equiv}N)-]$ or $-[CH_2C(CH_3)(C{\equiv}N)-]$.

In addition, the constituent unit having the pendant cyano group can be easily derived from an ethylenically unsaturated monomer, for example, acrylonitrile or methacrylonitrile, or a combination of these.

Furthermore, as an alkylene oxide in the hydrophilic poly(alkylene oxide) segment, ethylene oxide or a propylene oxide is preferable, and ethylene oxide is more preferable.

The number of repeating alkylene oxide structures in the hydrophilic poly(alkylene oxide) segment is preferably 10 to 100, more preferably 25 to 75, and even more preferably 40 to 50.

As the resin particles having a hydrophobic main chain and including both i) constituent unit having the pendant cyano group directly bonded to the hydrophobic main chain and ii) constituent unit having a pendant group including the hydrophilic poly(alkylene oxide) segment, for example, the particles described in paragraphs "0039" to "0068" of JP2008-503365A are preferable.

As a preferred aspect, the polymer particles are preferably obtained by a reaction of a polyvalent isocyanate compound that is an adduct of a polyhydric phenol compound having two or more hydroxy groups in a molecule and isophorone diisocyanate, with a compound having active hydrogen.

The average particle diameter of the polymer particles is preferably in a range of 0.01 to 3.0 μm, more preferably in a range of 0.05 to 2.0 μm, and particularly preferably in a range of 0.10 to 1.0 μm. In a case where the average particle diameter is in this range, excellent resolution and temporal stability are obtained.

One kind of polymer particles may be used alone, or two or more kinds of polymer particles may be used in combination.

The content of the polymer particles in the total solid content of the image-recording layer is preferably 5% to 90% by mass, more preferably 5% to 80% by mass, and even more preferably 10% to 75% by mass.

As the polymer compound contained in the image-recording layer, a polymer compound containing a constitutional unit derived from a styrene compound and/or a constitutional unit derived from an acrylonitrile compound is also preferable. From the viewpoint of contribution to on-press developability, this polymer compound can be suitably used as a binder polymer or as polymer particles.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, styrene is preferable.

Examples of the acrylonitrile compound include acrylonitrile, methacrylonitrile, and the like. Among these, acrylonitrile is preferable.

In the polymer compound containing a styrene compound and an acrylonitrile compound as constitutional units, a compositional ratio between the constitutional unit derived from the styrene compound and the constitutional unit derived from the acrylonitrile compound is preferably 4:1 to 1:4.

(Chain transfer agent)

The chain transfer agent contributes to the improvement of printing durability of the lithographic printing plate prepared from the lithographic printing plate precursor.

As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

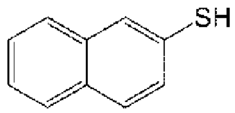
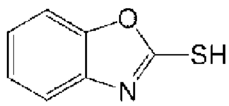
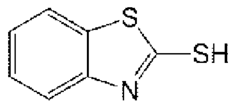
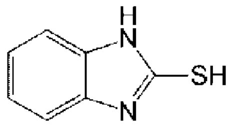
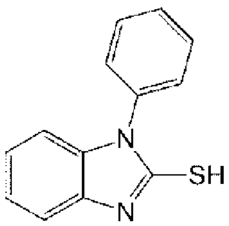
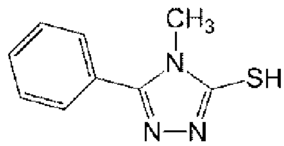
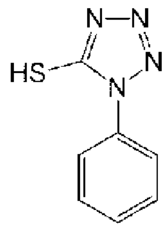
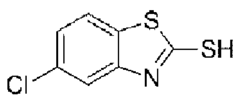
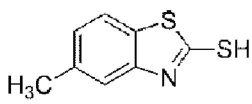
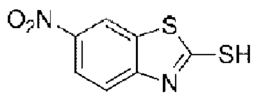
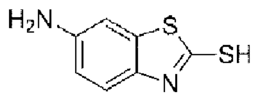
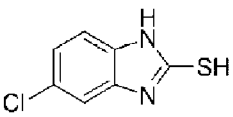
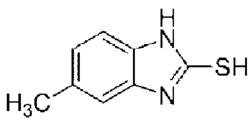
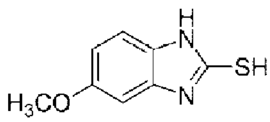
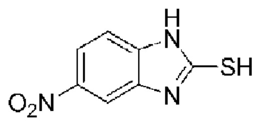
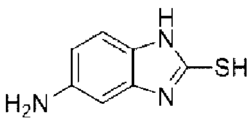
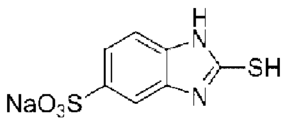
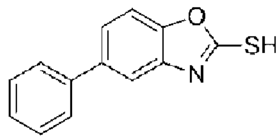
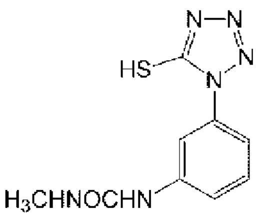
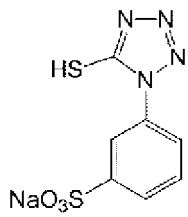

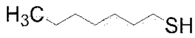
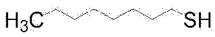
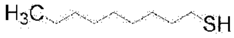
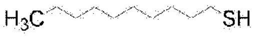
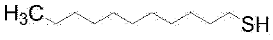
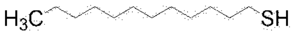
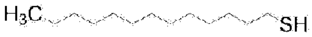
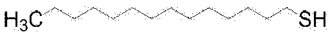
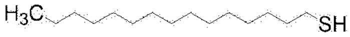
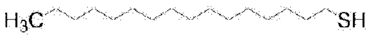
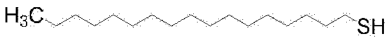
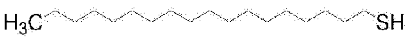
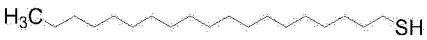
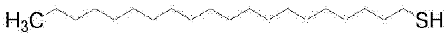
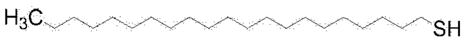
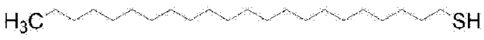
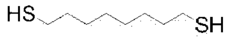
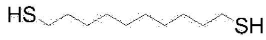
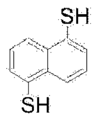
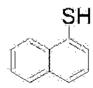
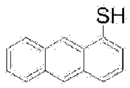
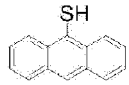
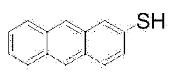
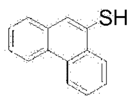
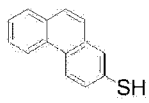
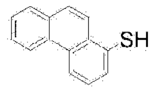
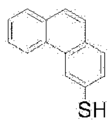
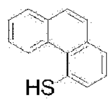

One chain transfer agent may be used alone, or two or more chain transfer agents may be used in combination.
The content of the chain transfer agent in the total solid content of the image-recording layer is preferably 0.01% to 50% by mass, more preferably 0.05% to 40% by mass, and even more preferably 0.1% to 30% by mass.

(Low-molecular-weight hydrophilic compound)

The low-molecular-weight hydrophilic compound contributes to the improvement of on-press developability of the lithographic printing plate precursor without deteriorating printing durability of the lithographic printing plate prepared from the lithographic printing plate precursor. The low-molecular-weight hydrophilic compound is preferably a compound having a molecular weight less than 1,000, more preferably a compound having a molecular weight less than 800, and even more preferably a compound having a molecular weight less than 500.
Examples of the low-molecular-weight hydrophilic compound include water-soluble organic compounds including glycols such as ethylene glycol, diethylene glycol, triethylene glycol, propylene glycol, dipropylene glycol, and tripropylene glycol, ether or ester derivatives of these glycols, polyols such as glycerin, pentaerythritol, and tris(2-hydroxyethyl)isocyanurate, organic amines and salts thereof such as triethanolamine, diethanolamine, and monoethanolamine, organic sulfonic acids and salts thereof such as alkyl sulfonate, toluene sulfonate, and benzene sulfonate, organic sulfamic acids and salts thereof such as alkylsulfamate, organic sulfuric acids and salts thereof such as alkyl sulfate and alkyl ether sulfate, organic phosphonic acids and salts thereof such as phenyl phosphate, organic carboxylic acids and salts thereof such as tartaric acid, oxalic acid, citric acid, malic acid, lactic acid, gluconic acid, and amino acid, betaines, and the like.
As the low-molecular-weight hydrophilic compound, at least one compound selected from polyols, organic sulfates, organic sulfonates, and betaines is preferable.
As the low-molecular-weight hydrophilic compound, it is possible to use the compound described in [0145] to [0147] of WO2020/137919A.
The low-molecular-weight hydrophilic compound has a hydrophobic portion with a small structure and substantially does not have a surface activation action. Therefore, this compound prevents dampening water from permeating the exposed portion of the image-recording layer (image area) and deteriorating hydrophobicity or film hardness of the image area. Accordingly, the image-recording layer can maintain excellent ink receiving properties and printing durability.
One low-molecular-weight hydrophilic compound may be used alone, or two or more low-molecular-weight hydrophilic compounds may be used in combination.
The content of the low-molecular-weight hydrophilic compound in the total solid content of the image-recording layer is preferably 0.5% to 20% by mass, more preferably 1% to 15% by mass, and even more preferably 2% to 10% by mass.

(Oil sensitizing agent)

The oil sensitizing agent contributes to the improvement of ink receptivity (hereinafter, also simply called "receptivity") of the lithographic printing plate prepared from the lithographic printing plate precursor. Examples of the oil sensitizing agent include a phosphonium compound, a nitrogen-containing low-molecular-weight compound, an ammonium group-containing polymer, and the like. Particularly, in a case where the lithographic printing plate precursor has a protective layer containing an inorganic lamellar compound, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

As the oil sensitizing agent, it is possible to use the compound described in [0151] to [0155] of WO2020/137919A.

The content of the oil sensitizing agent in the total solid content of the image-recording layer is preferably 0.01% to 30% by mass, more preferably 0.1% to 15% by mass, and even more preferably 1% to 10% by mass.

(Other components)

As other components, a surfactant, a printing-out agent, a polymerization inhibitor, a higher fatty acid derivative, a plasticizer, inorganic particles, an inorganic lamellar compound, and the like can be contained in the image-recording layer. Specifically, the above components described in paragraphs "0114" to "0159" of JP2008-284817A can be used.

The content of the polymer compound having a weight-average molecular weight more than 15,000, which is not particle-shaped, with respect to the total solid content of the image-recording layer is preferably 5% by mass or less and more preferably 4% by mass or less.

(Formation of image-recording layer)

The image-recording layer can be formed, for example, by preparing a coating liquid by appropriately dispersing or dissolving the necessary components described above in a known solvent, performing coating with the coating liquid by a known method such as bar coating, and drying the coating liquid, as described in paragraphs "0142" and "0143" of JP2008-195018A. The coating amount (solid content) of the image-recording layer after coating and drying varies with uses. However, from the viewpoint of obtaining excellent sensitivity and excellent film characteristics of the image-recording layer, the coating amount is preferably about 0.3 to 3.0 g/m$^2$.

From the viewpoint of imparting on-press developability, the image-recording layer preferably has water solubility or water-dispersibility. Here, the "water soluble" means that 0.1 g or more of compound is dissolved in 100 g of water at 20°C, and the "water-dispersible" means that the compound is uniformly dispersed in water at 20°C.

The on-press development type lithographic printing plate precursor can have an undercoat layer (also called interlayer in some cases) between the image-recording layer and the support.

The on-press development type lithographic printing plate precursor may or may not include a protective layer on the image-recording layer. The protective layer is as described above.

[Undercoat layer]

The undercoat layer enhances the adhesion between the support and the image-recording layer in an exposed portion, and enables the image-recording layer to be easily peeled from the support in a non-exposed portion. Therefore, the undercoat layer contributes to the improvement of developability without deteriorating printing durability. In addition, in the case of exposure to an infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, polymers having adsorbent groups and hydrophilic groups plus crosslinkable groups are preferable. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinkable group is preferable.

As the adsorbent group that can be adsorbed onto the surface of the support, a phenolic hydroxy group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinkable groups, an acryloyl

group, a methacryloyl group, an acrylamide group, a methacrylamide group, an allyl group, and the like are preferable.

The polymer may have a crosslinkable group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinkable groups (preferably ethylenically unsaturated bond groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinkable groups described in JP2005-125749A and JP2006-188038A are more preferable.

The content of ethylenically unsaturated bond group in the polymer used in the undercoat layer is preferably 0.1 to 10.0 mmol per gram of the polymer, and more preferably 0.2 to 5.5 mmol per gram of the polymer.

The mass-average molecular weight (Mw) of the polymer used in the undercoat layer is preferably 5,000 or more, and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer can be formed by coating by a known method, followed by drying. The coating amount (solid content) of the undercoat layer after drying is preferably 0.1 to 100 mg/$m^2$, and more preferably 1 to 30 mg/$m^2$.

The on-press development type lithographic printing plate precursor according to an embodiment of the present invention may have a shear droop shape at end parts.

Fig. 3 is a schematic view showing a cross-sectional shape of an end part of a lithographic printing plate precursor.

In Fig. 3, a lithographic printing plate precursor 1 has a shear droop 2 at an end part thereof. A distance X between the upper edge of an edge surface 1c of the lithographic printing plate precursor 1 (boundary point between the shear droop 2 and the edge surface 1c) and an intersection between an extension line of the edge surface 1c and an extension line of an image-recording layer surface (protective layer surface in a case where a protective layer is formed) 1a is called "shear droop amount X". A distance Y between a point at which the image-recording layer surface 1a of the lithographic printing plate precursor 1 begins to be beveled and the aforementioned intersection is called "shear droop width Y".

In the shear droop shape of the end part, the shear droop amount X is preferably 25 μm or more, more preferably 35 μm or more, and even more preferably 40 μm or more. From the viewpoint of preventing on-press developability deterioration resulting from the deterioration of surface condition of the end part, the upper limit of the shear droop amount X is preferably 150 μm. In a case where on-press developability deteriorates, ink adheres to the residual image-recording layer, which sometimes leads to the occurrence of edge contamination. In a case where the shear droop amount X is too small, the ink having adhered to the end part is likely to be transferred to a blanket, which sometimes leads to the occurrence of edge contamination. In a case where the shear droop amount X is in a range of 25 to 150 μm, and the shear droop width Y is small, the occurrence of cracks at the end part increases, and the printing ink is accumulated in the cracks, which sometimes leads to edge contamination. In this respect, the shear droop width Y is preferably in a range of 70 to 300 μm, and more preferably in a range of 80 to 250 μm. It should be noted that the ranges of the shear droop amount and shear droop width are not involved in the edge shape of a support surface 1b of the lithographic printing plate precursor 1.

Usually, at the end part of the lithographic printing plate precursor 1, the shear droop occurs in a boundary B between the image-recording layer and the support and in the support surface 1b as in the image-recording layer surface 1a.

The end part having the shear droop shape can be formed, for example, by adjusting the cutting conditions of the lithographic printing plate precursor.

Specifically, the end part having the shear droop can be formed by adjusting the gap between an upper cutting blade and a lower cutting blade in a slitter device used for cutting the lithographic printing plate precursor, intrusion amounts of the blades, tip angle of the blades, and the like.

Fig. 4 is a conceptual view showing an example of a cutting portion of a slitter device. In the slitter device, a

pair of upper and lower cutting blades 10 and 20 are vertically disposed. The cutting blades 10 and 20 consist of round blades on a disk. Upper cutting blades 10a and 10b are coaxially supported by a rotary shaft 11, and lower cutting blades 20a and 20b are coaxially supported by a rotary shaft 21. The upper cutting blades 10a and 10b and the lower cutting blades 20a and 20b rotate in opposite directions. A lithographic printing plate precursor 30 is passed between the upper cutting blades 10a and 10b and the lower cutting blades 20a and 20b and is cut in a predetermined width. By adjusting the gap between the upper cutting blade 10a and the lower cutting blade 20a and the gap between the upper cutting blade 10b and the lower cutting blade 20b of the cutting portion of the slitter device, it is possible to form an end part having a shear droop shape.

It is preferable that an ink repellent is provided on a part or all of two opposing lateral surfaces of the lithographic printing plate precursor. By coating a part or all of the two opposing lateral surfaces of the end parts having a shear droop shape with an ink repellent, it is possible to inhibit the edge part from undergoing edge contamination. The ink repellent is not particularly limited as long as it can repel ink, and for example, a hydrophilizing agent or an oil desensitizing liquid can be used as the ink repellent. Hereinafter, the material used as the ink repellent will be described.

(Hydrophilizing agent)

Examples of one of suitable aspects of the hydrophilic agent include a phosphoric acid compound. The phosphoric acid compound includes a phosphoric acid, a salt thereof, an ester thereof, and the like. Examples thereof include phosphoric acid, metaphosphoric acid, ammonium monophosphate, ammonium diphosphate, sodium dihydrogen phosphate, sodium monohydrogen phosphate, potassium monophosphate, potassium diphosphate, sodium tripolyphosphate, potassium pyrophosphate, and sodium hexametaphosphate. Among these, sodium dihydrogen phosphate, sodium monohydrogen phosphate, or sodium hexametaphosphate is preferable.

As the phosphoric acid compound, a polymer compound is preferable, and a polymer compound having a phosphoric acid ester group is more preferable. Examples of the polymer compound having a phosphoric acid ester group include a polymer consisting of one or more monomers having a phosphoric acid ester group in the molecule, a copolymer of one or more monomers that have a phosphoric acid ester group and one or more monomers that do not have a phosphoric acid ester group, a polymer obtained by introducing a phosphoric acid ester group into a polymer having no phosphoric acid ester group by a polymer reaction, and the like.

In the polymer compound having a phosphoric acid ester group, the content of the repeating unit having a phosphoric acid ester group with respect to all the repeating units of the polymer compound is preferably 1 to 100 mol%, more preferably 5 to 100 mol%, and even more preferably 10 to 100 mol%. The mass-average molecular weight of the polymer compound having a phosphoric acid ester group is preferably 5,000 to 1,000,000, more preferably 7,000 to 700,000, and even more preferably 10,000 to 500,000.

Examples of one of suitable aspects of the hydrophilic agent include a phosphonic acid compound. The phosphonic acid compound includes a phosphonic acid, a salt thereof, an ester, thereof, and the like. Examples thereof include ethyl phosphonic acid, propyl phosphonic acid, isopropyl phosphonic acid, butyl phosphonic acid, hexyl phosphonic acid, octyl phosphonic acid, dodecyl phosphonic acid, octadecyl phosphonic acid, 2-hydroxyethyl phosphonic acid, sodium or potassium salts thereof, methyl methylphosphonic acid, ethyl methylphosphonic acid, alkyl phosphonic acid monoalkyl ester such as methyl 2-hydroxyethylphosphonate and sodium salts or potassium salts thereof, alkylene diphosphonic acids such as methylene diphosphonic acid and ethylene diphosphonic acid, and polyvinylphosphonic acid.

Examples of one of suitable aspects of the hydrophilic agent include a water-soluble resin. Examples of the water-soluble resin include water-soluble resins classified as polysaccharides, polyvinyl alcohol, polyvinylpyrrolidone, polyacrylamide and a copolymer thereof, a vinyl methyl ether/maleic acid anhydride copolymer, a vinyl acetate/maleic acid anhydride copolymer, and a styrene/maleic acid anhydride copolymer. Examples of the polysaccharides include starch derivatives (such as dextrin, enzymolysis dextrin, hydroxypropylated starch, carboxymethylated starch, phosphoric acid esterified starch, polyoxyalkylene grafted starch, and cyclodextrin), celluloses (such as carboxymethyl cellulose, carboxyethyl cellulose, methyl cellulose, hydroxypropyl cellulose, and methylpropyl cellulose), carrageenan, alginic acid, guar gum, locust bean gum, xanthan gum, gum arabic, and soybean polysaccharides. As the water-soluble resin, a starch derivative such as dextrin or polyoxyalkylene grafted starch, gum Arabic, carboxymethyl cellulose, or soybean polysaccharides are preferable.

Examples of one of suitable aspects of the hydrophilic agent include an anionic surfactant and a nonionic surfactant. Examples of the anionic surfactant include those described in No. [0022] of JP2014-104631A, and what are described in the paragraph are incorporated into the specification of the present application. As the anionic surfactant, dialkylsulfosuccinates, alkyl sulfuric acid ester salts, polyoxyethylene aryl ether sulfuric acid ester salts, or alkylnaphthalene sulfonates are preferable. As the anionic surfactant, an anionic surfactant represented by General Formula (I-A) or General Formula (I-B) is preferable.

$$(R^1)_p - Ar^1 - (SO_3^{\ominus})_q \ M_1^{\oplus} \qquad \text{(I-A)}$$

$$(R^2)_m - Ar^2 - Y{-}O(R^3O)_n{-}SO_3^{\ominus} \ M_2^{\oplus} \qquad \text{(I-B)}$$

In General Formula (I-A), $R^1$ represents a linear or branched alkyl group having 1 to 20 carbon atoms, p represents 0, 1, or 2, $Ar^1$ represents an aryl group having 6 to 10 carbon atoms, q represents 1, 2, or 3, and $M_1^+$ represents $Na^+$, $K^+$, $Li^+$, or $NH_4^+$. In a case where p is 2, a plurality of $R^1$'s may be the same as or different from each other.

In General Formula (I-B), $R^2$ represents a linear or branched alkyl group having 1 to 20 carbon atoms, m represents 0, 1, or 2, $Ar^2$ represents an aryl group having 6 to 10 carbon atoms, Y represents a single bond or an alkylene group having 1 to 10 carbon atoms, $R^3$ represents a linear or branched alkylene group having 1 to 5 carbon atoms, n represents an integer of 1 to 100, and $M_2^+$ represents $Na^+$, $K^+$, $Li^+$, or $NH_4^+$. In a case where m is 2, a plurality of $R^2$'s may be the same as or different from each other. In a case where n is 2 or more, a plurality of $R^3$'s may be the same as or different from each other.

In General Formula (I-A) and General Formula (I-B), $R^1$ and $R^2$ are preferably $CH_3$, $C_2H_5$, $C_3H_7$, or $C_4H_9$. $R^3$ is preferably $-CH_2-$, $-CH_2CH_2-$, $-CH_2CH_2CH_2-$, or $-CH_2CH(CH_3)-$, and more preferably $-CH_2CH_2-$. p and m are preferably 0 or 1, and p is more preferably 0. Y is preferably a single bond. n is preferably an integer of 1 to 20.

Examples of the nonionic surfactant include those described in paragraph [0031] of JP2014-104631A, and what are described in the paragraph are incorporated into the specification of the present application. As the nonionic surfactant, polyoxyethylene aryl ethers and polyoxyethylene-polyoxypropylene block copolymers are preferable.

As the nonionic surfactant, a nonionic surfactant represented by General Formula (II-A) is preferable.

$$(R^4)_s{-}Ar^3{-}O(CH_2CH_2O)_t(CH_2CH(CH_3)O)_uH \qquad \text{(II - A)}$$

In General Formula (II-A), $R^4$ represents a hydrogen atom or an alkyl group having 1 to 20 carbon atoms, s represents 0, 1, or 2, $Ar^3$ represents an aryl group having 6 to 10 carbon atoms, t and u each represent an integer of 0 to 100, and t and u do not simultaneously represent 0. In a case where s is 2, a plurality of R4's may be the same as or different from each other.

Organic fine resin particles (for example, a microgel) may be used as the hydrophilic agent. The microgel is reactive or non-reactive resin particles dispersed in an aqueous medium. It is preferable that the microgel have a polymerizable group in the particles or on the particle surface.

The coating liquid containing a hydrophilic agent is preferably in the form of an aqueous solution obtained by dissolving or dispersing a hydrophilic agent in a medium mainly consisting of water. The content of the hydrophilic agent in the coating liquid containing a hydrophilic agent is preferably 0.05% to 50% by mass, and more preferably 0.1% to 30% by mass. The viscosity of the coating liquid containing a hydrophilic agent at 25°C is preferably 0.5 to 1,000 mPa s, and more preferably 1 to 100 mPa s. The surface tension of the coating liquid containing a hydrophilic agent at 25°C is preferably 25 to 70 mN/m, and more preferably 40 to 65 mN/m.

The coating liquid containing a hydrophilic agent may contain an organic solvent, a plasticizing agent, a preservative, an antifoaming agent, and an inorganic salt such as a nitrate or a sulfate, in addition to the hydrophilic agent.

(Oil desensitizing liquid)

Examples of the oil desensitizing liquid include an aqueous solution containing at least one of a hydrophilic organic polymer compound, hexametaphosphoric acid and a salt thereof, or phytic acid and a salt thereof. Specific examples of the hydrophilic organic polymer compound include gum arabic, dextrins, an alginate such as sodium alginate, water-soluble cellulose such as carboxymethyl cellulose, hydroxyethyl cellulose, or hydroxypropylmethyl cellulose, polyvinyl alcohol, polyvinylpyrrolidone, polyacrylamide, a water-soluble copolymer having an acrylamide unit, polyacrylic acid, a copolymer having an acrylic acid unit, polyacrylic acid, a copolymer having an acrylic acid unit, polymethacrylic acid, a copolymer containing a methacrylic acid unit, a copolymer of vinyl methyl ether and maleic acid anhydride, a copolymer of vinyl acetate and maleic acid anhydride, and phosphoric acid-modified starch. Among these, gum arabic is preferable in terms of a strong oil desensitizing effect. As necessary, two or more hydrophilic polymer compounds described above can be used in combination. The compounds are used at a concentration of about 1% to 40% by weight, and more preferably used at a concentration of about 3% to 30% by weight.

Specific examples of the hexametaphosphate include a hexametaphosphate alkali metal salt or an ammonium salt. Examples of the hexametaphosphate alkali metal salt or ammonium salt include sodium hexametaphosphate,

potassium hexametaphosphate, ammonium hexametaphosphate, and the like. Specific examples of phytic acid or a salt thereof include alkali metal salts such as a sodium salt, a potassium salt, and a lithium salt, an ammonium salt, an amine salt, and the like. Examples of the amine salt include salts of diethylamine, triethylamine, n-propylamine, di-n-propylamine, tri-n-propylamine, n-butylamine, n-amylamine, n-hexylamine, laurylamine, ethylenediamine, trimethylenediamine, tetramethylenediamine, pentamethylenediamine, hexamethylenediamine, ethanolamine, diethanolamine, triethanolamine, allylamine, aniline, and the like. The phytic acid salt may be any of a normal salt in which all the hydrogens of 12 acids are substituted or a hydrogen salt (acidic salt) in which some of the hydrogens of the acids are substituted. It is possible to use both a phytic acid salt in the form of a simple salt consisting of a salt of one base and a phytic acid salt in the form of a double salt containing two or more bases as components. Each of these compounds can be used alone, or two or more of these compounds can be used in combination.

It is preferable to additionally incorporate a metal salt of a strong acid into the oil desensitizing liquid used in the present embodiment. In a case where such a metal salt is incorporated into the oil desensitizing liquid, oil desensitizing action can be enhanced. Specific examples of the metal salt of a strong acid include a sodium salt, a potassium salt, a magnesium salt, a calcium salt, and a zinc salt of nitric acid, a sodium salt, a potassium salt, a magnesium salt, a calcium salt, and a zinc salt of sulfuric acid, a sodium salt, a potassium salt, a magnesium salt, a calcium salt, and a zinc salt of chromic acid, sodium fluoride, potassium fluoride, and the like. Two or more of these metal salts of a strong acid can be used in combination, and the amount thereof is preferably about 0.01% to 5% by weight based on the total weight of the oil desensitizing liquid. The pH of the oil desensitizing liquid used in the present invention is adjusted to fall in an acidic range. The pH is more preferably adjusted to 1 to 5, and most preferably adjusted to 1.5 to 4.5. Therefore, in a case where the pH of a water phase is not acidic, an acid is further added to the water phase. Examples of the acid added as such pH adjuster include mineral acids such as phosphoric acid, sulfuric acid, and nitric acid. Examples thereof include organic acids such as citric acid, tannic acid, malic acid, glacial acetic acid, lactic acid, oxalic acid, p-toluenesulfonic acid, and organic phosphonic acid. Among these, phosphoric acid is particularly excellent because it functions not only as a pH adjuster but also as an oil desensitizing action enhancer. It is preferable to incorporate the phosphoric acid into the oil desensitizing liquid such that the amount thereof with respect to the total weight of the oil desensitizing liquid is in a range of 0.01% to 20% by weight, and most preferably in a range of 0.1% to 10% by weight.

It is preferable that the oil desensitizing liquid used in the present embodiment contains a wetting agent and/or a surfactant. In this manner, the coating properties of the oil desensitizing liquid can be improved. Specifically, a lower polyhydric alcohol is preferable as the wetting agent. Examples thereof include ethylene glycol, diethylene glycol, triethylene glycol, propylene glycol, butylene glycol, pentanediol, hexylene glycol, tetraethylene glycol, polyethylene glycol, dipropylene glycol, tripropylene glycol, glycerin, sorbitol, pentaerythritol, and the like. Among these, glycerin is particularly preferable. As the surfactant, for example, it is possible to use a nonionic surfactant such as polyoxyethylene alkylphenyl ether or a polyoxyethylene/polyoxypropylene block copolymer, an anionic surfactant such as fatty acid salts, alkyl sulfuric acid ester salts, alkylbenzene sulfonates, alkylnaphthalene sulfonates, dialkylsulfosuccinic acid ester salts, alkyl phosphoric acid ester salts, and a naphthalene sulfonic acid formalin condensate, and an amphoteric surfactant betaine-type, glycine-type, alanine-type, or sulfobetaine-type amphoteric surfactant. The amount of these wetting agents and/or surfactants contained in the oil desensitizing liquid with respect to the total weight of the oil desensitizing liquid is in a range of about 0.5% to 10% by weight, and more preferably in a range of about 1% to 5% by weight. The oil desensitizing liquid used in the present invention can further contain a filler such as silicon dioxide, talc, or clay in an amount of up to 2% by weight, and can further contain a dye, a pigment, or the like in an amount of up to 1% by weight.

The oil desensitizing liquid used in the present embodiment consists of a hydrophilic aqueous solution as described above. For example, it is also possible to use the emulsified oil desensitizing liquids described in specifications of US4253999A, US4268613A, US4348954A, and the like in consideration of the fact that sometimes the aforementioned oil desensitizing liquid negatively affects the image-recording layer.

As the ink repellent, for example, HN-G5 (manufactured by FUJIFII,M Corporation) can be used.

(Coating method of ink repellent)

The coating method of performing coating with an ink repellent is not particularly limited. Fig. 7 is a view illustrating a coating method of performing coating with an ink repellent. As shown in Fig. 7, coating with a coating liquid containing an ink repellent can be performed using a wire bar 138. In Fig. 7, in order to explain a method of performing coating with an ink repellent, a lithographic printing plate precursor 100a having an outermost layer surface 122 on the side of the specific constitutional layer with reference to the support is illustrated simply, and the shear droop shape of the end part is not illustrated. For performing coating with an ink repellent by using the wire bar 138, first, the wire bar 138 is coated with a coating liquid containing an ink repellent. The wire bar 138 coated with the coating liquid is moved along an edge surface 120 (the lateral surface of the aluminum support) of the lithographic printing plate precursor 100a. The wire bar 138 can be moved, for example, at a moving speed of 20 mm/s. After coating, the coating liquid is dried. The drying can be performed, for example, under drying conditions where the coating liquid is exposed to air at 80°C

for 30 seconds at a wind speed of 6 m/s.

The size of the wire bar can be appropriately changed depending on the thickness of the aluminum support of the lithographic printing plate precursor 100a. For example, in a case where the thickness of the aluminum support is 0.3 mm, a #10 wire bar can be used.

During the coating with the coating liquid, as shown in Fig. 7, the wire bar 138 may be applied to the edge surface 120 of the lithographic printing plate precursor 100a by being tilted at an angle θ for coating.

As a method of coating a part of all of two opposing lateral surfaces of the lithographic printing plate precursor with the ink repellent, the method described in JP6628949B can be suitably used.

In the on-press development type lithographic printing plate precursor according to the embodiment of the present invention, the arithmetic mean height Sa of the surface of the outermost layer on the side opposite to the side where the image-recording layer is provided is preferably in a range of 0.3 to 20 μm. Here, the side opposite to the side where the image-recording layer is provided means the side opposite to the side where the image-recording layer is provided with reference to the support.

In the on-press development type lithographic printing plate precursor according to the embodiment of the present invention, the arithmetic mean height Sa of the surface of the outermost layer on the side where the image-recording layer is provided is preferably in a range of 0.3 to 20 μm. Here, the side where the image-recording layer is provided means the side where the image-recording layer is provided with reference to the support.

By providing the outermost layer surface having such characteristics, even in a case of being stacked in a form in which a interleaving paper is not interleaved between precursors (also referred to as elimination of interleaving paper), the on-press development type lithographic printing plate precursor according to the embodiment of the present invention is excellent in properties such as a property of preventing multiple plates from being fed in a step of taking out a precursor from a stack, a property of preventing scratches caused by a projection provided on the surface of the outermost layer of the precursor, and a property of preventing development delay caused by a projection provided on the surface of the outermost layer of the precursor.

In a case where the outermost layer surface on the side opposite to the side where the image-recording layer is provided has a backcoat layer on the opposite side, the outermost layer surface is the surface of the backcoat layer. In a case where the outermost layer surface has no layer on the opposite side, the outermost layer surface is the support surface.

For example, in a case where protrusions that will be described later are formed, the backcoat layer may be the outermost layer of the lithographic printing plate precursor, and a plurality of protrusions containing a polymer compound may be on the backcoat layer. Alternatively, the support may be the outermost layer, and a plurality of protrusions containing a polymer compound may be on the support.

In a case where an image-recording layer or a protective layer is the outermost layer, the outermost layer surface on the side where the image-recording layer is provided is the surface of the image-recording layer or the surface of the protective layer.

For example, in a case where protrusions that will be described later are formed, the image-recording layer or the protective layer may be the outermost layer of the lithographic printing plate precursor, and a plurality of protrusions containing a polymer compound may be on the image-recording layer or the protective layer.

The arithmetic mean height Sa of the surface of the outermost layer on the side opposite to the side where the image-recording layer is provided is more preferably in a range of 0.5 to 10 μm, and even more preferably in a range of 0.5 to 7 μm.

The arithmetic mean height Sa of the surface of the outermost layer on the side where the image-recording layer is provided is more preferably in a range of 0.5 to 10 μm, and even more preferably in a range of 0.5 to 7 μm.

The arithmetic mean height Sa of the outermost layer surface is measured according to the method described in ISO 25178. Specifically, the arithmetic mean height Sa is obtained by using MICROMAP MM3200-M100 (manufactured by Mitsubishi Chemical Systems, Inc.), selecting three or more sites from the same sample, performing the measurement, and averaging the obtained values. Regarding the measurement range, a range of 500 μm × 500 μm randomly selected from the sample surface is measured.

In order that the condition where the arithmetic mean height Sa of the outermost layer surface is 0.3 to 20 μm is satisfied, it is preferable that the outermost layer be in the form having irregularities.

Specifically, examples of aspects thereof include an aspect in which the outermost layer contains particles having an average particle diameter of 0.5 to 20 μm (aspect 1), and an aspect in which a plurality of protrusions containing a polymer compound as a main component is on the outermost layer (aspect 2). Here, the main component indicates a component whose content ratio (% by mass) is the highest.

In the aspect 1, the particles having an average particle diameter of 0.5 to 20 μm are not particularly limited, but are preferably at least one kind of particles selected from organic resin particles and inorganic particles.

Preferred examples of the organic resin particles include particles consisting of synthetic resins such as poly(meth)acrylic acid esters, polystyrene and derivatives thereof, polyamides, polyimides, polyolefins including low-density

polyethylene, high-density polyethylene, polypropylene, and the like, polyurethanes, polyureas, and polyesters, particles consisting of natural polymers such as chitin, chitosan, cellulose, crosslinked starch, and crosslinked cellulose, and the like.

Among these, the synthetic resin particles have advantages such as ease of particle size control and ease of control of surface characteristics as desired by surface reforming.

Regarding the manufacturing method of the organic resin particles, although a relatively hard resin such as polymethylmethacrylate (PMMA) can be made into fine particles by a crushing method, a particle synthesis method by an emulsification suspension polymerization method is preferably adopted in view of ease of particle diameter control and accuracy.

Details of the manufacturing method of the organic resin particles are described in "Ultrafine particles and materials" edited by The Materials Science Society of Japan, published in 1993, "Preparation and application of fine particles/powders", supervised by Haruma Kawaguchi, CMC Publishing CO., LTD., published in 2005, and the like.

Examples of commercially available products of the organic resin particles include crosslinked acrylic resins MX-40T, MX-80H3wT, MX-150, MX-180TA, MX-300, MX-500, MX-1000, MX-1500H, MR-2HG, MR-7HG, MR-10HG, MR-3GSN, MR-5GSN, MR-7G, MR-10G, MR-5C, and MR-7GC, and styryl resin-based SX-350H and SX-500H (manufactured by Soken Chemical & Engineering Co., Ltd.), Acrylic resins MBX-5, MBX-8, MBX-12MBX-15, MBX-20, MB20X-5, MB30X-5, MB30X-8, MB30X-20, SBX-6, SBX-8, SBX-12, and SBX-17 (manufactured by Sekisui Kasei Co., Ltd.), polyolefin resins and CHEMIPEARL W100, W200, W300, W308, W310, W400, W401, W405, W410, W500, WF640, W700, W800, W900, W950, and WP100 (manufactured by Mitsui Chemicals, Inc.).

Examples of the inorganic particles include silica, alumina, zirconia, titania, carbon black, graphite, $BaSO_4$, ZnS, $MgCO_3$, $CaCO_3$, ZnO, CaO, $WS_2$, $MoS_2$, MgO, $SnO_2$, $\alpha$-$Fe_2O_3$, $\alpha$-FeOOH, SiC, $CeO_2$, BN, SiN, MoC, BC, WC, titanium carbide, corundum, artificial diamond, garnet, garnet, silicastone, triboli, diatomaceous earth, dolomite, and the like.

The aforementioned particles are preferably particles having a hydrophilic surface. The particles having a hydrophilic surface include organic resin particles having a hydrophilic surface and inorganic particles having a hydrophilic surface.

The organic resin particles having a hydrophilic surface are preferably organic resin particles coated with at least one inorganic compound selected from the group consisting of silica, alumina, titania, and zirconia, and particularly preferably organic resin particles coated with silica.

The organic resin constituting the organic resin particles having a hydrophilic surface is preferably at least one resin selected from the group consisting of a polyacrylic resin, a polyurethane-based resin, a polystyrene-based resin, a polyester-based resin, an epoxy-based resin, a phenol-based resin, and a melamine resin.

Hereinafter, as an example of the organic resin particles having a hydrophilic surface, organic resin particles coated with silica (hereinafter, also called "silica-coated organic resin particles") will be specifically described. However, the organic resin particles having a hydrophilic surface are not limited thereto.

The silica-coated organic resin particles are particles obtained by coating the surface of particles consisting of an organic resin with silica. It is preferable that the organic resin particles constituting a core do not soften or turn sticky by the moisture in the air or temperature.

Examples of the organic resin constituting the organic resin particles in the silica-coated organic resin particles include a polyacrylic resin, a polyurethane-based resin, a polystyrene-based resin, a polyester-based resin, an epoxy-based resin, a phenol resin, a melamine resin, and the like.

Examples of materials forming the silica layer that coats the surface of the silica-coated organic resin particles include an alkoxysilyl group-containing compound such as a condensate of alkoxysiloxane-based compound, particularly, a siloxane-based material. Specifically, for example, silica particles such as silica sol, colloidal silica, and silica nanoparticles, and the like are preferable.

The silica-coated organic resin particles may have a constitution in which silica particles have adhered to the surface of organic resin particles as a solid component or may have a constitution in which a siloxane-based compound layer is formed on the surface of organic resin particles by a condensation reaction with an alkoxysiloxane-based compound.

It is not necessary for the surface of the organic resin particles to be fully coated with silica. It is preferable that the surface of the organic silica particles be coated such that the amount of silica is at least 0.5% by mass or more with respect to the total mass of the organic resin particles. That is, in a case where silica is present on at least a part of the surface of the organic resin particles, the affinity with a water-soluble polymer, for example, polyvinylalcohol (PVA), that also exists on the surface of the organic particles is improved. As a result, even though the particles are exposed to external stress, detachment of the particles is suppressed, which makes it possible to maintain excellent scratch resistance and ease of peeling during laminating without interleaving paper. Therefore, "silica-coated" includes a state where silica is present on at least a part of the surface of the organic resin particles.

The surface coating state of silica can be checked by morphological observation using a scanning electron

microscope (SEM) or the like. In addition, the coating amount of silica can be checked by detecting Si atoms by elemental analysis such as X-ray fluorescence analysis and calculating the amount of silica present therein.

The manufacturing method of the silica-coated organic resin particles is not particularly limited, and may be a method of allowing silica particles or a silica precursor compound to coexist with a monomer component which is a raw material of organic resin particles to form organic resin particles and form a silica surface coating layer at the same time or a method of forming organic resin particles, then physically attaching silica particles, and then immobilizing the particles.

Hereinafter, an example of the manufacturing method of the silica-coated organic resin particles will be described. First, silica and a raw material resin (more specifically, a raw material resin such as a suspension-polymerizable monomer, a suspension-crosslinkable prepolymer, or a resin liquid constituting the organic resin) are added to water containing a water-soluble polymer such as polyvinyl alcohol, methyl cellulose, or polyacrylic acid or suspension stabilizer appropriately selected from inorganic suspension agents such as calcium phosphate, calcium carbonate, and the like, followed by stirring and mixing to disperse silica and the raw material resin, thereby preparing a suspension. At this time, adjusting the type and concentration of suspension stabilizer, rotation speed for stirring, and the like makes it possible to form a suspension having a desired particle diameter. Thereafter, the suspension is heated such that a reaction is initiated and the resin raw material undergoes suspension polymerization or suspension crosslinking, thereby generating resin particles. At this time, the coexisting silica is immobilized on the resin particles that are cured by the polymerization or crosslinking reaction, particularly, in the vicinity of the surface of the resin particles due to the physical properties thereof. Then, the suspension is subjected to solid-liquid separation and washed to remove the suspension stabilizer having adhered to the particles, followed by drying. In this way, substantially spherical silica-coated organic resin particles with a desired particle diameter having immobilized silica are obtained.

As described above, by controlling the conditions during the suspension polymerization or the suspension crosslinking, it is possible to obtain silica-coated organic resin particles having a desired particle diameter. Alternatively, by generating silica-coated organic resin particles without strictly controlling such conditions and then filtering the particles through a mesh, it is possible to obtain silica-coated organic particles having a desired size.

Regarding the amount of raw materials added in the mixture used in manufacturing the silica-coated organic particles by the above method, for example, in a case where the total amount of the raw material resin and silica is 100 parts by mass, for example, an aspect is preferable in which 0.1 to 20 parts by mass of a suspension stabilizer is added first to 200 to 800 parts by mass of water which is a dispersion medium, thoroughly dissolving or dispersing the raw material resin and silica, 100 parts by mass of the aforementioned mixture of the raw material resin and silica is added to the obtained liquid, the liquid is stirred in a state where the stirring speed is being adjusted such that the dispersed particles have a predetermined particle size, the liquid temperature is raised to 30°C to 90°C after the particle size is adjusted, and the liquid is allowed have a reaction for 1 to 8 hours.

The above method is an example of the manufacturing method of the silica-coated organic resin particles. For example, silica-coated organic resin particles obtained, for example, by the methods specifically described in JP2002-327036A, JP2002-173410A, JP2004-307837A, JP2006-38246A, and the like can also be suitably used in the present invention.

The silica-coated organic resin particles are also available as a commercially available product. Specific examples of the silica/melamine composite particles include OPTBEADS 2000M, OPTBEADS 3500M, OPTBEADS 6500M, OPTBEADS 10500M, OPTBEADS 3500S, and OPTBEADS 6500S manufactured by Nissan Chemical Corporation. Examples of the silica/acryl composite particles include ART PEARL G-200 transparent, ART PEARL G-400 transparent, ART PEARL G-800 transparent, ART PEARL GR-400 transparent, ART PEARL GR-600 transparent, ART PEARL GR-800 transparent, and ART PEARL J-7P manufactured by Negami Chemical Industrial Co., Ltd. Examples of the silica/urethane composite particles include ART PEARL C-400 transparent, C-800 transparent, P-800T, U-600T, U-800T, CF-600T, and CF800T manufactured by Negami Chemical Industrial Co., Ltd., DYNAMIC BEADS CN5070D, and DANPLACOAT THU manufactured by Dainichiseika Color & Chemicals Mfg.Co., Ltd.

Organic resin particles were described as an example of the silica-coated organic resin particles. Organic resin particles coated with alumina, titania, or zirconia can be manufactured by the same method by using alumina, titania, or zirconia instead of silica.

It is preferable that the aforementioned particles have a perfectly spherical shape. The aforementioned particles may have a flat plate shape or so-called spindle shape that looks like an ellipse in a projection view.

In the aspect 1, the average particle diameter of the particles is preferably in a range of 0.5 to 10 μm and more preferably in a range of 0.5 to 5 μm.

The average particle diameter of particles means a volume average particle diameter. The volume average particle diameter is measured with a laser diffraction/scattering-type particle size distribution analyzer. Specifically, the measurement is performed using, for example, a particle size distribution measuring device "MICROTRAC MT-3300II" (manufactured by Nikkiso Co., Ltd.).

For other particles, unless otherwise specified, the average particle diameter is measured by the above measuring method.

In the aspect 1, an in-plane density of particles having an average particle diameter of 0.5 to 20 μm is preferably 10,000 particles/$mm^2$ or less. The in-plane density is more preferably 100 to 5,000 particles/$mm^2$, and even more preferably 100 to 3,000 particles/$mm^2$.

The in-plane density can be checked by observing the surface of the lithographic printing plate precursor with a scanning electron microscope (SEM). Specifically, five sites within the surface of the lithographic printing plate precursor re observed with a scanning electron microscope (SEM), the number of particles is counted and converted into the number of particles per area ($mm^2$) of the visual field of observation, and the average thereof is calculated. In this way, the in-plane density can be determined.

It is preferable that the outermost layer on the side opposite to the side where the image-recording layer is provided contain a binder, in addition to the particles having an average particle diameter of 0.5 to 20 μm.

The binder preferably contains at least one compound selected from the group consisting of a novolac or resol resin such as a phenolformaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, pyrogallol, an acetone resin, an epoxy resin, a saturated copolymerized polyester resin, a phenoxy resin, a polyvinyl acetal resin, a vinylidene chloride copolymer resin, polybutene, polybutadiene, polyamide, an unsaturated copolymerized polyester resin, polyurethane, polyurea, polyimide, polysiloxane, polycarbonate, an epoxy resin, chlorinated polyethylene, an aldehyde condensation resin of alkylphenol, polyvinyl chloride, polyvinylidene chloride, polystyrene, polyacrylate, a carboxyvinyl polymer, an acrylic resin copolymer resin, hydroxycellulose, hydroxymethylcellulose, polyvinyl alcohol, polyvinylpyrrolidone, cellulose acetate, methylcellulose, and carboxymethylcellulose. In order to prevent concerns on dissolution in dampening water during on-press development, a water-insoluble resin is preferable.

In addition, the binder preferably contains at least one compound selected from the group consisting of polyurethane, an acrylic resin, polystyrene, and polyethylene.

Furthermore, in the aspect 1, it is preferable that the aforementioned particles and the binder each independently contain at least one compound selected from the group consisting of polyurethane, an acrylic resin, polystyrene, and polyethylene.

The outermost layer on the side opposite to the side where the image-recording layer is provided may contain other components in addition to the particles and the binder. Examples of those other components include known additives, such as a surfactant.

The thickness of the outermost layer on the side opposite to the side where the image-recording layer is provided is preferably in a range of 0.5 to 10 μm, more preferably in a range of 0.5 to 5 μm, and still more preferably in a range of 0.5 to 3 μm.

The polymer compound configuring the plurality of protrusions containing a polymer compound as a main component in the aspect 2 preferably contains at least one polymer compound selected from the group consisting of a novolac or resol resin such as a phenolformaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, pyrogallol, an acetone resin, an epoxy resin, a saturated copolymerized polyester resin, a phenoxy resin, a polyvinyl acetal resin, a vinylidene chloride copolymer resin, polybutene, polybutadiene, polyamide, an unsaturated copolymerized polyester resin, polyurethane, polyurea, polyimide, polysiloxane, polycarbonate, an epoxy resin, chlorinated polyethylene, an aldehyde condensation resin of alkylphenol, polyvinyl chloride, polyvinylidene chloride, polystyrene, polyacrylate, a carboxyvinyl polymer, an acrylic resin copolymer resin, hydroxycellulose, hydroxymethylcellulose, polyvinyl alcohol, polyvinylpyrrolidone, cellulose acetate, methylcellulose, and carboxymethylcellulose.

Among these, from the viewpoint of causing excellent developability to be exhibited even in a case where the detached protrusions move to the image-recording layer, a water-soluble polymer is more preferable. Specific examples thereof include polyacrylate, a carboxyvinyl polymer, an acrylic resin copolymer resin, hydroxycellulose, hydroxymethyl cellulose, polyvinyl alcohol, modified polyvinyl alcohol, polyvinylpyrrolidone, cellulose acetate, methylcellulose, carboxymethyl cellulose, and the like.

As the modified polyvinyl alcohol, acid-modified polyvinyl alcohol having a carboxy group or a sulfo group is preferably used. Specifically, the modified polyvinyl alcohols described in JP2005-250216A and JP2006-259137A are suitable.

The shape and height of the protrusions are not particularly limited, but the arithmetic mean height Sa is preferably 0.3 to 20 μm.

The method of forming protrusions in a stripe pattern (stripe coating film) is not particularly limited. It is possible to easily form such protrusions by performing coating with a composition containing at least one component selected from the group consisting of particles and a polymer compound, by at least one method selected from the group consisting of a bar coating method, an ink jet printing method, a gravure printing method, a screen printing method, a spray coating method, and a slot die coating method.

The method of forming protrusions in a dot pattern (dot coating film) is not particularly limited. It is possible to easily form such protrusions by performing coating with a composition containing at least one component selected from

the group consisting of particles and a polymer compound, by at least one method selected from the group consisting of a spray coating method, an inkjet printing method, and a screen printing method.

The method of forming protrusions in a broken line pattern (broken line coating film) is not particularly limited. It is possible to easily form such protrusions by performing coating with a composition containing at least one component selected from the group consisting of particles and a polymer compound, by at least one method selected from the group consisting of an inkjet printing method and a screen printing method.

Examples of the binder contained in the outermost layer in the aspect 2 include the same polymer compound as the polymer compound contained in the protrusions, and preferred aspects thereof are also identical.

In the aspect 2, from the viewpoint of preventing the detachment of the protrusions, it is preferable that the binder contained in the outermost layer and the polymer compound contained in the protrusions contain the same type of resin. The "same type of resin" means that the types of resins, such as polyurethane, an acrylic resin, polystyrene, and polyethylene, are identical, and it is not necessary for all the constitutional units in the resins to be the same as each other.

(Method of preparing printing plate)

The method of preparing a printing plate according to an embodiment of the present invention will be described using the lithographic printing plate precursor according to an embodiment of the present invention. The method of preparing a printing plate includes a step (exposure step) of image-exposing a lithographic printing plate precursor and a step (on-press development step) of removing a non-exposed portion of an image-recording layer in the image-exposed lithographic printing plate precursor on a printer by supplying at least one of printing ink or dampening water.

[Exposure step]

The image exposure is preferably performed by a method of scanning and exposing digital data with an infrared laser or the like.

The wavelength of an exposure light source to be used is preferably 750 to 1,400 nm. As the light source having a wavelength of 750 to 1,400 nm, a solid-state laser or a semiconductor laser that radiates infrared rays is suitable. The exposure mechanism may be any of an in-plane drum method, an external surface drum method, a flat head method, and the like.

The exposure step can be performed by a known method using a platesetter or the like. In addition, a printer comprising an exposure device may be used, the lithographic printing plate precursor may be mounted on the printer, and then image exposure may be performed on the printer.

[On-press development step]

In the on-press development step, in a case where printing begins by supplying of a printing ink and dampening water on a printer without performing any development treatment on the lithographic printing plate precursor after image exposure, the non-exposed portion of the lithographic printing plate precursor is removed at the initial stage during printing. As a result, the surface of the hydrophilic support is exposed, and a non-image area is formed. As the printing ink and the dampening water, known printing ink and dampening water for lithographic printing are used. What is supplied first to the surface of the printing plate precursor may be any of the printing ink or dampening water. In view of preventing the plate from being contaminated by the components of the image-recording layer from which the dampening water is removed, it is preferable that the printing ink be supplied first.

In the manner described above, the lithographic printing plate precursor is subjected to on-press development on an offset printer and used as it is for printing a number of sheets.

The method of preparing a printing plate according to the embodiment of the present invention may include known steps other than the above-described steps. Examples of those other steps include a plate inspection step of checking the position and orientation of the lithographic printing plate precursor before each step, a checking step of checking a print-out image after the on-press development step, and the like.

Examples

Hereinafter, the present invention will be specifically described based on examples, but the present invention is not limited thereto. In examples, unless otherwise specified, "%" and "part" mean "% by mass" and "part by mass" respectively. Unless otherwise described, the molecular weight of a polymer compound is a mass-average molecular weight (Mw), and the ratio of repeating constitutional units of a polymer compound is expressed as molar percentage. The mass-average molecular weight (Mw) is a polystyrene-equivalent molecular weight measured by gel permeation

chromatography (GPC).

[Examples 1 to 29 and Comparative Examples 1 and 2]

<Preparation of support 1>

The following treatments (F-a) to (F-g) were performed on an aluminum plate (aluminum alloy plate) made of a material 1S having a thickness of 0.3 mm, thereby preparing a support 1. A rinsing treatment was performed between all the treatment steps. After the rinsing treatment, water was drained using a nip roller.

(F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 5 g/m$^2$.

(F-b) Desmutting treatment using acidic aqueous solution

As an acidic aqueous solution, an aqueous solution at a liquid temperature of 30°C having a sulfuric acid concentration of 150 g/L was sprayed on an aluminum plate for 3 seconds, thereby performing a desmutting treatment.

(F-c) Electrochemical roughening treatment

An electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm$^2$ in terms of the peak current value of the alternating current waveform. In addition, the quantity of electricity was 450 C/dm$^2$ which was the total quantity of electricity used for the aluminum plate to have an anodic reaction, and the electrolytic treatment was performed 4 times by conducting electricity of 112.5 C/dm$^2$ for 4 seconds at each treatment session. A carbon electrode was used as the counter electrode of the aluminum plate.

(F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/m$^2$.

(F-e) Desmutting treatment using acidic aqueous solution

As an acidic aqueous solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

(F-f) First-stage anodization treatment

By using the anodization device for direct current electrolysis having the structure shown in Fig. 6, a first-stage anodization treatment was performed. By using a 150 g/L aqueous phosphoric acid solution as an electrolytic solution, an anodization treatment was performed under the conditions of a liquid temperature of 35°C and a current density of 4.5 A/dm$^2$, thereby forming an anodic oxide film having a film amount of 1 g/m$^2$.

In an anodization treatment device 410 shown in Fig. 6, an aluminum plate 416 is transported as indicated by the arrow in Fig. 6. In a power supply tank 412 containing an electrolytic solution 418, the aluminum plate 416 is positively (+) charged by a power supply electrode 420. Then, the aluminum plate 416 is transported upwards by a roller 422 in

the power supply tank 412, makes a turn downwards by a nip roller 424, then transported toward an electrolytic treatment cell 414 containing an electrolytic solution 426, and makes a turn by a roller 428 to move in the horizontal direction. Subsequently, the aluminum plate 416 is negatively (-) charged by an electrolysis electrode 430. As a result, an anodic oxide film is formed on the surface of the aluminum plate 416. The aluminum plate 416 exits from the electrolytic treatment cell 414 and is then transported for the next step. In the anodization treatment device 410, the roller 422, the nip roller 424, and the roller 428 constitute a direction change unit. Furthermore, in the inter-tank portion between the power supply tank 412 and the electrolytic treatment cell 414, the aluminum plate 416 is transported in a ridge shape and an inverted U shape by the rollers 422, 424, and 428. The power supply electrode 420 and the electrolysis electrode 430 are connected to a direct current power source 434.

(F-g) Second-stage anodization treatment

By using the anodization device for direct current electrolysis having the structure shown in Fig. 6, a second-stage anodization treatment was performed. By using a 170 g/L aqueous sulfuric acid solution as an electrolytic solution, an anodization treatment was performed under the conditions of a liquid temperature of 50°C and a current density of 13 A/$dm^2$, thereby forming an anodic oxide film having a film amount of 2.1 g/$m^2$. Then, rinsing was performed by means of spraying. The average diameter of the micropores in the support 2 was 40 nm.

The value of the brightness L* of the surface of the anodic oxide film of the support 1 was 83.7 in the L*a*b* color system.

<Preparation of support 2>

The following treatments (F-a) to (F-f) were performed on an aluminum plate (aluminum alloy plate) made of a material 1S having a thickness of 0.3 mm, thereby preparing a support 2. A rinsing treatment was performed between all the treatment steps. After the rinsing treatment, water was drained using a nip roller.

(F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 5 g/$m^2$.

(F-b) Desmutting treatment using acidic aqueous solution

As an acidic aqueous solution, an aqueous solution at a liquid temperature of 30°C having a sulfuric acid concentration of 150 g/L was sprayed on an aluminum plate for 3 seconds, thereby performing a desmutting treatment.

(F-c) Electrochemical roughening treatment

An electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/$dm^2$ in terms of the peak current value of the alternating current waveform. In addition, the quantity of electricity was 450 C/$dm^2$ which was the total quantity of electricity used for the aluminum plate to have an anodic reaction, and the electrolytic treatment was performed 4 times by conducting electricity of 112.5 C/$dm^2$ for 4 seconds at each treatment session. A carbon electrode was used as the counter electrode of the aluminum plate.

(F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/$m^2$.

(F-e) Desmutting treatment using acidic aqueous solution

As an acidic aqueous solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

(F-f) First-stage anodization treatment

By using the anodization device for direct current electrolysis having the structure shown in Fig. 6, a first-stage anodization treatment was performed. By using a 150 g/L aqueous phosphoric acid solution as an electrolytic solution, an anodization treatment was performed under the conditions of a liquid temperature of 35°C and a current density of 4.5 A/dm$^2$, thereby forming an anodic oxide film having a film amount of 1 g/m$^2$.
The average diameter of the micropores in the support 2 was 40 nm.
The value of the brightness L* of the surface of the anodic oxide film of the support 2 was 82.4 in the L*a*b* color system.

<Preparation of support 3>

A support 3 was prepared according to the manufacturing method of the support of Example 5 of WO2021/67054A.

<Preparation of support 4>

The following treatments (J-a) to (J-m) were performed on an aluminum plate (aluminum alloy plate) made of a material 1S having a thickness of 0.3 mm, thereby manufacturing a support 4. A rinsing treatment was performed between all the treatment steps. After the rinsing treatment, water was drained using a nip roller.

(J-a) Mechanical roughening treatment (brush graining method)

By using the device shown in Fig. 5, a pumice suspension (specific gravity: 1.1 g/cm$^3$) as an abrasive slurry was supplied to the surface of an aluminum plate, and in this state, a mechanical roughening treatment is performed using a rotating bundled brush. In Fig. 5, 31 represents an aluminum plate, 32 and 34 represent roller-shaped brushes (bundled brushes in the present example), 33 represents an abrasive slurry, and 35, 36, 37, and 38 represent support rollers.
In the mechanical roughening treatment, an abrasive having a median diameter (μm) of 30 μm and 4 brushes were used, and the rotation speed (rpm) of the brushes was set to 250 rpm. The bundled brush was made of 6 10 nylon and consisted of bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

(J-b) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 10 g/m$^2$.

(J-c) Desmutting treatment using acidic aqueous solution

As an acidic aqueous solution, the waste liquid of nitric acid used in the following step, an electrochemical roughening treatment, at a liquid temperature of 35°C was sprayed on the aluminum plate for 3 seconds. In this way, a desmutting treatment was performed.

(J-d) Electrochemical roughening treatment using aqueous nitric acid solution

An electrochemical roughening treatment was continuously performed using alternating current voltage of 60

Hz. An electrolytic solution at a liquid temperature of 35°C was used which was prepared by adding aluminum nitrate to 10.4 g/L aqueous nitric acid solution such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used. The peak current density was 30 A/dm$^2$, and 5% of the current coming from the power source was allowed to flow into the auxiliary anode. The electricity quantity (C/dm$^2$) was 185 C/dm$^2$, which is the total quantity of electricity used during the anodic reaction of the aluminum plate.

(J-e) Alkaline etching treatment

An aqueous solution of caustic soda having a caustic soda concentration of 27% by mass and an aluminum ion concentration of 2.5% by mass was sprayed onto the aluminum plate at a temperature of 50°C, thereby performing an etching treatment. The amount of dissolved aluminum was 3.5 g/m$^2$.

(J-f) Desmutting treatment using acidic aqueous solution

As an acidic aqueous solution, an aqueous solution at a liquid temperature of 30°C having a sulfuric acid concentration of 170 g/L and an aluminum ion concentration of 5 g/L was sprayed on an aluminum plate for 3 seconds, thereby performing a desmutting treatment.

(J-g) Electrochemical roughening treatment using aqueous hydrochloric acid solution

An electrochemical roughening treatment was continuously performed using alternating current voltage of 60 Hz. An electrolytic solution at a liquid temperature of 35°C was used which was prepared by adding aluminum chloride to 6.2 g/L aqueous hydrochloric acid solution such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used. The peak current density was 25 A/dm$^2$, and the electricity quantity (C/dm$^2$) during the hydrochloric acid electrolysis was 63 C/dm$^2$ which is the total quantity of electricity used during the anodic reaction of the aluminum plate.

(J-h) Alkaline etching treatment

An aqueous solution of caustic soda having a caustic soda concentration of 5% by mass and an aluminum ion concentration of 0.5% by mass was sprayed onto the aluminum plate at a temperature of 60°C, thereby performing an etching treatment. The amount of dissolved aluminum was 0.2 g/m$^2$.

(J-i) Desmutting treatment using acidic aqueous solution

As an acidic aqueous solution, an aqueous solution at a liquid temperature of 35°C (sulfuric acid concentration 170 g/L and aluminum ion concentration 5 g/L) which was a waste liquid generated in the anodization treatment step was sprayed on an aluminum plate for 4 seconds, thereby performing a desmutting treatment.

(J-j) First-stage anodization treatment

By using the anodization device for direct current electrolysis having the structure shown in Fig. 6, a first-stage anodization treatment was performed. By using a 170 g/L aqueous sulfuric acid solution as an electrolytic solution, an anodization treatment was performed under the conditions of a liquid temperature of 50°C and a current density of 30 A/dm$^2$, thereby forming an anodic oxide film having a film amount of 0.3 g/m$^2$.

(J-k) Pore widening treatment

The aluminum plate having undergone the anodization treatment was immersed in an aqueous solution of caustic soda having a caustic soda concentration of 5% by mass and an aluminum ion concentration of 0.5% by mass for 3 seconds at 40°C, thereby performing a pore widening treatment.

(J-l) Second-stage anodization treatment

By using the anodization device for direct current electrolysis having the structure shown in Fig. 6, a second-stage anodization treatment was performed. By using a 170 g/L aqueous sulfuric acid solution as an electrolytic solution, an anodization treatment was performed under the conditions of a liquid temperature of 50°C and a current density of 13 A/$dm^2$, thereby forming an anodic oxide film having a film amount of 2.1 g/$m^2$.

(J-m) Hydrophilic treatment

In order to ensure the hydrophilicity of the non-image area, the aluminum plate was immersed in a 2.5% by mass No. 3 aqueous sodium silicate solution at 50°C for 7 seconds, thereby performing a silicate treatment. The amount of Si adhered was 8.5 mg/$m^2$. The average diameter of the micropores was 30 nm.

The value of the brightness L* of the surface of the anodic oxide film of the support 4 was 72.3 in the L*a*b* color system.

<Preparation of support 5>

-Alkaline etching treatment-

An aqueous solution of caustic soda having a caustic soda concentration of 26% by mass and an aluminum ion concentration of 6.5% by mass was sprayed onto the aluminum plate at a temperature of 55°C, thereby performing an etching treatment. Then, rinsing was performed by means of spraying. The amount of dissolved aluminum within the surface to be subjected to the electrochemical roughening treatment later was 3 g/$m^2$.

-Desmutting treatment using acidic aqueous solution (first desmutting treatment)-

Next, a desmutting treatment was performed using an acidic aqueous solution. In the desmutting treatment, a 170 g/L aqueous sulfuric acid solution was used as the acidic aqueous solution. The liquid temperature was 30°C. The desmutting treatment was performed for 3 seconds by spraying the acidic aqueous solution onto the aluminum plate. Then, a rinsing treatment was performed.

-Electrochemical roughening treatment-

Next, an electrochemical roughening treatment was performed using an electrolytic solution at a hydrochloric acid concentration and alternating current. The liquid temperature of the electrolytic solution was 40°C. The waveform of the alternating current was a sine wave in which the positive and negative waveforms are symmetrical, and the frequency was 50 Hz. The quantity of electricity was 300 C/$dm^2$, which is the total quantity of electricity that the aluminum plate stores during the anodic reaction. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 35°C such that the etching amount was 0.1 g/$m^2$ or less, thereby performing an etching treatment. Then, a rinsing treatment was performed.

-Desmutting treatment using acidic aqueous solution-

Next, a desmutting treatment was performed using an acidic aqueous solution. In the desmutting treatment, a 170 g/L aqueous sulfuric acid solution was used as the acidic aqueous solution. The liquid temperature was 30°C. The desmutting treatment was performed for 3 seconds by spraying the acidic aqueous solution onto the aluminum plate. Then, a rinsing treatment was performed.

-Anodization treatment-

An anodization treatment was performed using 170 g/L of a sulfuric acid solution and direct current at a liquid temperature of 40°C such that the amount of the anodic oxide film was 3 g/$m^2$, and then the support 5 was obtained.

<Formation of undercoat layer 1>

The support was coated with an undercoat layer coating liquid (1) having the following composition such that the dry coating amount was 0.03 g/m$^2$. In this way, an undercoat layer 1 was formed.

(Undercoat layer coating liquid (1))

| | |
|---|---|
| Aqueous polyacrylic acid solution (40% by mass) Jurymer AC-10S (manufactured by Toagosei Company, Limited) | 3.0 parts |
| Water | 27.0 parts |

<Formation of undercoat layer 2>

The support was coated with an undercoat layer coating liquid (2) having the following composition such that the dry coating amount was 26 mg/m$^2$. In this way, an undercoat layer 2 was formed.

(Undercoat layer coating liquid (2))

| | |
|---|---|
| · Compound for undercoat layer (2) (the following structure) | 0.013 parts |
| · Hydroxyethyl iminodiacetic acid | 0.005 parts |
| · Tetrasodium ethylenediaminetetraacetate | 0.005 parts |
| · Polyoxyethylene lauryl ether | 0.0003 parts |
| · Water | 3.15 parts |

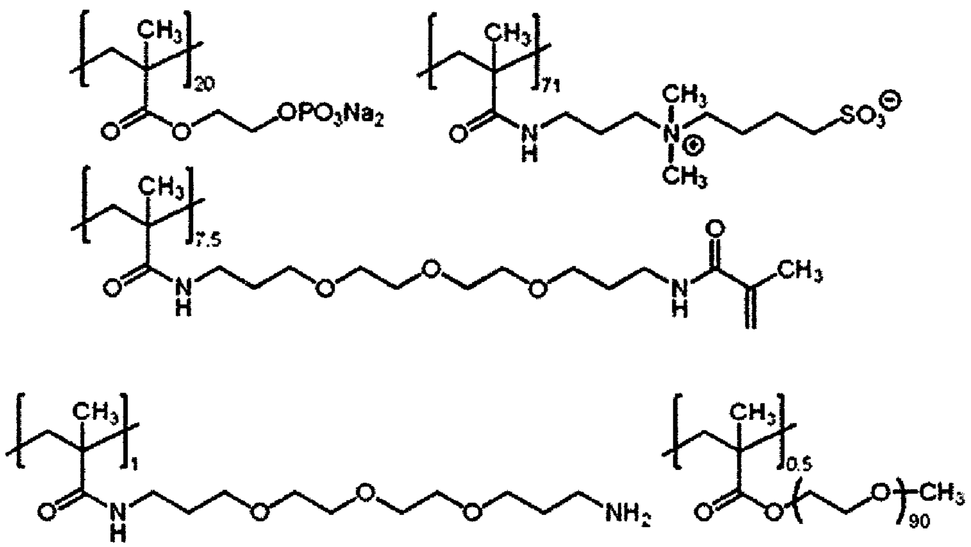

Compound for undercoat layer (2) Mw 100,000

The numerical value at the right lower side of the parentheses of each constitutional unit in the compound (2) for an undercoat layer represents a mass ratio, and the numerical value at the right lower side of the parentheses of the ethyleneoxy unit represents the number of repeating units.

<Formation of image-recording layers 1 to 19, and 22>

The undercoat layer was bar-coated with the image-recording layer coating liquids having the following composition (image-recording layer coating liquid (1) to (19), and (22)) and dried in an oven at 110°C for 40 seconds, thereby forming a respective image-recording layer 1 to 19, and 22 having a dry weight of 0.9 $g/m^2$.

(Image-recording layer coating liquid)

| | |
|---|---|
| · 1-Propanol | 39.75 parts |
| · 2-Butanone | 39.85 parts |
| · γ-Butyrolactone | 0.88 parts |
| · Polymer emulsion A*1 | 6.95 parts |
| · KLUCEL E*2 | 0.25 parts |
| · Iodonium saltA*3 (I-1) | 0.15 parts |
| · Iodonium saltB*4 (I-2) | 0.15 parts |
| · 3-Mercapto 1,2,4-triazole | 0.05 parts |
| · BYK 336*5 | 0.18 parts |
| · TECHPOLYMER SSX-105*6 | 0.47 parts |
| · Polymerizable compound (shown in Table 1) | amount (parts) shown in Table 1 |
| · Infrared absorber (shown in Table 1) | amount (parts) shown in Table 1 |
| · Color forming substance precursor (shown in Table 1) | amount (parts) shown in Table 1 |
| · Ultraviolet absorber (shown in Table 1) | amount (parts) shown in Table 1 |

*1: The polymer emulsion A is polymer particles of a graft copolymer of polyethylene glycol) methyl ether methacrylate/styrene/acrylonitrile = 10:9:81, which is in the form of a dispersion composed of a solvent of n-propanol/water at a mass ratio 80/20 containing 24% by mass of the polymer particles. In addition, the volume average particle diameter is 193 nm.
*2: Klucel E means hydroxypropyl cellulose available from Hercules Incorporated.
*3: A compound represented by Formula 1
*4: A compound represented by Formula 2

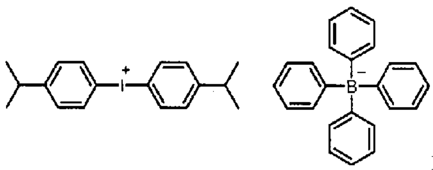
Formula 1

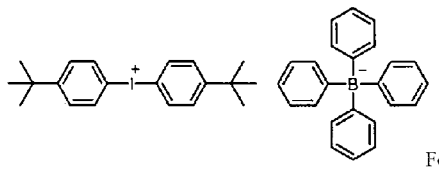
Formula 2

*5: A xylene/methoxypropyl acetate solution containing a modified polydimethylsiloxane copolymer at a concentration of 25% by mass (manufactured by BYK Chemie GmbH)
*6: Crosslinked acrylic beads, average particle diameter of 5.0 μm (Sekisui Kasei Co., Ltd.)

[Table 1]

| Table 1 | | Image-recording layer | | | | | | | | | | | | | | | | | | | |
|---|---|---|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 | 17 | 18 | 19 | 22 |
| Infrared absorber | IR-1 | 0.15 | 0.15 | 0.15 | 0.15 | 0.15 | 0.15 | 0.15 | 0.15 | 0.15 | 0.15 | 0.15 | 0.15 | 0.15 | 0.15 | 0.15 | 0.15 | 0.15 | 0.15 | - | 0.15 |
| | IR-2 | - | - | - | - | - | - | - | - | - | - | - | - | - | - | - | - | - | - | 0.15 | - |
| | IR-3 | - | - | - | - | - | - | - | - | - | - | - | - | - | - | - | - | - | - | 0.15 | - |
| Color forming substance precursor | S-1 | 0.167 | 0.167 | 0.167 | 0.167 | 0.167 | 0.167 | 0.167 | 0.167 | 0.167 | 0.167 | 0.167 | 0.167 | 0.167 | 0.167 | 0.167 | 0.167 | - | - | 0.167 | 0.167 |
| | S-2 | - | - | - | - | - | - | - | - | - | - | - | - | - | - | - | - | 0.167 | - | - | - |
| | S-3 | - | - | - | - | - | - | - | - | - | - | - | - | - | - | - | - | - | 0.167 | - | - |
| Polymerizable compound | M-1 (10 functionalities) | 1.65 | 1.65 | 1.65 | 1.65 | 1.65 | 1.65 | 1.65 | 1.65 | 1.65 | 1.65 | 1.65 | 1.65 | 1.65 | 1.65 | 1.65 | - | 1.65 | 1.65 | 1.65 | - |
| | M-2 (15 functionalities) | - | - | - | - | - | - | - | - | - | - | - | - | - | - | - | 4.4 | - | - | - | - |
| | M-3 (5 functionalities) | 0.77 | 0.77 | 0.77 | 0.77 | 0.77 | 0.77 | 0.77 | 0.77 | 0.77 | 0.77 | 0.77 | 0.77 | 0.77 | 0.77 | 0.77 | - | 0.77 | 0.77 | 0.77 | - |
| | M-4 (4 functionalities) | - | - | - | - | - | - | - | - | - | - | - | - | - | - | 1.32 | - | - | - | - | - |
| | M-5 (3 functionalities) | - | - | - | - | - | - | - | - | - | - | - | - | - | - | - | - | - | - | - | 5.25 |
| Ultraviolet absorber | Tinuvin 384 | - | 0.15 | - | - | - | - | - | - | - | - | - | - | - | - | - | - | - | - | - | - |
| | Tinuvin 928 | - | - | 0.15 | - | - | - | - | - | - | - | - | - | 0.1 | 0.2 | 0.15 | 0.15 | 0.15 | 0.15 | 0.15 | 0.15 |
| | Tinuvin 400 | - | - | - | 0.15 | - | - | - | - | - | - | - | - | - | - | - | - | - | - | - | - |
| | Tinuvin 405 | - | - | - | - | 0.15 | - | - | - | - | - | - | - | - | - | - | - | - | - | - | - |
| | Tinuvin 460 | - | - | - | - | - | 0.15 | - | - | - | - | - | - | - | - | - | - | - | - | - | - |
| | Tinuvin 479 | - | - | - | - | - | - | 0.15 | - | - | - | - | - | - | - | - | - | - | - | - | - |
| | Uvinul 3035 | - | - | - | - | - | - | - | 0.15 | - | - | - | - | - | - | - | - | - | - | - | - |
| | Uvinul 3039 | - | - | - | - | - | - | - | - | 0.15 | - | - | - | - | - | - | - | - | - | - | - |
| | Uvinul 3030 | - | - | - | - | - | - | - | - | - | 0.15 | - | - | - | - | - | - | - | - | - | - |
| | Uvinul 3049 | - | - | - | - | - | - | - | - | - | - | 0.15 | - | - | - | - | - | - | - | - | - |
| | Uvinul 3050 | - | - | - | - | - | - | - | - | - | - | - | 0.15 | - | - | - | - | - | - | - | - |

[Infrared absorber]

The infrared absorbers described in Table 1 are shown below.

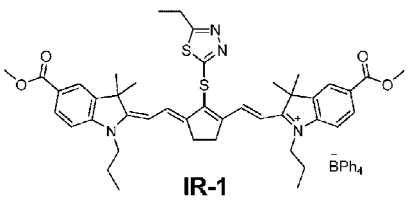
IR-1

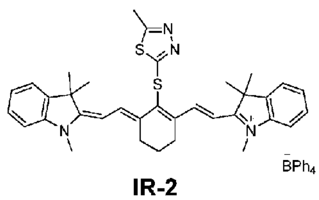
IR-2

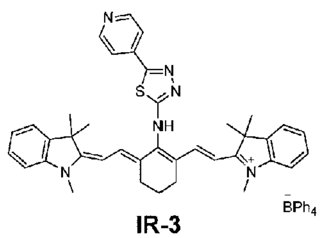
IR-3

[Color forming substance precursor]

The color forming substance precursors shown in Table 1 are described below.

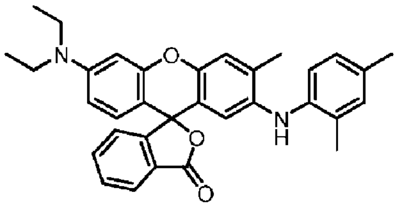

**S-1**

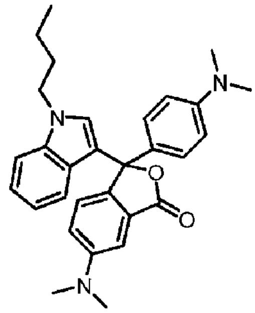

**S-2**

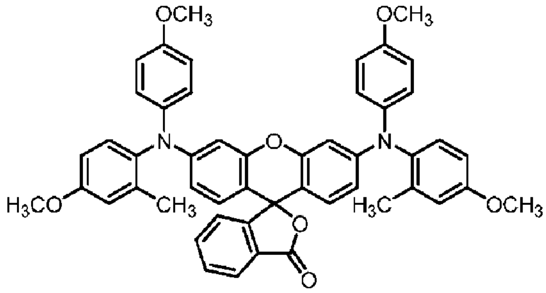

**S-3**

[Polymerizable compound]

The polymerizable compounds shown in Table 1 are described below.

M-1:

A polymerizable compound having a concentration of 80% by mass in a 2-butanone solution, which is obtained by reacting DESMODUR (registered trademark) N100, hydroxyethyl acrylate, and pentatritol acrylate at a molar ratio of 1:1.5:1.5,
(weight-average molecular weight: 1,650).

M-2:
A mixed solution of TAKENATE D-160N (polyisocyanate trimethylolpropane adduct, manufactured by Mitsui Chemicals, Inc., 4.7 parts), ARONIX M-403 (manufactured by Toagosei Company, Limited, amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTAN U-600 (bismuth-based polycondensation catalyst, manufactured by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (M-2) solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight was 14,000.
M-3:
Dipentaerythritol pentaacrylate "Sartmer SR399" (manufactured by Sartomer Company, Inc.)
M-4:
Ethoxylated (4) pentaerythritol tetraacrylate "Sartmer SR494" (manufactured by Sartomer Company, Inc.)
M-5:
NK ESTER A-9300, 40% methyl ethyl ketone solution, manufactured by Shin-Nakamura Chemical Co., Ltd.

[Ultraviolet absorber]

The ultraviolet absorbers shown in Table 1 are described below.

Tinuvin 384 (manufactured by BASF SE)

Tinuvin 928 (manufactured by BASF SE)
Tinuvin 400 (manufactured by BASF SE)
Tinuvin 405 (manufactured by BASF SE)
Tinuvin 460 (manufactured by BASF SE)
Tinuvin 479 (manufactured by BASF SE)
Uvinul 3035 (manufactured by BASF SE)
Uvinul 3039 (manufactured by BASF SE)
Uvinul 3030 (manufactured by BASF SE)
Uvinul 3049 (manufactured by BASF SE)
Uvinul 3050 (manufactured by BASF SE)

All the above-described ultraviolet absorbers are compounds having λmax in a wavelength range of 280 to 400 nm.

<Formation of image-recording layer 20>

The undercoat layer was bar-coated with an image-recording layer coating liquid (20) having the following composition and dried in an oven at 110°C for 40 seconds, thereby forming an image-recording layer 20 having a dry weight of 0.9 $g/m^2$.

(Image-recording layer coating liquid (20))

| | |
|---|---|
| · Infrared absorber (IR-4) (shown below) | 0.0203 parts |
| · Infrared absorber (IR-5) (shown below) | 0.0068 parts |
| · Color forming substance precursor (S-3) | 0.0300 parts |
| · Electron-accepting polymerization initiator (I-3) (shown below) | 0.0981 parts |
| · Borate compound (1) (shown below) | 0.0270 parts |
| · Polymerizable compound (M-1) | 0.3536 parts |
| · Tricresyl phosphate | 0.0125 parts |
| · Anionic surfactant 1 (shown below) | 0.0162 parts |
| · PIONIN A-41-C (manufactured by Takemoto Oil & Fat Co., Ltd., 70% methanol solution) | 0.0081 parts |
| · Fluorine-based surfactant (1) (shown below) | 0.0042 parts |
| · 2-Butanone | 5.3155 parts |
| · 1-Methoxy-2-propanol | 2.8825 parts |
| . Methanol | 2.3391 parts |
| · Microgel liquid | 2.8779 parts |
| · Tinuvin 928 (manufactured by BASF SE) | 0.0300 parts |

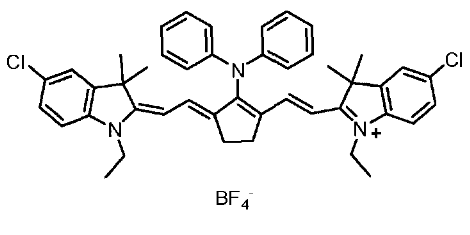

IR-4

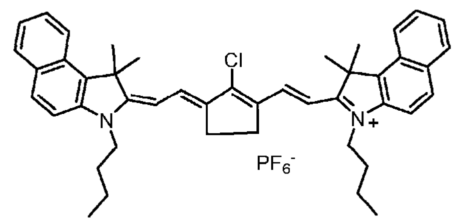

IR-5

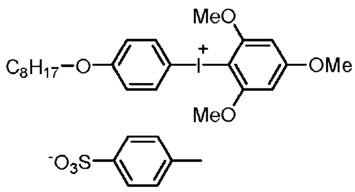

I − 3

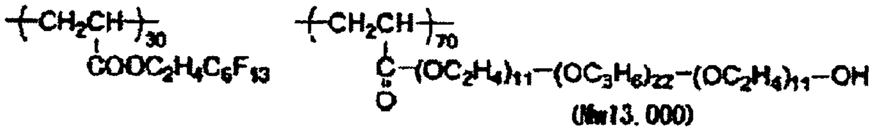

Fluorine-based surfactant (1)

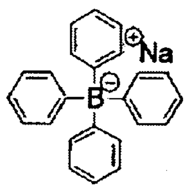

Borate compound (1)

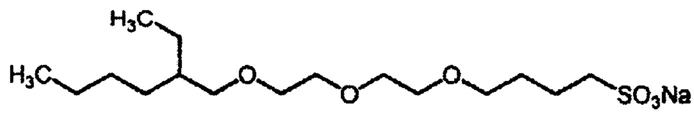

Anionic surfactant 1

(Microgel liquid)

Microgel used in the aforementioned microgel liquid was prepared by the following method.

-Preparation of polyvalent isocyanate compound-

Bismuth tris(2-ethylhexanoate) (NEOSTAN U-600, manufactured by NITTO KASEI CO., LTD., 0.043 parts) was added to an ethyl acetate (25.31 g) suspension solution of 17.78 parts (80 molar equivalents) of isophorone diisocyanate and 7.35 parts (20 molar equivalents) of the following polyhydric phenol compound (1), and the obtained solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

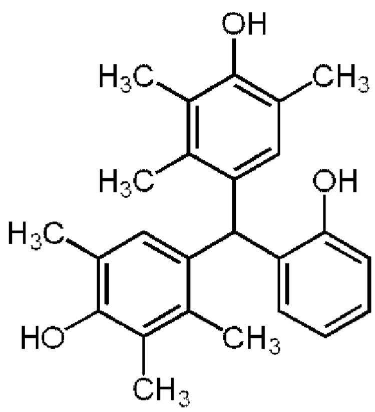

Polyhydric phenol compound (1)

-Preparation of microgel-

The following oil-phase components and water-phase components were mixed together and emulsified at

12,000 rpm for 10 minutes by using a homogenizer. The obtained emulsion was stirred at 45°C for 4 hours, 5.20 g of a 10% by mass aqueous solution of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion of a microgel (1). The average particle diameter thereof measured by a light scattering method was 0.28 μm.

-Oil-phase component-

(Component 1) ethyl acetate: 12.0 parts
(Component 2) an adduct obtained by addition of trimethylolpropane (6 molar equivalents), xylene diisocyanate (18 molar equivalents), and polyoxyethylene having one methylated terminal (1 molar equivalent, the number of repeating oxyethylene units: 90) (50% by mass ethyl acetate solution, manufactured by Mitsui Chemicals, Inc.): 3.76 parts
(Component 3) polyvalent isocyanate compound (1) (as 50% by mass ethyl acetate solution): 15.0 parts
(Component 4) 65% by mass ethyl acetate solution of dipentaerythritol pentaacrylate (SR-399, manufactured by Sartomer Company Inc.): 11.54 parts
(Component 5) 10% ethyl acetate solution of sulfonate type surfactant (PIONIN A-41-C, manufactured by TAKEMOTO OIL & FAT Co., Ltd.): 4.42 parts

-Water-phase component-

Distilled water: 46.87 parts

<Formation of image-recording layer 21>

The undercoat layer was bar-coated with an image-recording layer coating liquid (21) having the following composition and dried in an oven at 120°C for 40 seconds, thereby forming an image-recording layer 21 having a dry weight of 1.0 g/$m^2$.

The image-recording layer coating liquid (21) contains the following components and was prepared by adjusting the solid content to 6% by mass by using a mixed solvent of 1-methoxy-2-propanol (MFG):methyl ethyl ketone (MEK):methanol = 4:4:1 (mass ratio).

| | |
|---|---|
| Electron-accepting polymerization initiator (I-4) | 0.06 parts |
| Infrared absorber IR-6 | 0.026 parts |
| Borate compound (1) | 0.050 parts |
| Polymerizable compound M-1 | 0.50 parts |
| Binder polymer P-2 | 0.15 parts |
| Color forming substance precursor S-4 | 0.03 parts |
| Tinuvin 928 | 0.03 parts |
| Hydrophilic compound T-2 | 0.01 parts |

P-2: Polyvinyl acetal, S-LEC BL10 manufactured by SEKISUI CHEMICAL CO., LTD.

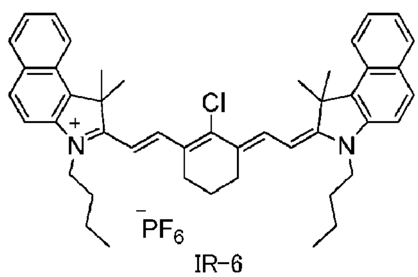

IR-6

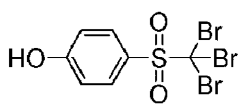

I-4

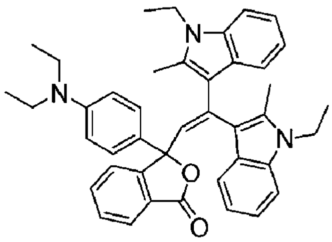

S - 4

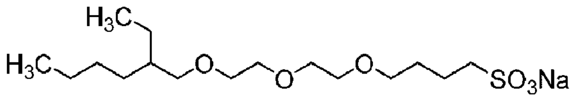 T - 2

The image-recording layers 1 to 22 are uniformly dispersed in water at 20°C. The image-recording layers 1 to 22 have water dispersibility.

<Formation of protective layers 1 to 7>

The image-recording layer was bar-coated with a protective layer coating liquids having the following composition (protective layer coating liquid (1) to (7)), and then dried in an oven at 120°C for 60 seconds, thereby forming a protective layer having a dry coating amount of 0.1 g/$m^2$.

(Protective layer coating liquid)

| | |
|---|---|
| · Water: | 1.0161 parts |
| · METOLOSE SM04 (manufactured by Shin-Etsu Chemical Co., Ltd.): | 0.0600 parts |
| · FS-102 (17% aqueous dispersion liquid) (manufactured by Nipponpaint IndustrialCoatings Co., LTD.): | 0.1177 parts |
| · RAPISOL A-80 (80% aqueous solution) (manufactured by NOF CORPORATION) | 0.0063 parts |
| · Ultraviolet absorber (shown in Table 2) | amount (parts) shown in Table 2 |

[Table 2]

| Table 2 | | Protective layer | | | | | | |
|---|---|---|---|---|---|---|---|---|
| | | 1 | 2 | 3 | 4 | 5 | 6 | 7 |
| Ultraviolet absorber | UVA-805 | 0.03 | - | - | - | - | - | - |
| | Tinuvin 9945-DW(N) | - | 0.03 | - | - | - | - | - |
| | Tinuvin 400-DW(N) | - | - | 0.03 | - | - | - | - |
| | Tinuvin 477-DW(N) | - | - | - | 0.03 | - | - | - |
| | Tinuvin 479-DW(N) | - | - | - | - | 0.03 | - | - |
| | Tinuvin 123-DW(N) | - | - | - | - | - | 0.03 | - |
| | Tinuvin 5333-DW(N) | - | - | - | - | - | - | 0.03 |

[Ultraviolet absorber]

The ultraviolet absorbers shown in Table 2 are described below.

UVA-805 (manufactured by BASF SE)

Tinuvin 9945-DW(N) (manufactured by BASF SE)

Tinuvin 400-DW(N) (manufactured by BASF SE)

Tinuvin 477-DW(N) (manufactured by BASF SE)

Tinuvin 479-DW(N) (manufactured by BASF SE)

Tinuvin 123-DW(N) (manufactured by BASF SE)

Tinuvin 5333-DW(N) (manufactured by BASF SE)

All the above-described ultraviolet absorbers are compounds having λmax in a wavelength range of 280 to 400 nm.

<Formation of protective layer 8>

The image-recording layer was bar-coated with a protective layer coating liquid (8) having the following composition and dried in an oven at 120°C for 60 seconds, thereby forming a protective layer 8 having a dry coating amount of 0.15 g/m$^2$.

(Protective layer coating liquid (8))

| | |
|---|---|
| · Inorganic lamellar compound dispersion (1) (described below): | 1.5 parts |
| · Hydrophilic polymer (1) (the following structure, Mw: 30,000) (solid content): | 0.03 parts |
| · 6% by mass aqueous solution of polyvinyl alcohol (manufactured by NIHON GOSEI KAKO Co.,Ltd., CKS50, modified with sulfonic acid, saponification degree: 99 mol% or more, degree of polymerization: 300): | 0.10 parts |
| · 6% by mass aqueous solution of polyvinyl alcohol (manufactured by KURARAY CO., LTD., PVA-405, saponification degree: 81.5 mol%, degree of 500): | 0.03 parts |
| · Surfactant (EMALEX 710, manufactured by NIHON EMULSION Co., Ltd., the following structure, 1% by mass aqueous solution): | 0.86 parts |
| · Deionized water: | 6.0 parts |

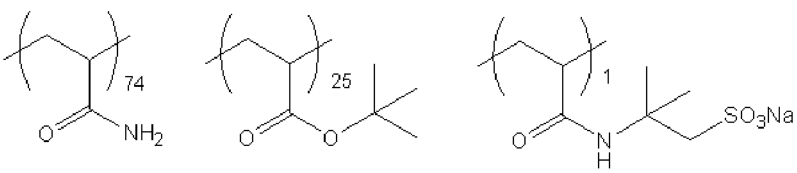

Hydrophilic polymer (1)

$C_{12}H_{25}-(OCHCH_2)_{10}-OH$

EMALEX 710

(Preparation of inorganic lamellar compound dispersion (1))

Synthetic mica SOMASIF ME-100 manufactured by Co-op Chemical Co., Ltd., 6.4 parts) was added to 193.6 parts of deionized water and was dispersed using a homogenizer until the volume average particle diameter (the laser scattering method) reached 3 μm. The aspect ratio of the obtained dispersed particles was 100 or more.

<Formation of protective layer 9>

The image-recording layer was bar-coated with a protective layer coating liquid (9) having the following composition and dried in an oven at 120°C for 60 seconds, thereby forming a protective layer 9 having a dry coating amount of 0.15 g/m$^2$.

The protective layer coating liquid (9) contains the following components, and was prepared by adjusting the solid content to 6% by mass by using deionized water.

| | |
|---|---|
| · Discoloring compound A | 0.02 parts |
| · Hydrophilic polymer WP-1 | 0.70 parts |
| · Hydrophilic polymer WP-2 | 0.20 parts |
| · Hydrophilic polymer WP-3 | 0.20 parts |
| · Surfactant | 0.002 parts |

WP-1: Polyvinyl alcohol, manufactured by Sigma-Aldrich Co. LLC., Mowiol 4-88
WP-2: Polyvinyl alcohol, manufactured by Sigma-Aldrich Co. LLC., Mowiol 8-88
WP-3: The following resin (Mw: 52,000)
Surfactant: Anionic surfactant, RAPISOL A-80, manufactured by NOF CORPORATION.

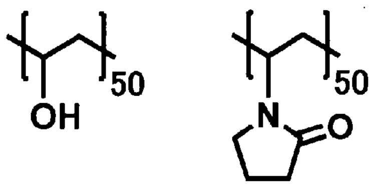

WP - 3

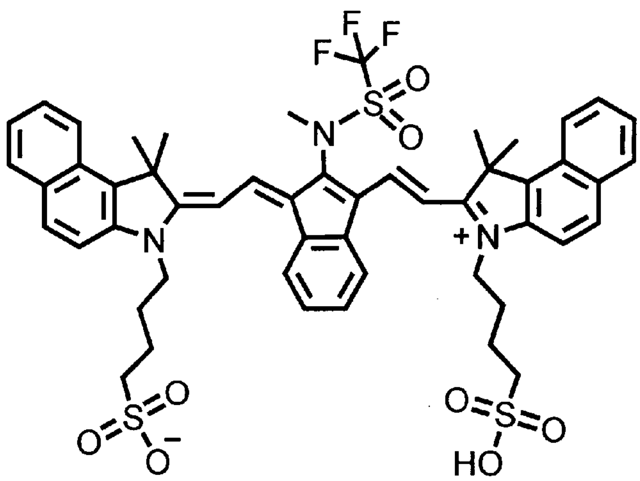

A

<Formation of protective layer 10>

The image-recording layer was bar-coated with a protective layer coating liquid (10) having the following composition and dried in an oven at 120°C for 60 seconds, thereby forming a protective layer 10 having a dry coating amount of 0.1 g/m$^2$.

(Protective layer coating liquid (10))

| | |
|---|---|
| · Water: | 1.0161 parts |
| · METOLOSE SM04 (manufactured by Shin-Etsu Chemical Co., Ltd.): | 0.0600 parts |
| · FS-102 (17% aqueous dispersion liquid) (manufactured by Nipponpaint Industrial Coatings Co., LTD.): | 0.1177 parts |
| · RAPISOL A-80 (80% aqueous solution) (manufactured by NOF CORPORATION): | 0.0063 parts |

[Preparation of lithographic printing plate precursor]

The support, the undercoat layer, the image-recording layer, and the protective layer were combined as shown

in Table 3, thereby preparing lithographic printing plate precursors of Examples 1 to 29 and Comparative Examples 1 and 2.

In a case where the each image-recording layer was exposed to an infrared laser having a wavelength of 830 nm at an energy density of 120 $mJ/cm^2$, a loss of ethylenically unsaturated bonds in an exposed region in the image-recording layer with respect to a loss of ethylenically unsaturated bonds in a non-exposed region in the image-recording layer is described in Table 3 as "loss of ethylenically unsaturated bonds during exposure to an infrared laser". A measuring method will be described below.

<Loss of ethylenically unsaturated bonds during exposure to infrared laser>

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 120 $mJ/cm^2$. The exposed image includes a solid image and a non-image area.

Next, using a Fourier transform infrared spectrophotometer (FT-IR) "FT-720" manufactured by HORIBA, Ltd., the peak surface area in the vicinity of 1,410 $cm^{-1}$ derived from the ethylenically unsaturated group were determined for the solid image area and the non-image area. Here, the support of each lithographic printing plate is used as a background. In a case where the peak surface area of the solid image area is defined as S1 and the peak surface area of the non-image area is defined as S2, a loss of ethylenically unsaturated bonds R1 [%] is determined by Expression (1).

$$R1 = [1 - (S1/S2)] \times 100 \cdots (1)$$

In a case where the each image-recording layer is exposed to a white fluorescent lamp having an illuminance of 600 Lux for 1 hour, the loss of ethylenically unsaturated bonds in the exposed region with respect to a loss of ethylenically unsaturated bonds in the non-exposed region is described in Table 3 as "loss of ethylenically unsaturated bonds during exposure to a white lamp". A measuring method will be described below.

<Loss of ethylenically unsaturated bonds during exposure to white lamp>

The obtained lithographic printing plate precursor is exposed to a white fluorescent lamp such that the illuminance on the plate surface is 600 Lux. After the exposure for 1 hour, using a Fourier transform infrared spectrophotometer (FT-IR) "FT-720" manufactured by HORIBA, Ltd., the peak surface area in the vicinity of 1,410 $cm^{-1}$ derived from the ethylenically unsaturated group were determined for the exposed portion and the non-exposed portion. Here, the support of each lithographic printing plate is used as a background. In a case where the peak surface area of the exposed portion is defined as S3 and the peak surface area of the non-exposed portion is defined as S4, a loss of ethylenically unsaturated bonds R2 [%] is determined by Expression (2).

$$R2 = [1 - (S3/S4)] \times 100 \cdots (2)$$

The hydrogen abstraction enthalpy of all hydrogen atoms present in the molecule of the color forming substance precursor is shown in Table 3 as "hydrogen abstraction enthalpy of color forming substance precursor".

The hydrogen abstraction enthalpy of all hydrogen atoms present in a molecule of the color forming substance precursor is calculated by the above-described method.

[Table 3]

| Table 3 | Support | Undercoat layer | Image-developing layer | Protective layer | Physical property value | | | Development delay | Printing durability | Color developability |
|---|---|---|---|---|---|---|---|---|---|---|
| | No. | No. | No. | No. | Loss of ethylenically unsaturated bonds during exposure to infrared rays (%) | Loss of ethylenically unsaturated bonds during exposure to white lamp (%) | Hydrogen abstraction enthalpy of color forming precursor (kcal/mol) | | | |
| Example 1 | 1 | 1 | 1 | 1 | 25 | 3 | -10.5 | 5 | 4 | 6.5 |
| Example 2 | 1 | 1 | 1 | 2 | 25 | 3 | -10.5 | 5 | 4 | 6.5 |
| Example 3 | 1 | 1 | 1 | 3 | 25 | 5 | -10.5 | 4 | 4 | 6.5 |
| Example 4 | 1 | 1 | 1 | 4 | 25 | 5 | -10.5 | 4 | 4 | 6.5 |
| Example 5 | 1 | 1 | 1 | 5 | 25 | 5 | -10.5 | 4 | 4 | 6.5 |
| Example 6 | 1 | 1 | 1 | 6 | 25 | 5 | -10.5 | 4 | 4 | 6.5 |
| Example 7 | 1 | 1 | 1 | 7 | 25 | 5 | -10.5 | 4 | 4 | 6.5 |
| Example 8 | 1 | 1 | 2 | Absent | 20 | 3 | -10.5 | 5 | 4 | 5.7 |
| Example 9 | 1 | 1 | 3 | Absent | 20 | 3 | -10.5 | 5 | 4 | 5.7 |
| Example 10 | 1 | 1 | 4 | Absent | 20 | 5 | -10.5 | 4 | 4 | 5.7 |
| Example 11 | 1 | 1 | 5 | Absent | 20 | 5 | -10.5 | 4 | 4 | 5.7 |
| Example 12 | 1 | 1 | 6 | Absent | 20 | 5 | -10.5 | 4 | 4 | 5.7 |
| Example 13 | 1 | 1 | 7 | Absent | 20 | 5 | -10.5 | 4 | 4 | 5.7 |
| Example 14 | 1 | 1 | 8 | Absent | 20 | 5 | -10.5 | 4 | 4 | 5.7 |
| Example 15 | 1 | 1 | 9 | Absent | 20 | 5 | -10.5 | 4 | 4 | 5.7 |
| Example 16 | 1 | 1 | 10 | Absent | 20 | 5 | -10.5 | 4 | 4 | 5.7 |
| Example 17 | 1 | 1 | 11 | Absent | 20 | 5 | -10.5 | 4 | 4 | 5.7 |
| Example 18 | 1 | 1 | 12 | Absent | 20 | 5 | -10.5 | 4 | 4 | 5.7 |
| Example 19 | 1 | 1 | 13 | Absent | 20 | 7 | -10.5 | 3 | 4 | 5.7 |

(continued)

| Table 3 | Support | Undercoat layer | Image-developing layer | Protective layer | Physical property value | | | Development delay | Printing durability | Color developability |
|---|---|---|---|---|---|---|---|---|---|---|
| | No. | No. | No. | No. | Loss of ethylenically unsaturated bonds during exposure to infrared rays (%) | Loss of ethylenically unsaturated bonds during exposure to white lamp (%) | Hydrogen abstraction enthalpy of color forming precursor (kcal/mol) | | | |
| Example 20 | 1 | 1 | 14 | Absent | 15 | 5 | -10.5 | 5 | 3 | 5.7 |
| Example 21 | 1 | 1 | 15 | Absent | 20 | 3 | -10.5 | 5 | 3 | 5.7 |
| Example 22 | 1 | 1 | 16 | Absent | 20 | 3 | -10.5 | 5 | 5 | 5.7 |
| Example 23 | 1 | 1 | 17 | Absent | 20 | 4 | -6.2 | 5 | 5 | 9.0 |
| Example 24 | 1 | 1 | 18 | Absent | 20 | 3 | 6.5 | 5 | 5 | 9.0 |
| Example 25 | 1 | 1 | 19 | Absent | 20 | 5 | -10.5 | 4 | 4 | 5.7 |
| Example 26 | 2 | 1 | 3 | Absent | 20 | 3 | -10.5 | 5 | 4 | 5.7 |
| Example 27 | 3 | 1 | 3 | Absent | 20 | 3 | -10.5 | 5 | 4 | 5.7 |
| Example 28 | 4 | 2 | 20 | 8 | 15 | 4 | 6.5 | 5 | 5 | 5.7 |
| Example 29 | 5 | Absent | 21 | 9 | 15 | 3 | -3.4 | 5 | 5 | 5.7 |
| Comparative Example 1 | 1 | 1 | 1 | 10 | 25 | 15 | -10.5 | 2 | 5 | 5.7 |
| Comparative Example 2 | 1 | 1 | 22 | Absent | 8 | 5 | -10.5 | 4 | 2 | 5.7 |

<Printing durability evaluation>

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 120 mJ/cm$^2$. The exposed image had a solid image, a 50% halftone dot chart of an AM screen, and a non-image area.

The lithographic printing plate precursor having undergone image exposure was mounted on an offset rotary printer manufactured by TOKYO KIKAI SEISAKUSHO, LTD., and printing was performed on 150,000 sheets of newsprints at a speed of 100,000 sheets/hour by using SOYBI KKST-S (red) manufactured by Inktech Corporation as a printing ink for newspaper and TOYO ALKY manufactured by TOYO INK CO., LTD. as dampening water.

As the number of printed sheets increased, the image-recording layer was gradually worn and the ink receiving property was degraded, and thus the ink density on the printing paper decreased. The state thereof was visually checked.

5: There is almost no change from the case of 10,000 sheets
4: The image remains at about 70% compared to the case of 10,000 sheets
3: The image remains at about 50% compared to the case of 10,000 sheets
2: The image remains at about 20% compared with the case of 10,000 sheets
1: Substantially no ink remains.

<Color formability (visibility) evaluation>

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 120 mJ/cm$^2$. The exposed image includes a solid image and a non-image area. The exposure was carried out in an environment of 25°C and 50% RH.

Immediately after exposure, the color formment of the lithographic printing plate precursor was measured. The measurement was performed by the specular component excluded (SCE) method by using a spectrocolorimeter CM2600d and operation software CM-S100W manufactured by Konica Minolta, Inc. The color formability is evaluated based on a difference ΔL between the L* value of the exposed portion and the L* value of the non-exposed portion using the L* value (brightness) of the L*a*b* color system. It can be said that the larger the value of ΔL', the better the color formability.

<Suppression of development delay>

The suppression of the development delay was evaluated as safety under a white lamp fluorescent lamp as follows (white lamp safety).

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 120 mJ/cm$^2$. The exposed image had a solid image, a 50% halftone dot chart of an AM screen, and a non-image area. Then, the lithographic printing plate precursor having been exposed to a white fluorescent lamp such that the illuminance on the plate surface was 600 Lux was mounted on an offset rotary printer manufactured by TOKYO KIKAI SEISAKUSHO, LTD., and on-press development was performed on newsprints at a speed of 100,000 sheets/hour by using SOYBI KKST-S (red) manufactured by Inktech Corporation as a printing ink for newspaper and ALKY manufactured by TOYO INK CO., LTD. as dampening water. The number of sheets in which on-press development was completed in both the 50% halftone dot area and the non-image area was counted.

In a case where the number of developed sheets of lithographic printing plate precursors having been exposed to a white lamp for 3 hours after exposure was defined as N1, the number of developed sheets of lithographic printing plate precursors not having been exposed to a white lamp after exposure was defined as N2, and N1 - N2 = Δ, evaluation was performed according to the following standard.

5:

$$\Delta N = 0$$

4:

$$1 \leq \Delta N \leq 10$$

3:

$$11 \leq \Delta N \leq 20$$

2:

$$21 \leq \Delta N \leq 30$$

1:

$$31 \leq \Delta N$$

As shown in the results shown in Table 3, according to the on-press developable lithographic printing plate precursor according to the embodiment of the present invention, color formability is excellent and development delay can be suppressed.

In addition, it has been confirmed that according to the on-press developable lithographic printing plate precursor according to the embodiment of the present invention, color formability is excellent, development delay is suppressed, and further printing durability is excellent.

<Cutting of lithographic printing plate precursor>

Lithographic printing plate precursors of Examples 30 to 33 were prepared in the same manner as in the lithographic printing plate precursor of Example 9. The lithographic printing plate precursors of Example 9 and Examples 30 to 33 are the same.

The lithographic printing plate precursors of Examples 9 and 30 to 33 were cut using the rotary blades shown in Fig. 4 with adjusting the gap between the upper cutting blade and the lower cutting blade, intrusion amounts of the blades, and tip angle of the blades, thereby forming the shear droop shape at the end part.

Table 4 shows a shear droop amount X and a shear droop width Y of the shear droop shape.

<Formation of edge layer 1>

Coating with the composition 1 was performed under the following coating condition 1, thereby forming an edge layer 1.

(Coating condition 1)

Coating was performed by the coating method shown in Fig. 7. The wire bar was installed such that it was perpendicular to the lithographic printing plate precursor ($\theta = 0°$), and coating was performed. The coating was carried out by the following procedure.

[1] HN-GV (manufactured by FUJIFILM Global Graphic Systems Co. Ltd.) was uniformly added dropwise to an area of 1 $cm^3$ of the #10 wire bar.
[2] The wire bar was moved at 20 mm/s along the lateral surface of the lithographic printing plate precursor. At this time, the wire bar was installed such that it was perpendicular to the lithographic printing plate precursor ($\theta = 0°$).
[3] The lithographic printing plate precursor was dried by being exposed to air of 80°C at 6 m/s for 30 seconds.
[4] Only the lateral surface of the lithographic printing plate precursor could be coated. At this time, the coating amount of the composition 1 was 120 $mg/m^2$.
[5] A variation Z in the coating width from the end part of the lithographic printing plate precursor was Z = 0.1 mm.

The composition 1 contains the following components.

| | |
|---|---|
| · Deionized water | 75.00 parts |
| · Penon JE66*1 | 12.95 parts |
| · NISSAN ANON BDF-SF*2 | 9.50 parts |
| · Sodium hexametaphosphate | 2.50 parts |
| · Bioden ZNS*3 | 0.05 parts |

*1: Etherified starch (Nippon Starch Chemical Co., Ltd.)
*2: Cocamidopropyl betaine (NOF Corporation)
*3: Disinfectant or biobactericide (Daiwa Chemical Industries Corporation)

The variation Z is obtained based on [0186] and [0187] of JP6628949B.
The lithographic printing plate precursor with an end part having a shear droop shape and the edge layer were combined as shown in Table 4, thereby preparing a lithographic printing plate precursor for measuring edge contamination preventiveness.
The edge contamination preventiveness was evaluated as follows.

<Edge contamination preventiveness>

Each of the obtained lithographic printing plate precursors was exposed by Luxcel PLATESETTER T-6000III (manufactured by Fujifilm Corporation) equipped with an infrared semiconductor laser under conditions of an external drum rotation speed of 1000 rpm, a laser output of 70%, and a resolution of 2400 dpi. As the exposure image, a chart including a solid image, 50% halftone dots, and a non-image area was used.
The lithographic printing plate precursor having undergone image exposure was mounted on an offset rotary printer manufactured by TOKYO KIKAI SEISAKUSHO, LTD., and printing was performed on newsprints at a speed of 100,000 sheets/hour by using SOYBI KKST-S (red) manufactured by Inktech Corporation as a printing ink for newspaper and ALKY manufactured by TOYO INK CO., LTD. as dampening water. The 1,000th printed matter was sampled with a water level gauge 1.1 times the water level gauge for removing scumming, and the degree of linear contamination caused by the end part of the lithographic printing plate precursor was evaluated based on the following standard. The results are shown in Table 4 as an edge contamination preventiveness.

5: No contamination
4: Intermediate level between 5 and 3
3: Contamination has slightly occurred but is at an acceptable level.
2: Intermediate level between 3 and 1 (acceptable level)
1: Marked contamination which is at an unacceptable level

[Table 4]

| Example | Support | Undercoat | Image-developing layer | Protective layer | Shear droop width X [μm] | Shear droop width Y [μm] | Edge layer | Edge contamination |
|---|---|---|---|---|---|---|---|---|
| 9 | 1 | 1 | 3 | Absent | 15 | 50 | Absent | 2 |
| 30 | 1 | 1 | 3 | Absent | 55 | 130 | Absent | 3 |
| 31 | 1 | 1 | 3 | Absent | 55 | 130 | 1 | 5 |
| 32 | 1 | 1 | 3 | Absent | 30 | 100 | 1 | 4 |
| 33 | 1 | 1 | 3 | Absent | 70 | 150 | 1 | 5 |

It has been confirmed that using the lithographic printing plate precursor having a predetermined shear droop shape results in excellent edge contamination properties.
According to the present invention, an on-press development type lithographic printing plate precursor having excellent color formability, and suppressed development delay, and a method of preparing a printing plate using the on-press development type lithographic printing plate precursor can be provided.

In addition, according to the present invention, an on-press development type lithographic printing plate precursor having excellent color formability, suppressed development delay, and further excellent printing durability, and a method of preparing a printing plate using the on-press development type lithographic printing plate precursor can be provided.

The present invention has been described in detail with reference to specific embodiments. To those skilled in the art, it is obvious that various changes or modifications can be added without departing from the gist and scope of the present invention.

The present application is based on Japanese Patent Application (JP2021-142007) filed on August 31, 2021, the contents of which are incorporated herein by reference.

Explanation of References

1: lithographic printing plate precursor
1a: image-recording layer surface
1b: support surface
1c: edge surface
2: shear droop
10: cutting blade
10a: upper cutting blade
10b: upper cutting blade
11: rotary shaft
20: cutting blade
20a: lower cutting blade
20b: lower cutting blade
21: rotary shaft
30: lithographic printing plate precursor
31: aluminum plate
32, 34: roller-shaped brush
33: abrasive slurry
35, 36, 37, 38: support roller
50: main electrolytic cell
51: alternating current power source
52: radial drum roller
53a, 53b: main pole
54: electrolytic solution supply port
55: electrolytic solution
56: slit
57: electrolytic solution channel
58: auxiliary anode
60: auxiliary anode tank
410: anodization treatment device
412: power supply tank
414: electrolytic treatment cell
416: aluminum plate
418, 426: electrolytic solution
420: power supply electrode
422, 428: roller
424: nip roller
430: electrolysis electrode
432: cell wall
434: direct current power source
B: boundary between image-recording layer surface and support
W: aluminum plate
X: shear droop amount
Y: shear droop width
100a: lithographic printing plate precursor

120: edge surface
122: outermost layer surface 122 on image-recording layer side with reference to support
138: wire bar
θ: angle

## Claims

1. An on-press development type lithographic printing plate precursor comprising, in the following order:

   a support;
   an image-recording layer; and
   a protective layer,
   wherein the image-recording layer contains a) a polymerizable compound, b) an infrared absorber, c) a polymerization initiator, and d) a color forming substance precursor, and
   the protective layer contains an ultraviolet absorber.

2. An on-press development type lithographic printing plate precursor comprising, in the following order:

   a support; and
   an image-recording layer,
   wherein the image-recording layer contains a) a polymerizable compound, b) an infrared absorber, c) a polymerization initiator, d) a color forming substance precursor, and e) an ultraviolet absorber, and
   the polymerizable compound has 4 or more functionalities and has a molecular weight of less than 15,000.

3. An on-press development type lithographic printing plate precursor comprising, in the following order:

   a support;
   an image-recording layer; and
   a protective layer,
   wherein the image-recording layer contains a) a polymerizable compound, b) an infrared absorber, c) a polymerization initiator, and d) a color forming substance precursor,
   the protective layer contains an ultraviolet absorber,
   in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer, and
   in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

4. An on-press development type lithographic printing plate precursor comprising, in the following order:

   a support; and
   an image-recording layer,
   wherein the image-recording layer contains a) a polymerizable compound, b) an infrared absorber, c) a polymerization initiator, d) a color forming substance precursor, and e) an ultraviolet absorber,
   in a case where the image-recording layer is exposed to an infrared laser having a wavelength of 830 nm at an energy density of 120 $mJ/cm^2$, a loss of ethylenically unsaturated bonds in an exposed region in the image-recording layer is 10% or more with respect to a loss of ethylenically unsaturated bonds in a non-exposed region in the image-recording layer, and
   in a case where the image-recording layer is exposed to a white fluorescent lamp having an illuminance of 600 Lux for 1 hour, a loss of ethylenically unsaturated bonds in an exposed region in the image-recording layer is less than 10% with respect to a loss of ethylenically unsaturated bonds in a non-exposed region in the image-recording layer.

5. The on-press development type lithographic printing plate precursor according to any one of claims 1 to 4,

wherein the ultraviolet absorber has λmax at a wavelength of 280 to 400 nm.

**6.** The on-press development type lithographic printing plate precursor according to any one of claims 1 to 4, wherein the image-recording layer contains, as the polymerizable compound, a polymerizable compound having 7 or more functionalities and having a molecular weight of less than 15,000.

**7.** The on-press development type lithographic printing plate precursor according to any one of claims 1 to 4, wherein the image-recording layer contains, as the polymerizable compound, a polymerizable compound having 10 or more functionalities and having a molecular weight of less than 15,000.

**8.** The on-press development type lithographic printing plate precursor according to any one of claims 1 to 4, wherein the image-recording layer contains polymer particles.

**9.** The on-press development type lithographic printing plate precursor according to claim 8, wherein the polymer particles have a hydrophobic main chain, and include both of

i) a constituent unit having a pendant cyano group directly bonded to the hydrophobic main chain, and
ii) a constituent unit having a pendant group that contains a hydrophilic poly(alkylene oxide) segment.

**10.** The on-press development type lithographic printing plate precursor according to claim 8, wherein the polymer particles are obtained by a reaction of a polyvalent isocyanate compound that is an adduct of a polyhydric phenol compound having two or more hydroxy groups in a molecule of the polyhydric phenol compound and isophorone diisocyanate, with a compound having active hydrogen.

**11.** The on-press development type lithographic printing plate precursor according to any one of claims 1 to 4, wherein a hydrogen abstraction enthalpy of all hydrogens present in a molecule of the color forming substance precursor is -6.5 kcal/mol or more.

**12.** The on-press development type lithographic printing plate precursor according to any one of claims 1 to 4, wherein the color forming substance precursor has a tertiary amine structure.

**13.** The on-press development type lithographic printing plate precursor according to any one of claims 1 to 4, wherein the color forming substance precursor includes an acid color forming agent.

**14.** The on-press development type lithographic printing plate precursor according to any one of claims 1 to 4,

wherein the support has an anodic oxide film,
micropores in the anodic oxide film of the support are each composed of a large diameter portion that extends to a position at a depth of 10 nm to 1,000 nm from a surface of the anodic oxide film and a small diameter portion that is in communication with a bottom portion of the large diameter portion and that extends to a position at a depth of 20 nm to 2,000 nm from the communicate position,
an average diameter of the large diameter portion at the surface of the anodic oxide film is 15 nm to 100 nm, and an average diameter of the small diameter portion at the communicate position is 15 nm or less.

**15.** The on-press development type lithographic printing plate precursor according to any one of claims 1 to 4,

wherein the support has an anodic oxide film,
micropores in the anodic oxide film of the support each composed of a small diameter portion that extends to a position at a depth of 10 nm to 1,000 nm from a surface of the anodic oxide film and a large diameter portion that is in communication with a bottom portion of the small diameter portion and that extends to a position at a depth of 20 nm to 2,000 nm from the communicate position,
an average diameter of the small diameter portion at the surface of the anodic oxide film is 35 nm or less, and an average diameter of the large diameter portion is 40 to 300 nm.

**16.** The on-press development type lithographic printing plate precursor according to any one of claims 1 to 4,

wherein the support has an anodic oxide film, and
the anodic oxide film comprises, in order from a surface of the anodic oxide film along a depth direction,

an upper layer that has a thickness of 30 to 500 nm and that has micropores having an average diameter of 20 to 100 nm,
an interlayer that has a thickness of 100 to 300 nm and that has micropores having an average diameter which is 1/2 to 5 times the average diameter of the micropores in the upper layer, and
an under layer that has a thickness of 300 to 2,000 nm and that has micropores having an average diameter of 15 nm or less.

**17.** The on-press development type lithographic printing plate precursor according to any one of claims 1 to 4, wherein an end part of the lithographic printing plate precursor has a shear droop shape having a shear droop amount X of 25 to 150 μm and a shear droop width Y of 70 to 300 μm.

**18.** The on-press development type lithographic printing plate precursor according to claim 17, wherein an ink repellent is provided on a part or all of two opposing lateral surfaces of the lithographic printing plate precursor.

**19.** A method of preparing a printing plate, comprising:

a step of image-exposing the on-press development type lithographic printing plate precursor according to any one of claims 1 to 4; and
a step of supplying at least any one of printing ink or dampening water on a printer to remove a non-exposed portion of the image-recording layer in the on-press development type lithographic printing plate precursor.

FIG. 1

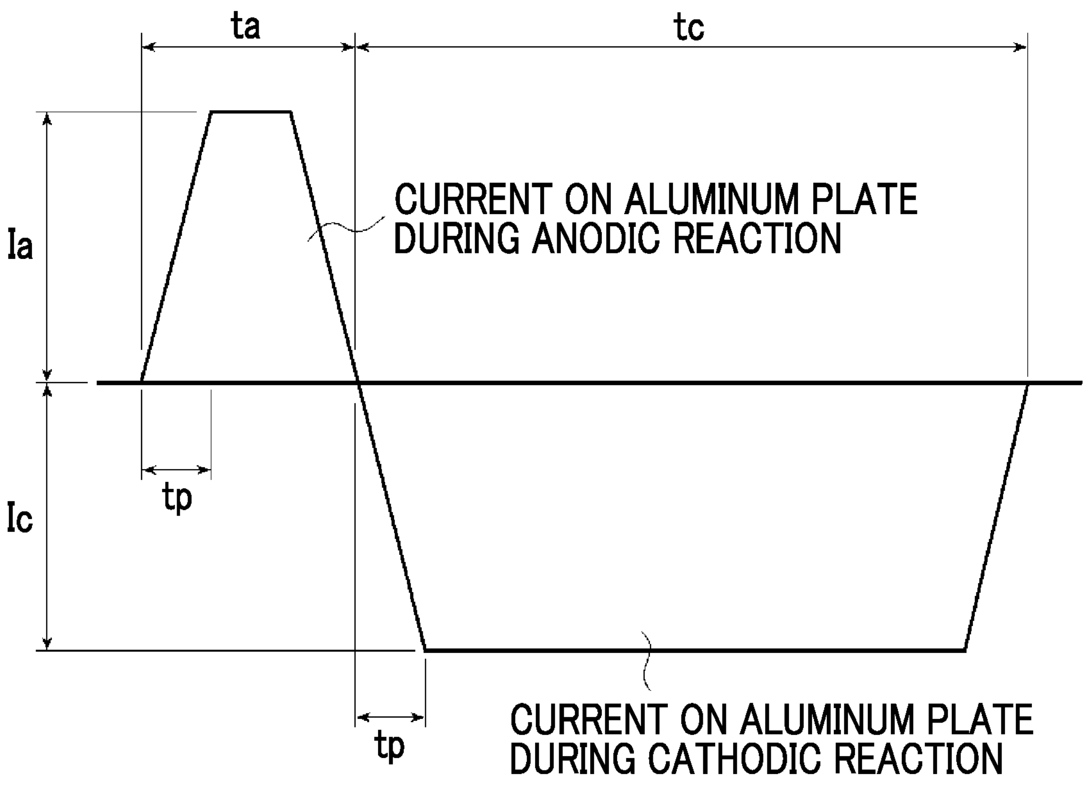
ta
tc
Ia
Ic
tp
tp
CURRENT ON ALUMINUM PLATE DURING ANODIC REACTION
CURRENT ON ALUMINUM PLATE DURING CATHODIC REACTION

FIG. 2

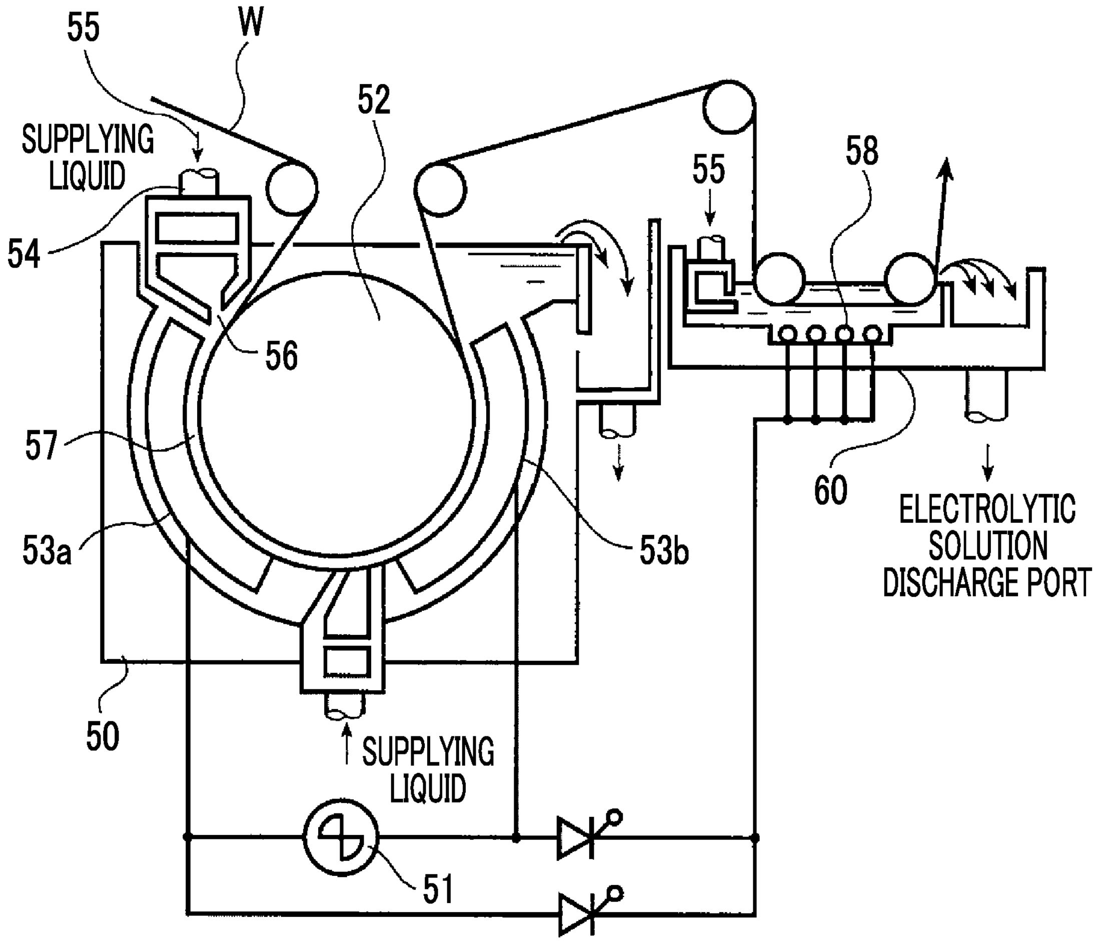
55
W
52
SUPPLYING LIQUID
54
55
58
56
57
53a
53b
60
ELECTROLYTIC SOLUTION DISCHARGE PORT
50
SUPPLYING LIQUID
51

FIG. 3

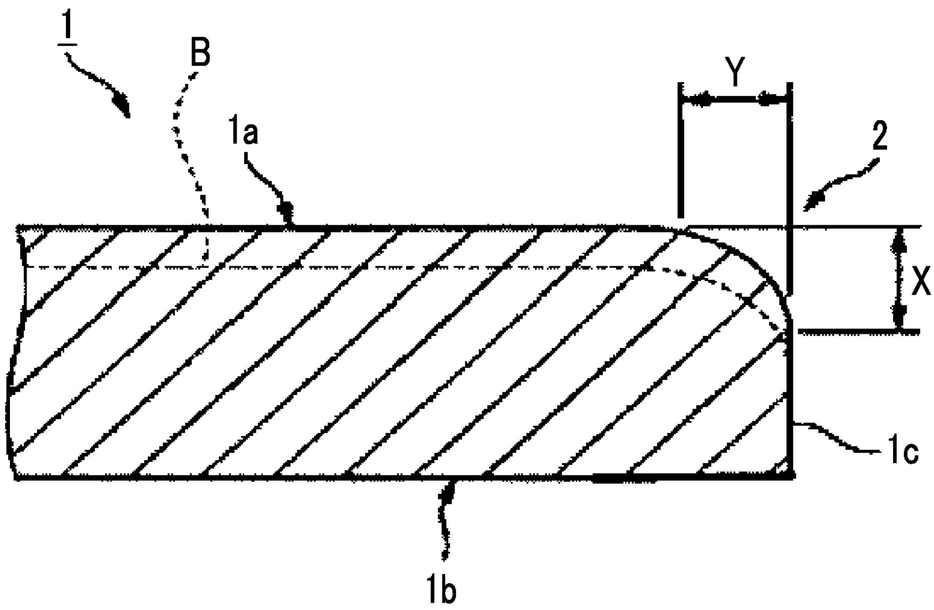
1
B
1a
Y
2
X
1c
1b

FIG. 4

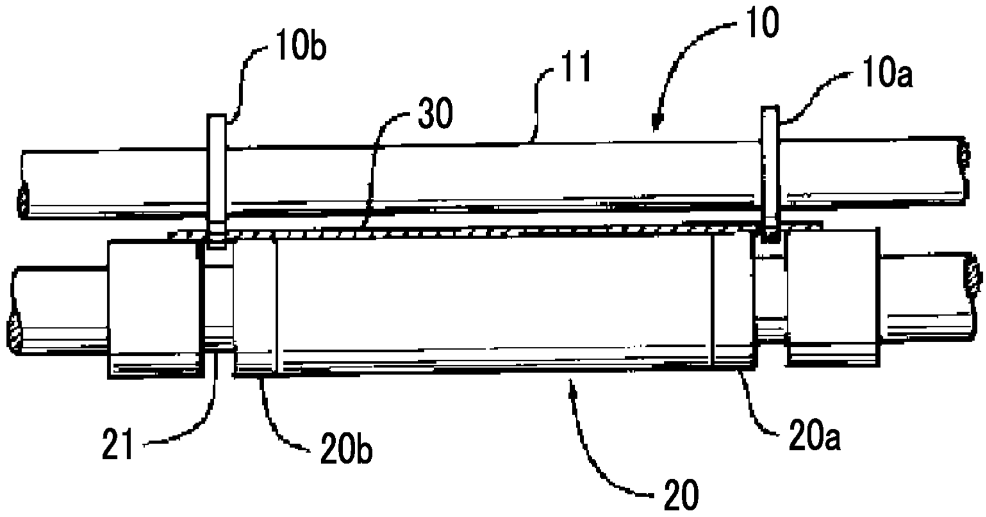


FIG. 5

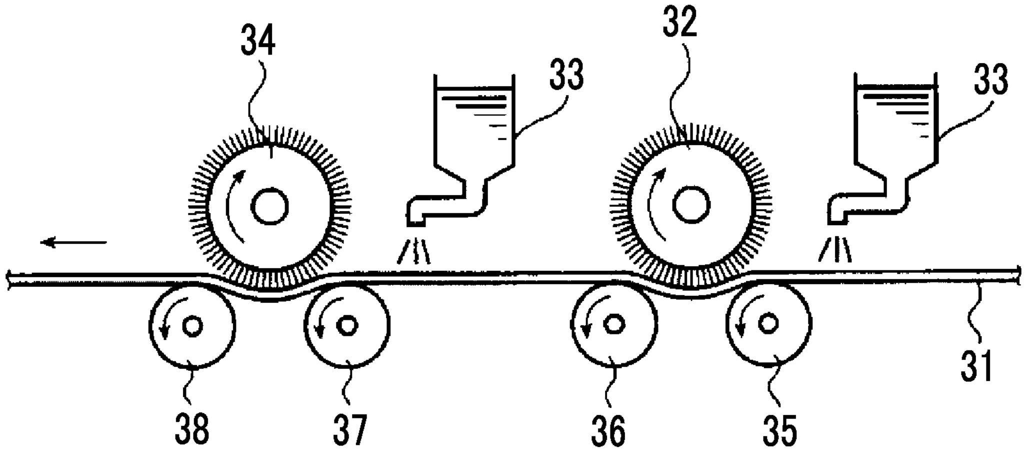

FIG. 6

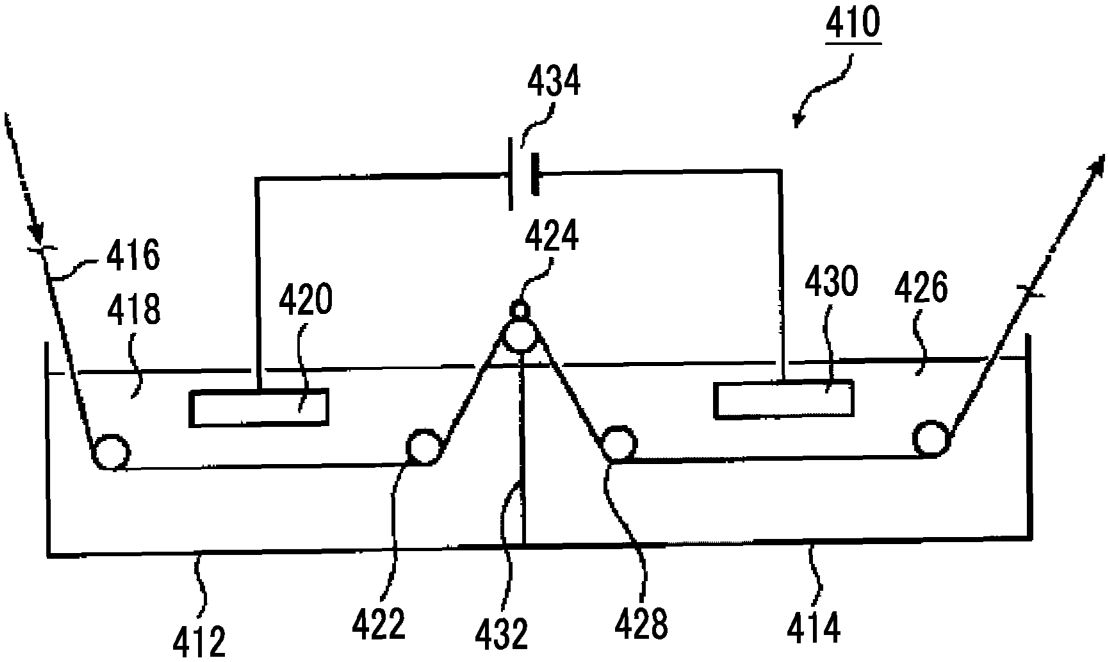
410
434
424
416
418
420
430
426
412
422
432
428
414

FIG. 7

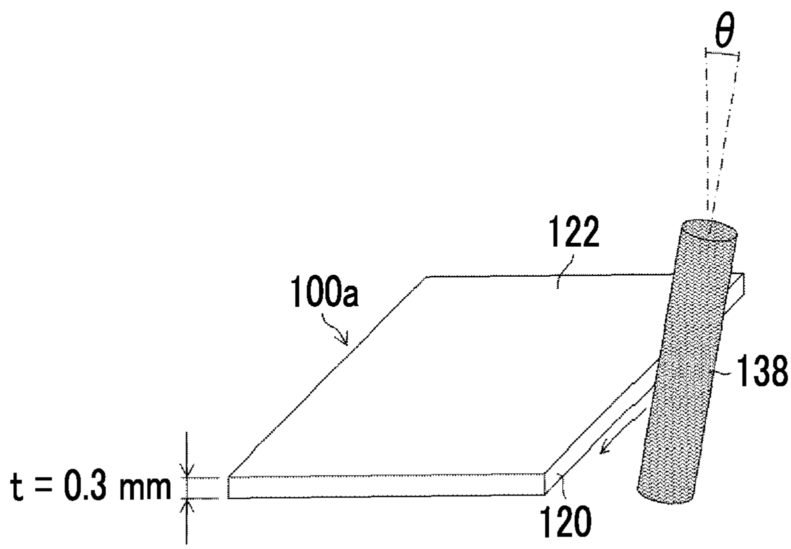
θ
122
100a
138
t = 0.3 mm
120

## INTERNATIONAL SEARCH REPORT

International application No. **PCT/JP2022/032297**

**A. CLASSIFICATION OF SUBJECT MATTER**

***B41N 1/14***(2006.01)i; ***B41C 1/10***(2006.01)i; ***G03F 7/00***(2006.01)i; ***G03F 7/004***(2006.01)i; ***G03F 7/027***(2006.01)i; ***G03F 7/09***(2006.01)i; ***G03F 7/11***(2006.01)i

FI: B41N1/14; B41C1/10; G03F7/00 503; G03F7/004 505; G03F7/004 507; G03F7/004 501; G03F7/11 501; G03F7/027; G03F7/09

According to International Patent Classification (IPC) or to both national classification and IPC

**B. FIELDS SEARCHED**

Minimum documentation searched (classification system followed by classification symbols)

B41N1/14; B41C1/10; G03F7/00; G03F7/004; G03F7/027; G03F7/09; G03F7/11

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2020/262691 A1 (FUJIFILM CORPORATION) 30 December 2020 (2020-12-30) claims 1-43, paragraphs [0566]-[0731] | 1-19 |
| Y | WO 2007/123031 A1 (KONICA MINOLTA MEDICAL & GRAPHIC, INCORPORATED) 01 November 2007 (2007-11-01) claims 1-3, paragraphs [0163]-[0202] | 1, 3, 5-19 |
| Y | JP 2011-73213 A (FUJIFILM CORPORATION) 14 April 2011 (2011-04-14) claims 1-7, paragraphs [0189]-[0241] | 2, 4-19 |
| Y | US 2021/0094336 A1 (EASTMAN KODAK COMPANY) 01 April 2021 (2021-04-01) claims 1-21, paragraph [0264] | 16 |
| Y | WO 2019/188910 A1 (FUJIFILM CORPORATION) 03 October 2019 (2019-10-03) claim 1, paragraph [0045] | 17-18 |
| A | US 2009/0269699 A1 (MUNNELLY, Heidi M. et al.) 29 October 2009 (2009-10-29) whole document | 1-19 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 October 2022** | **01 November 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/032297**

| Patent document cited in search report | Publication date (day/month/year) | Patent family member(s) | Publication date (day/month/year) |
|---|---|---|---|
| WO 2020/262691 A1 | 30 December 2020 | US 2022/0118753 A1<br>claims 1-25, paragraphs [1223]-[1667]<br>EP 3991989 A1<br>CN 114096914 A | |
| WO 2007/123031 A1 | 01 November 2007 | US 2009/0087779 A1<br>claims 1-14, paragraphs [0161]-[0198]<br>CN 101426659 A | |
| JP 2011-73213 A | 14 April 2011 | US 2011/0076616 A1<br>claims 1-7, paragraphs [0189]-[0236] | |
| US 2021/0094336 A1 | 01 April 2021 | WO 2021/067054 A1<br>CN 114502378 A | |
| WO 2019/188910 A1 | 03 October 2019 | US 2021/0001618 A1<br>claim 1, paragraph [0045]<br>EP 3778252 A1 | |
| US 2009/0269699 A1 | 29 October 2009 | EP 2113381 A2 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2020262691 A
- JP 5045885 A
- JP H545885 A
- JP 6035174 A
- JP H635174 A
- JP 50040047 B
- GB 1412768 A
- JP 2005254638 A
- US 2714066 A
- US 3181461 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S4841708 B
- JP 51037193 A
- JP S5137193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP 2000250211 A
- JP 2007094138 A
- US 7153632 B
- JP 8505958 A
- JP H08505958 A
- JP 2007293221 A
- JP 2007293223 A
- JP 2001133969 A
- JP 2002023360 A
- JP 2002040638 A
- JP 2002278057 A
- JP 2008195018 A
- JP 2007090850 A
- JP 5005005 A
- JP H055005 A
- JP 2001222101 A
- JP 8108621 A
- JP H08108621 A
- JP 61166544 A
- JP S61166544 A
- JP 2002328465 A
- US 3458311 A
- JP 55049729 B
- JP S5549729 B
- JP 2005250216 A
- JP 2006259137 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- WO 2020137919 A
- JP 2008284817 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- JP 2014104631 A
- US 4253999 A
- US 4268613 A
- US 4348954 A

- JP 6628949 B
- JP 2002327036 A
- JP 2002173410 A
- JP 2004307837 A
- JP 2006038246 A
- WO 202167054 A
- JP 2021142007 A


**Non-patent literature cited in the description**


- Ultrafine particles and materials. 1993
- Preparation and application of fine particles/powders. CMC Publishing CO., LTD, 2005